# EUROPEAN PATENT APPLICATION

(11) **EP 4 435 016 A1**
(43) Date of publication of application: **25.09.2024**
(21) Application number: 22901369.3
(22) Date of filing: 30.11.2022
(51) Int. Cl.: C08F 20/00, C08F 265/00, C08F 265/06, C09K 11/08, C09K 11/66, C08F 220/10, B82Y 20/00, B82Y 30/00, C08F 2/44

(54) **PHOTORESPONSIVE MATERIAL AND PHOTORESPONSIVE COMPOSITION**

(30) Priority: 30.11.2021 JP 2021194474; 30.11.2021 JP 2021194476; 16.03.2022 JP 2022041491; 28.03.2022 JP 2022051869; 15.11.2022 JP 2022182323; 15.11.2022 JP 2022182325; 28.11.2022 JP 2022189339
(71) Applicant: CANON KABUSHIKI KAISHA, Tokyo 146-8501 (JP)
(72) Inventor: YOSHIMASA Yutaka, Tokyo 146-8501 (JP); OHASHI Yoshihiro, Tokyo 146-8501 (JP)
(74) Representative: WESER & Kollegen Patentanwälte PartmbB
(86) International application number: PCT/JP2022/044200
(87) International publication number: WO 2023/100937

(57) **Abstract**

A photoresponsive material contains a nanoparticle with a perovskite crystal structure and a shell-like ligand that has a plurality of binding portions with an ionic structural unit and that has a polymer portion bound to the nanoparticle at a plurality of positions via the plurality of binding portions.

## Description

### Technical Field

The present disclosure relates to a photoresponsive material and a photoresponsive composition that emit light upon light irradiation.

### Background Art

It is known that a quantum dot with a perovskite crystal structure has a narrow full width at half maximum in spectral sensitivity characteristics, has high color purity, and is therefore applied to an organic EL material or a quantum dot photoresponsive material. Patent Literature 1 discloses a quantum dot with a perovskite crystal structure that absorbs light from a light-emitting element, converts the light into any one of RGB light, and emits the light, and a light conversion layer containing the quantum dot.

On the other hand, it is known that a quantum dot with a particle size of several to twenty nanometers has a particle form with a large specific surface area and is therefore more likely to change in composition through the particle surface than that in a bulk form. Patent Literature 1 further discloses that the particle surface of a quantum dot with a perovskite crystal structure is modified with a ligand having an organic group to protect the surface of the quantum dot.

Patent Literature 2 discloses a technique of modifying a particle surface with a ligand containing a zwitterionic surfactant to improve the stability of a perovskite quantum dot. The surfactant contained in the ligand described in Patent Literature 2 has positively charged and negatively charged atoms at positions not adjacent to each other in the same molecule, has a betaine structure with no electric charge as a whole molecule, and exhibits a zwitterionic property.

### Citation List

### Patent Literature

PTL 1: Japanese Patent Laid-Open No. 2018-197782
PTL 2: PCT Japanese Translation Patent Publication No. 2019-526658

### Summary of Invention

### Technical Problem

When a photoresponsive material or a light-emitting layer is produced using a perovskite quantum dot protected by a ligand described in Patent Literature 1 or Patent Literature 2, the quantum dot is dispersed in a solid carrier or a liquid solvent. When such a perovskite quantum dot is applied to a photoresponsive material, the photoluminescence quantum yield is sometimes not higher than expected.

When a quantum dot comes into contact with a solvent with a high dielectric constant, such as an alcohol, it is thought that a ligand is separated from the quantum dot, and a component of the quantum dot from which the ligand has been separated moves between the quantum dot and the solvent, so that the crystal structure of the perovskite crystal structure is changed. A quantum dot with a perovskite crystal structure is considered to have an opportunity to come into contact with a surrounding polar solvent in steps of storage, transport, and production. Thus, it has been desired to provide a photoresponsive material containing a perovskite quantum dot with stability against a surrounding environment. A quantum dot with a perovskite crystal structure has a higher photoluminescence quantum yield and is more active than a non-perovskite light-emitting nanoparticle, but has low stability in composition and crystal structure. Thus, it is expected that a measure for stabilizing a nanoparticle with a photoluminescence quantum yield lowered by an external stimulus is a stabilization measure against many activation factors including temperature rise, photoreception, and the like.

It is an object of the present invention to provide a photoresponsive material containing a perovskite quantum dot with a particle surface protected so that the photoluminescence quantum yield is maintained even in at least one of an environment in which the material comes into contact with a medium containing a polar solvent and an environment of temperature rise or photoreception.

When a quantum dot containing a photoresponsive nanoparticle is applied to a photodetector or a solar cell, the photoluminescence quantum yield described in the present description is also referred to as the photoelectric conversion quantum yield related to the generation of a charge pair. In the present description, the photoluminescence quantum yield related to the wavelength conversion of light is treated as one form of the conversion quantum yield including the photoelectric conversion quantum yield related to photoelectric conversion.

Accordingly, the present invention has been made in view of the above problems and aims to provide a photoresponsive material containing a perovskite quantum dot with a particle surface protected so that the conversion quantum yield is maintained even when the material comes into contact with a medium containing a polar solvent. Solution to Problem

A photoresponsive material according to an embodiment of the present invention includes a nanoparticle with a perovskite crystal structure and a shell portion that has a plurality of binding portions with an ionic structural unit and that has a polymer portion bound to the nanoparticle at a plurality of positions via the plurality of binding portions.

### Advantageous Effects of Invention

The present invention can provide a photoresponsive material containing a perovskite quantum dot with a particle surface protected so that the photoluminescence quantum yield is maintained even in at least one of an environment in which the material comes into contact with a medium containing a polar solvent and an environment of temperature rise or photoreception.

### Brief Description of Drawings

[Fig. 1A] Fig. 1A is a schematic cross-sectional view of a photoresponsive material according to a first embodiment.
[Fig. 1B] Fig. 1B is a schematic cross-sectional view of a photoresponsive material according to a modified embodiment of the first embodiment.
[Fig. 1C] Fig. 1C is a schematic view of a binding portion according to the first embodiment.
[Fig. 1D] Fig. 1D is a schematic view of an organic polymer portion according to the first embodiment.
[Fig. 2] Fig. 2 is a schematic view of a binding portion 60 according to a first reference embodiment without a shell-like ligand 20.
[Fig. 3A] Fig. 3A is a schematic view of a photoresponsive composition according to a second embodiment.
[Fig. 3B] Fig. 3B is a schematic view of a wavelength conversion layer according to a third embodiment.
[Fig. 4A] Fig. 4A is a schematic cross-sectional view of a photoresponsive material according to a fourth embodiment.
[Fig. 4B] Fig. 4B is a schematic cross-sectional view of a photoresponsive material according to a modified embodiment of the fourth embodiment.
[Fig. 4C] Fig. 4C is a schematic view of a binding portion according to the fourth embodiment.
[Fig. 4D] Fig. 4D is a schematic view of an organic polymer portion according to the fourth embodiment.
[Fig. 5] Fig. 5 is a schematic view of a binding portion according to a second reference embodiment without the shell-like ligand 20.
[Fig. 6A] Fig. 6A is a view of the dispersion state of an ink composition according to a fifth embodiment.
[Fig. 6B] Fig. 6B is a schematic view of a binding portion according to the fifth embodiment.
[Fig. 6C] Fig. 6C is a schematic view of an organic polymer portion according to the fifth embodiment.
[Fig. 7A] Fig. 7A is a schematic view of a photoresponsive material according to a sixth embodiment.
[Fig. 7B] Fig. 7B is a schematic view of a photoresponsive material according to a modified embodiment of the sixth embodiment.
[Fig. 7C] Fig. 7C is a schematic view of a binding portion according to the sixth embodiment.
[Fig. 7D] Fig. 7D is a schematic view of a polymer portion according to the sixth embodiment.
[Fig. 8] Fig. 8 is a schematic view of a photoresponsive material according to a third reference embodiment without the shell-like ligand 20.
[Fig. 9A] Fig. 9A is a schematic view of a photoresponsive composition according to a seventh embodiment.
[Fig. 9B] Fig. 9B is a schematic view of a wavelength conversion layer according to an eighth embodiment. Description of Embodiments

Preferred embodiments of the present invention are described in detail below with reference to the drawings. The dimensions, materials, shapes, and relative arrangements of the constituents described in these embodiments are not intended to limit the scope of the present invention.

### <First Embodiment>

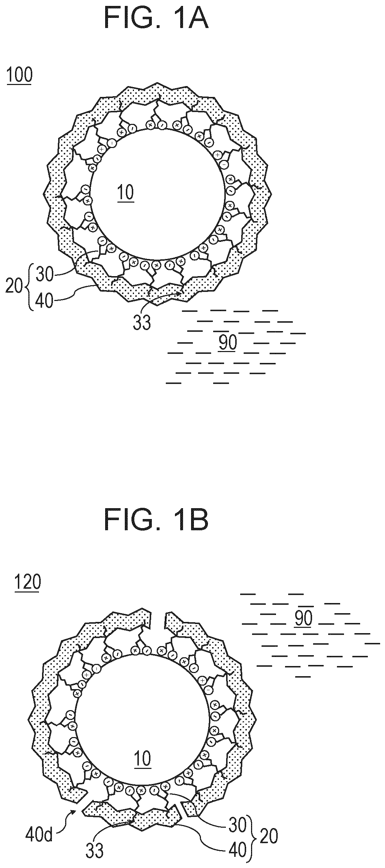

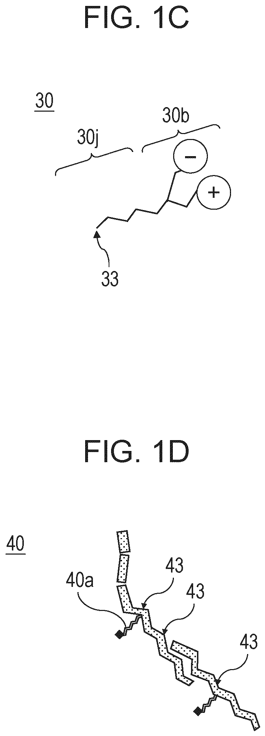

A photoresponsive material 100 according to a first embodiment is described below with reference to Figs. 1A and 1C.

### (Photoresponsive Material)

As illustrated in Fig. 1A, the photoresponsive material 100 according to the present embodiment contains a photoresponsive nanoparticle 10 having a perovskite crystal structure with a surface coordinated by a shell-like ligand 20. The shell-like ligand 20 has a plurality of binding portions 30 with an ionic structural unit, and a polymer portion 40 (organic polymer portion 40) bound to the nanoparticle 10 at a plurality of positions via the plurality of binding portions 30.

### (Nanoparticle)

In the present embodiment, the nanocrystal may be a semiconductor nanocrystal with a perovskite crystal structure including an A site (a monovalent cation), a B site (a divalent cation), and an X site (a monovalent anion including a halide anion) as constituents. The perovskite crystal structure is also referred to as a perovskite structure, an ABX₃ crystal structure, or an ABX₃ structure. Furthermore, a double perovskite crystal structure represented by A₂B₁B₂X₆ is also included in the perovskite crystal structure.

### [A Site of Perovskite Structure]

A monovalent cation is used in the A site. The monovalent cation used in the A site may be a nitrogen-containing organic compound cation, such as an ammonium cation (NH₄⁺), an alkylammonium cation with 6 or less carbon atoms, a formamidinium cation (HC(NH₂)₂⁺), a guanidinium cation (C(NH₂)₃⁺), an imidazolium cation, a pyridinium cation, or a pyrrolidinium cation, or an alkali metal cation, such as a lithium cation (Li⁺), a sodium cation (Na⁺), a potassium cation (K⁺), a rubidium cation (Rb⁺), or a cesium cation (Cs⁺).

These monovalent cations used in the A site have a small ion size that can fit a crystal lattice, and the perovskite compound can therefore form a stable three-dimensional crystal.

The alkylammonium cation with 6 or less carbon atoms is preferably, for example, a methylammonium cation (CH₃NH₃⁺), an ethylammonium cation (C₂H₅NH₃⁺), a propylammonium cation (C₃H₇NH₃⁺), or the like.

From the perspective of achieving high light emission efficiency, at least one of a methylammonium cation, a formamidinium cation, and a cesium cation is preferably used in the A site, and from the perspective of reducing color change, a cesium cation is more preferably used in the A site. These monovalent cations used in the A site may be used in combination of two or more thereof.

When a cesium cation is used in the A site, a cesium salt may be used as a raw material for the synthesis of a light-emitting nanocrystal described later. The cesium salt may be cesium chloride, cesium bromide, cesium iodide, cesium hydroxide, cesium carbonate, cesium hydrogen carbonate, cesium bicarbonate, cesium formate, cesium acetate, cesium propionate, cesium pivalate, or cesium oxalate as appropriate. Among these cesium salt candidates, a cesium salt suitable for the synthesis method can be used.

When another alkali metal cation is used in the A site, a salt produced by replacing the cesium element of the cesium compound with another alkali metal cation element can be used as a raw material.

When a nitrogen-containing organic compound cation, such as a methylammonium cation, is used in the A site, for example, a neutral compound other than a salt, such as methylamine, can be used as a raw material. These raw materials may be used in combination of two or more thereof.

### [Perovskite Crystal Structure B Site]

A divalent cation including a divalent transition metal cation or a divalent typical metal cation is used in the B site of the perovskite crystal structure.

The divalent transition metal cation may be a scandium cation (Sc²⁺), a titanium cation (Ti²⁺), a vanadium cation (V²⁺) , a chromium cation (Cr²⁺), a manganese cation (Mn²⁺), an iron cation (Fe²⁺), a cobalt cation (Co²⁺), a nickel cation (Ni²⁺), a copper cation (Cu²⁺), a palladium cation (Pd²⁺), a europium cation (Eu²⁺), or an ytterbium cation (Yb²⁺).

The divalent typical metal cation may be a magnesium cation (Mg²⁺), a calcium cation (Ca²⁺), a strontium cation (Sr²⁺), a barium cation (Ba²⁺), a zinc cation (Zn²⁺), a cadmium cation (Cd²⁺), a germanium cation (Ge²⁺), a tin cation (Sn²⁺), or a lead cation (Pb²⁺).

Among these divalent cations, a divalent typical metal cation is preferred in terms of the growth of a stable three-dimensional crystal, a tin cation or a lead cation is more preferred, and a lead cation is particularly preferred from the perspective of high light emission intensity. These divalent cations may be used in combination of two or more thereof, and the perovskite crystal structure may be of a so-called double perovskite type.

When a lead cation is used in the B site, a raw material for the synthesis of a nanoparticle (light-emitting nanocrystal) described later may be a lead compound and can be appropriately selected depending on the synthesis method. The lead compound may be lead chloride, lead bromide, lead iodide, lead oxide, lead hydroxide, lead sulfide, lead carbonate, lead formate, lead acetate, lead 2-ethylhexanoate, lead oleate, lead stearate, lead naphthenate, lead citrate, lead maleate, or lead acetylacetonate. When another divalent metal cation is used in the B site, a salt produced by replacing the lead element of the lead compound with another divalent metal cation element can be used as a raw material. These raw materials may be used in combination of two or more thereof.

### [X Site of Perovskite Crystal Structure]

A monovalent anion including a halide anion is used in X of the perovskite crystal structure. The halide anion may be a fluoride anion (F-), a chloride anion (Cl-), a bromide anion (Br⁻), an iodide anion (I⁻), or the like. Among these, a chloride anion, a bromide anion, or an iodide anion is preferred from the perspective of forming a stable three-dimensional crystal and emitting strong light in the visible light region. The emission color is blue for the chloride anion, green for the bromide anion, and red for the iodide anion.

The halide anions may be used in combination of two or more thereof. In particular, when a chloride anion, a bromide anion, and an iodide anion are used in combination, the light-emitting nanocrystal can have a desired emission wavelength depending on the content ratio of the anionic species. More specifically, in particular, the combined use of a chloride anion, a bromide anion, and an iodide anion is preferred because an emission spectrum covering almost the entire region of visible light from blue to red can be obtained while maintaining a narrow full width at half maximum depending on the content ratio of the anionic species.

The X site may contain a monovalent anion other than halide anions. The monovalent anion other than halide anions may be a pseudohalide anion, such as a cyanide anion (CN-), a thiocyanic acid anion (SCN-), or an isothiocyanic acid anion (CNS⁻). A raw material for the synthesis of a nanoparticle (light-emitting nanocrystal) described later can be appropriately selected from a salt with a counter cation in the A site and the B site, a salt with another cation, and the like, such as cesium chloride or lead bromide, depending on the synthesis method.

The nanoparticle (light-emitting nanocrystal) in the present embodiment can be produced by a process as described below. The process is, for example, a hot injection method of mixing raw material liquids at high temperature and rapidly cooling the mixture after the formation of fine particles to produce a stable product or a ligand-assisted reprecipitation method of producing fine particles by reprecipitation utilizing a difference in miscibility of a product with a solvent.

The production method may also be a room-temperature synthesis method of producing fine particles by mixing a liquid mixture of a raw material for the A site and a raw material for the B site, which are non-halides containing no component for the X site, with a separately prepared raw material liquid for the X site under a mild condition of approximately room temperature. The production method may also be a production method adopted in a mechanochemical method of producing product fine particles by a reaction of a solid raw material by mechanical mixing, such as milling, or ultrasonication, or in an in-situ synthesis method of applying a raw material liquid to a substrate and then producing a reaction product by direct crystal growth.

### (Shell-Like Ligand)

As illustrated Fig. 1A, the photoresponsive material 100 according to the present embodiment includes a nanoparticle 10 with a perovskite crystal structure and a shell-like ligand 20 bound for coordination to the surface of the nanoparticle 10 at a plurality of positions. The shell-like ligand 20 has the plurality of binding portions 30 with a betaine structure 30b, and the organic polymer portion 40 bound to the nanoparticle 10 at a plurality of positions via the plurality of binding portions 30.

The betaine structure 30b corresponds to a zwitterionic structural unit that has a positive charge and a negative charge at positions not adjacent to each other in the same molecule and that has no electric charge as a whole molecule. Thus, in other words, the shell-like ligand 20 according to the present embodiment is a ligand that has the plurality of binding portions 30 with a zwitterionic structural unit and the polymer portion 40 coordinated to the photoresponsive nanoparticle 10 via the plurality of binding portions 30. Each binding portion 30 has the betaine structure 30b related to bonding to the nanoparticle, and a linking portion 30j related to bonding to the organic polymer portion 40 and having a bonding arm 33 at an end. In Fig. 1A, the photoresponsive material 100 is stably dispersed in a solvent 90. Likewise, in Fig. 1A, the light-emitting nanoparticle 10 coordinated by the shell-like ligand 20 is dispersed in the solvent 90 and is protected from the solvent 90 by the shell-like ligand 20.

The nanoparticle 10 may also be protected from attack by a dispersed component or a dissolved component (not shown) dispersed or dissolved in the solvent 90. In other words, the zwitterionic structure is a form with a structural unit partially having an ionic property.

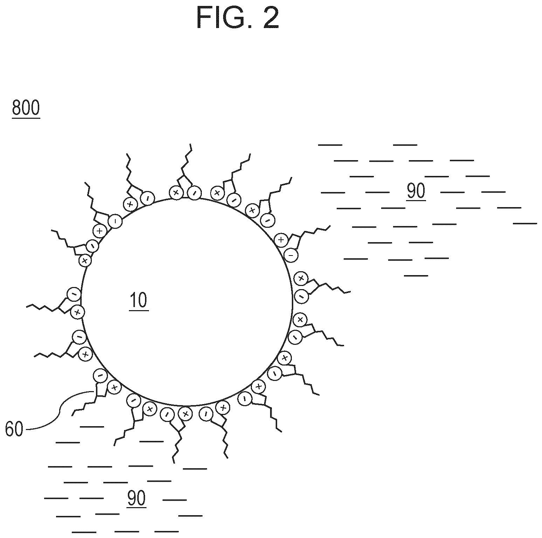

The shell-like ligand 20 including the structural unit with the betaine structure 30b can coordinate strongly to the surface of the nanoparticle 10 (light-emitting nanocrystal). Furthermore, because the shell-like ligand 20 has a plurality of betaine structures 30b in the same molecule, even if some stimulus partially eliminates some coordination from the surface of the nanoparticle 10, the shell-like ligand 20 can coordinate easily again. Furthermore, a polymer chain of the organic polymer portion 40 performs a protective function as a shell for the core of the nanoparticle 10 and reduces the effects of a substance, such as a polar solvent, on the nanoparticle 10. It is thought that this improves the stability of the structure and composition of the nanoparticle 10, which is a light-emitting nanocrystal, and improves the stability of emission properties. In the present description, the bond between the binding portions 30 and the nanoparticle 10 corresponds to an ionic bond due to electrostatic interaction. In other words, the bond between the binding portions 30 and the nanoparticle 10 may be distinguished from a covalent bond and may correspond to a noncovalent bond. As illustrated in Figs. 1A to 1C and Fig. 2, to clearly show bonding due to electrostatic interaction, the betaine structure 30b is shown to have a pair of branched ends positively and negatively polarized in the molecule. The pair of positively and negatively polarized portions in the molecule in the betaine structure 30b corresponds to a polarization region located in a linear structure corresponding to any one of polarized portions in the structural unit represented by each of the formulae (1) to (3).

The shell-like ligand 20 according to the present embodiment has at least a portion coordinated to the nanoparticle 10. In the shell-like ligand 20 according to the present embodiment, the organic polymer portion 40 coordinates so as to cover the outer periphery of the nanoparticle 10. As described later in a modified embodiment of the present embodiment, the shell-like ligand 20 does not necessarily completely cover the outer periphery of the nanoparticle 10, that is, does not necessarily have a coverage of 100%, and the organic polymer portions 40 may be locally unconnected to each other.

From the perspective of the stability of the nanoparticle 10 in a polar solvent, the shell-like ligand 40 preferably has a number-average molecular weight of 1,000 or more and 50,000 or less. Likewise, the shell-like ligand 20 more preferably has a number-average molecular weight of 2,000 or more and 30,000 or less. When the ratio of the organic polymer portion 30 to the shell-like ligand 20 is dominant over the ratio of the binding portions 30 to the shell-like ligand 20, the number-average molecular weight of the organic polymer portion 40 may substitute for the number-average molecular weight of the shell-like ligand 20.

### (Binding Portion)

As illustrated in Fig. 1B, each binding portion 30 of the shell-like ligand 20 includes the betaine structure 30b related to bonding to the nanoparticle 10 and the linking portion 30j with the bonding arm 33 on the side opposite the betaine structure 30b. The bonding arm 33 is a portion related to bonding to the organic polymer portion 40 and corresponds to a bonding arm 43 of the organic polymer portion 40 illustrated in Fig. 1C.

Furthermore, each binding portion 30 has an organic group 30a in the linking portion 30j. The organic group 30a is compatibly mixed with a polymerizable compound (not shown) present in a medium and stabilizes the dispersion of the nanoparticle 10 coordinated by the shell-like ligand 20 in the medium.

In the present embodiment, the binding portions 30 of the shell-like ligand 20 have a structural unit represented by at least one of the formulae (1) to (3).

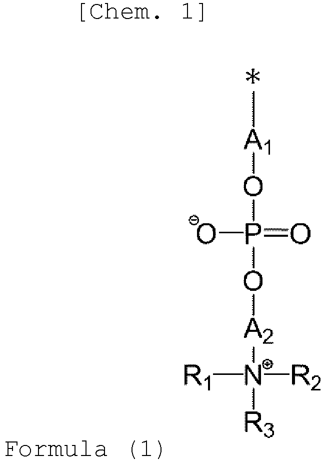

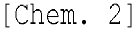

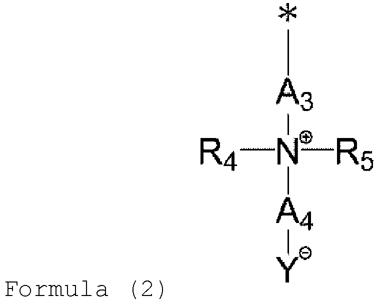

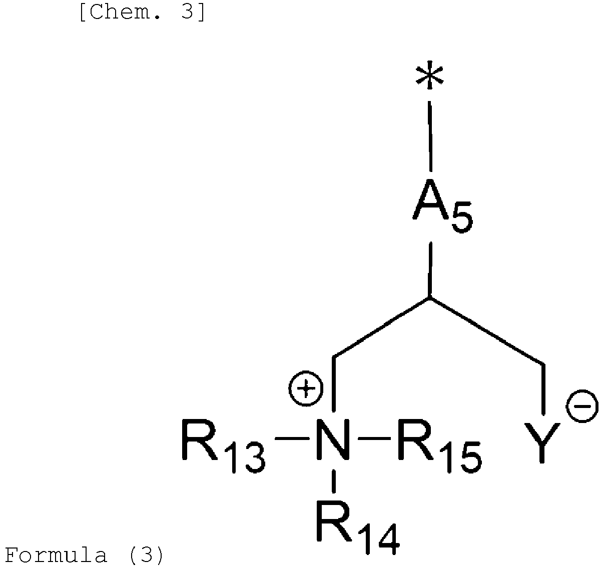

In the formulae (1) to (3), R₁ to R₅ and R₁₃ to R₁₅ each independently denote any one of a hydrogen atom and an alkyl group, N denotes a nitrogen atom, A₁ to A₅ denote a linking group, Y⁻ denotes a COO⁻ group or a SO₃⁻ group, and "*" denotes a bonding arm to the organic polymer portion. In the present embodiment, the shell-like ligand 20 is preferably a copolymer with a binding portion 30 represented by one of the formulae (1) to (3).

The alkyl groups in R₁ to R₃ in the formula (1), R₄ and R₅ in the formula (2), and R₁₃ to R₁₅ in the formula (3) are preferably alkyl groups with 1 to 18 carbon atoms. Examples thereof include a methyl group, an ethyl group, a n-propyl group, an isopropyl group, a n-butyl group, a n-octyl group, a 2-ethylhexyl group, a dodecyl group, and an octadecyl group. These alkyl groups may be further substituted or may be bound together to form a ring.

In the formula (1), A₁ denotes a linking group that links the polymer main chain and the phosphate moiety. The linking group A₁ is any one of a carbonyl group, an alkylene group, an arylene group, and -COOR₂₀- (provided that the carbonyl group in -COOR₂₀- is bound to one other than the phosphate moiety, and R₂₀ denotes an alkylene with 1 or more and 4 or less carbon atoms). Furthermore, the betaine structure 30b may be directly bound by a single bond to the polymer main chain of the organic polymer portion 40.

The alkylene group in the linking group A₁ may be linear or branched and is preferably an alkylene group with 1 to 4 carbon atoms. The alkylene group with 1 to 4 carbon atoms may be a methylene group, an ethylene group, a propylene group, a butylene group, or the like.

The arylene group in the linking group A₁ is, for example, a 1,2-phenylene group, a 1,3-phenylene group, a 1,4-phenylene group, a naphthalene-1,4-diyl group, a naphthalene-1,5-diyl group, a naphthalene-2,6-diyl group, or the like.

In -COOR₂₀- in the linking group A₁, the carbonyl group of -COOR₂₀- is bound to one other than the phosphate moiety, and R₂₀ denotes an alkylene with 1 or more and 4 or less carbon atoms. The alkylene may be linear or branched.

The linking group A₁ may be further substituted with another functional group.

The linking group A₁ is more preferably a carbonyl group or -COOR₂₀- from the perspective of the availability of a raw material and the ease of production.

In the formula (1), A₂ denotes a linking group that links the phosphate moiety and the quaternary ammonium moiety and denotes any one of an alkylene group and an arylene group.

The alkylene group in the linking group A₂ may be linear or branched and is preferably an alkylene group with 1 to 4 carbon atoms.

Examples thereof include a methylene group, an ethylene group, a propylene group, and various butylene groups.

The arylene group in the linking group A₂ is, for example, a 1,2-phenylene group, a 1,3-phenylene group, a 1,4-phenylene group, a naphthalene-1,4-diyl group, a naphthalene-1,5-diyl group, a naphthalene-2,6-diyl group, or the like.

The linking group may be further substituted.

From the perspective of the availability of a raw material and the ease of production, the linking group A₂ is more preferably a simple alkylene group, such as a methylene group or an ethylene group.

In the formula (2), A₃ denotes a linking group that links the polymer main chain and the quaternary ammonium moiety. The linking group A₃ may be an alkylene group, an arylene group, an aralkylene group, a-COOR₂₁-b, a-CONHR₂₁-b, a-OR₂₁-b, or the like. "a" denotes a binding site for one other than the quaternary ammonium moiety, "b" denotes a binding site for the quaternary ammonium moiety, and R₂₁ denotes an alkylene group or an arylene group. The betaine portion may be directly bound to the polymer main chain by a single bond.

The alkylene group in the linking group A₃ may be linear or branched and is preferably an alkylene group with 1 to 4 carbon atoms. Examples thereof include a methylene group, an ethylene group, a propylene group, and various butylene groups.

The arylene group in the linking group A₃ is, for example, a 1,2-phenylene group, a 1,3-phenylene group, a 1,4-phenylene group, a naphthalene-1,4-diyl group, a naphthalene-1,5-diyl group, a naphthalene-2,6-diyl group, or the like.

The aralkylene group in the linking group A₃ is, for example, an aralkylene group with 7 to 15 carbon atoms.

When the linking group A₃ is a-COOR₂₁-b, a-CONHR₂₁-b, or a-OR₂₁-b, the alkylene group in R₂₁ may be linear or branched and is preferably an alkylene group with 1 to 4 carbon atoms. Examples thereof include a methylene group, an ethylene group, a propylene group, and various butylene groups. "a" denotes a binding site for one other than the quaternary ammonium moiety, "b" denotes a binding site for the quaternary ammonium moiety, and R₇ denotes an alkylene group or an arylene group.

The arylene group in R₂₁ is, for example, a 1,2-phenylene group, a 1,3-phenylene group, a 1,4-phenylene group, a naphthalene-1,4-diyl group, a naphthalene-1,5-diyl group, a naphthalene-2,6-diyl group, or the like.

The linking group A₃ may be further substituted.

From the perspective of the availability of a raw material and the ease of production, the linking group A₃ is more preferably a-COOR₂₁-b or a-CONHR₂₁-b.

In the formula (2), A₄ denotes a linking group that links the quaternary ammonium moiety and the counter anion moiety Y⁻ thereof, and is, for example, an alkylene group, an arylene group, or the like.

In the formula (3), A₅ is a linking group that links the polymer main chain and the betaine moiety. The linking group A₅ may be an alkylene group, an arylene group, an aralkylene group, a-COOR₂₂-b, a-CONHR₂₂-b, a-OR₂₂-b, or the like. "a" denotes a binding site for one other than the betaine moiety, b denotes a binding site for the betaine moiety, and R₂₂ denotes an alkylene group or an arylene group. The betaine portion may be directly bound to the polymer main chain by a single bond.

The alkylene group in the linking group A₄ may be linear or branched and is preferably an alkylene group with 1 to 4 carbon atoms.

Examples thereof include a methylene group, an ethylene group, a propylene group, and various butylene groups.

The arylene group in the linking group A₂ is, for example, a 1,2-phenylene group, a 1,3-phenylene group, a 1,4-phenylene group, a naphthalene-1,4-diyl group, a naphthalene-1,5-diyl group, a naphthalene-2,6-diyl group, or the like.

The linking group A₄ may be further substituted.

The linking group A₄ is not particularly limited as described above. From the perspective of the availability of a raw material and the ease of production, the linking group A₂ is more preferably a simple alkylene group, such as a methylene group, an ethylene group, or a propylene group.

In the formula (3), Y⁻ denotes a counter anion of the quaternary ammonium moiety and is covalently bound to the quaternary ammonium moiety via the linking group A₄. Y-denotes a COO⁻ group or a SO₃⁻ group.

### (Polymer Portion)

As illustrated in Fig. 1D, the polymer portion 40 in the shell-like ligand 20 has a polymer chain constituting a linear or branched shell structure, and the polymer chain has the bonding arm 43. The bonding arm 43 is a portion related to bonding to the binding portions 30 and corresponds to the bonding arm 33 of the binding portion 30 illustrated in Fig. 1C.

The organic polymer portion 40 may have a plurality of bonding arms 33. The organic polymer portion 40 and an adjacent organic polymer portion 40 overlap and are entangled with each other, forming an organic polymer network constituting the shell-like ligand 20.

A discontinuous portion 40d in Fig. 1B is a gap between adjacent organic polymers 40 and may have a plurality of forms, including a linear or branched slit type and an independent opening type corresponding to a mesh of an organic polymer chain constituting the shell structure.

The shell-like ligand 20 is preferably a copolymer having both the polymer portion 40 with the structural unit represented by the formula (6) and the binding portions 30.

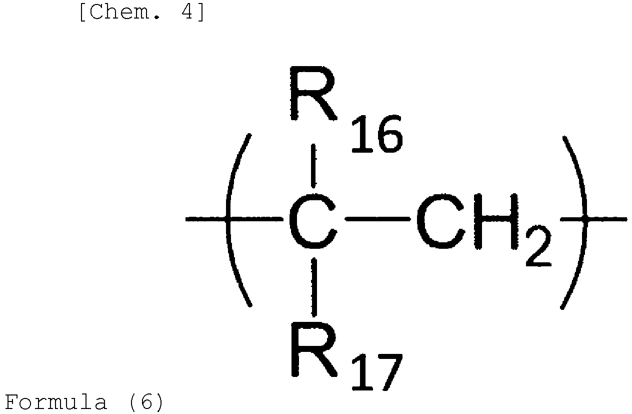

In the formula (6), R₁₆ denotes any one of a hydrogen atom and an alkyl group, and R17 denotes any one of an alkyl group, a carboxylate group, a carboxamide group, an alkoxy group, and an aryl group.

In the formula (6), the alkyl group in R₁₆ is preferably an alkyl group with 1 to 4 carbon atoms. Examples thereof include a methyl group, an ethyl group, a n-propyl group, an isopropyl group, and a n-butyl group. In the formula (6), R₁₆ preferably denotes a hydrogen atom or a methyl group from the perspective of the production of a copolymer (polymerizability).

In the formula (6), the alkyl group in R₁₇ is preferably an alkyl group with 1 to 30 carbon atoms. Examples thereof include a methyl group, an ethyl group, a n-propyl group, a n-butyl group, a n-hexyl group, a n-decyl group, a n-hexadecyl group, an octadecyl group, a docosyl group, and a triacontyl group.

In the formula (6), the aryl group in R₁₇ may be an aryl group, such as a phenyl group, a 1-naphthyl group, or a 2-naphthyl group.

In the formula (6), the carboxylate group in R₁₇ may be -COOR₂₄. R₂₄ denotes any one of an alkyl group with 1 to 30 carbon atoms, a phenyl group, and a hydroxyalkyl group with 1 to 30 carbon atoms. The carboxylate group in R₁₇ may be an ester group, such as a methyl ester group, an ethyl ester group, a n-propyl ester group, an isopropyl ester group, a n-butyl ester group, a tert-butyl ester group, an octyl ester group, a 2-ethylhexyl ester group, a dodecyl ester group, an octadecyl ester group, a docosyl ester group, a triacontyl ester group, a phenyl ester group, or a 2-hydroxyethyl ester group.

In the formula (6), the carboxamide group in R₁₇ may be -CO-NR₂₅R₂₆. R₂₅ and R₂₆ each independently denote any one of hydrogen, an alkyl group with 1 to 30 carbon atoms, and a phenyl group. The carboxamide group in R₁₇ may be an amide group, such as an N-methylamide group, an N,N-dimethylamide group, an N,N-diethylamide group, an N-isopropylamide group, an N-tert-butyramide group, an N-n-decylamide group, an N-n-hexadecylamide group, an N-octadecylamide group, an N-docosylamide group, an N-triacontylamide group, or an N-phenylamide group.

In the formula (6), the alkoxy group in R₁₇ may be an alkoxy group with 1 to 30 carbon atoms or a hydroxyalkoxy group with 1 to 30 carbon atoms. The alkoxy group in R₁₇ may be an alkoxy group, such as a methoxy group, an ethoxy group, a n-propoxy group, an isopropoxy group, a n-butoxy group, a n-hexyloxy group, a cyclohexyloxy group, a n-octyloxy group, a 2-ethylhexyloxy group, a dodecyloxy group, an octadecyloxy group, a docosyloxy group, a triacontyloxy group, or a 2-hydroxyethoxy group.

In the formula (6), a substituent in R₁₇ may be further substituted. In such a case, a substituent that may be substituted may be an alkoxy group, such as a methoxy group or an ethoxy group, an amino group, such as an N-methylamino group or an N,N-dimethylamino group, an acyl group, such as an acetyl group, or a halogen atom, such as a fluorine atom or a chlorine atom.

In the formula (6), R₁₆ and R₁₇ can be arbitrarily selected from the substituents listed above, and an appropriate substituent may be selected according to the intended use. For example, when the photoresponsive material is used in a highly hydrophobic medium, a substituent with a long-chain organic group is preferably selected to improve dispersibility and stability.

In the present embodiment, the mole ratio of a structural unit represented by any one of the formulae (1) to (3) to the structural unit represented by the formula (6) in the copolymer is preferably 2.0/98 or more and 50/50 or less. The mole ratio is more preferably 6/94 or more and 45/55 or less, still more preferably 10/90 or more and 40/60 or less. A copolymerization composition ratio in such a range results in the shell-like ligand stably coordinated to the nanoparticle and the light-emitting nanocrystal with a stabilized composition and crystal structure.

The shell-like ligand 20 content of the photoresponsive material 100 is preferably 1 part by mass to 1000 parts by mass, preferably 5 parts by mass to 500 parts by mass, more preferably 10 parts by mass to 300 parts by mass, per 100 parts by mass of the light-emitting nanocrystal. A content of less than 1 part by mass may result in an insufficient effect as a shell and unimproved stability. A content of more than 1000 parts by mass may result in a shell-like ligand with reduced solubility and dispersibility in a medium and a photoresponsive material with unimproved stability. The shell-like ligand 20 content of the photoresponsive material 100 may be appropriately adjusted according to the type and use of the nanoparticle 10 and the shell-like ligand 20.

The shell-like ligand 20 content in the present embodiment is determined by TG-DTA measure of a mixture containing the nanoparticle 10 and the shell-like ligand 20.

A mixture (not shown) composed of the nanoparticle 10 and the shell-like ligand 20 can be produced by adding a poor solvent for the mixture to an ink composition, precipitating the mixture by centrifugation, and then drying the precipitate. For the nanoparticle 10 containing an organic component, the shell-like ligand 20 content can be determined by separately measuring the organic component content and subtracting the content from the ratio of the ink composition 100. The case where the A site of the perovskite quantum dot is an organic compound is included in the case where an organic component is contained in the nanoparticle 10.

The shell-like ligand 20 may coordinate to the surface of the nanoparticle 10 by a method of allowing the shell-like ligand 20 to replace a ligand described later after the synthesis of the nanoparticle 10, a method of allowing the shell-like ligand 20 to coexist for coordination during the synthesis of the nanoparticle 10, or the like. When the shell-like ligand 20 coordinates in place of the ligand as described above, an excess free ligand can be removed by centrifugation.

In the present embodiment, the number of millimoles of a betaine group per gram of the light-emitting nanocrystal preferably ranges from 0.01 to 10, preferably 0.03 to 8, more preferably 0.1 to 6. A number of millimoles of a betaine group per gram of the light-emitting nanocrystal in such a range results in strong coordination to the light-emitting nanocrystal and consequently improved stability. Less than 0.02 may result in an insufficient effect as a shell and unimproved stability. More than 10 may result in a shell-like ligand with reduced solubility and dispersibility in a medium and a photoresponsive material with unimproved stability. This may also result in increased viscosity. The number of millimoles corresponds to the betaine group content per gram of the light-emitting nanocrystal and is a unit corresponding to x 10⁻³ mol.

A method for producing the shell-like ligand and a copolymer (hereinafter also collectively referred to as a shell-like ligand) is described in detail below.

The shell-like ligand may be produced by any method for producing the shell-like ligand with the above structure, for example, by the following method (i) or (ii).

(i) The shell-like ligand can be produced by a method of producing a monomer having at least a structure corresponding to any one of the formulae (1) to (3) and then polymerizing the monomer. (ii) The shell-like ligand can be produced by a method of synthesizing a polymer main chain and then bonding a zwitterionic moiety corresponding to any one of the formulae (1) to (3) to the polymer main chain by a polymer reaction.

From the perspective of the availability of the monomer and control of the amount of functional group, the production method (i) is preferred. A method for synthesizing the shell-like ligand 20 including the structural unit represented by the formula (1) using the method (i) is described in detail below.

A monomer for introducing the structural unit represented by the formula (1) into the shell-like ligand 20 may be a vinyl ether derivative, an acrylate derivative, a methacrylate derivative, an α-olefin derivative, an aromatic vinyl derivative, or the like, depending on the structure of the linking group A₁. Among these monomers, an acrylate derivative or a methacrylate derivative is preferably used from the perspective of the ease of production of the monomer.

A corresponding acrylate derivative or methacrylate derivative can be produced by a method described in the following literature.

K. Ishihara et al., "Polymer Journal", (Japan), the Society of Polymer Science, Japan, 1990, vol. 22, pp. 355-360.

The method for polymerizing the monomer may be radical polymerization or ionic polymerization, or living polymerization for the purpose of molecular weight distribution control or structure control. Industrially, radical polymerization is preferably used.

The radical polymerization can be performed by the use of a radical polymerization initiator, by irradiation with light, such as a radioactive ray or laser light, by a combined use of a photopolymerization initiator and irradiation with light, by heating, or the like. The radical polymerization initiator may be any radical polymerization initiator that can produce a radical and initiate a polymerization reaction, and is selected from compounds that produce a radical by the action of heat, light, radiation, a redox reaction, or the like.

The radical polymerization initiator may be an azo compound, an organic peroxide, an inorganic peroxide, an organometallic compound, a photopolymerization initiator, or the like.

More specifically, the radical polymerization initiator may be an azo compound, such as 2,2'-azobisisobutyronitrile (AIBN) or 2,2'-azobis(2,4-dimethylvaleronitrile), an organic peroxide, such as benzoyl peroxide (BPO), tert-butyl peroxypivalate, or tert-butyl peroxyisopropyl carbonate, an inorganic peroxide, such as potassium persulfate or ammonium persulfate, a redox initiator, such as a hydrogen peroxide-iron (II) salt system, a BPO-dimethylaniline system, or a cerium (IV) salt-alcohol system, a photopolymerization initiator, such as acetophenone, benzoin ether, or ketal, or the like.

These radical polymerization initiators may be used in combination of two or more thereof.

The polymerization temperature of the monomer has a preferred temperature range depending on the type of the polymerization initiator to be used and is not particularly limited. However, the polymerization is typically performed at a temperature in the range of -30°C to 150°C, more preferably 40°C to 120°C.

The amount of the polymerization initiator to be used is preferably adjusted in the range of 0.1 parts by mass or more and 20 parts by mass or less per 100 parts by mass of the monomer so as to produce a shell-like ligand with a target molecular weight distribution.

The polymerization method may be, but is not limited to, solution polymerization, suspension polymerization, emulsion polymerization, dispersion polymerization, precipitation polymerization, bulk polymerization, or the like.

The resulting shell-like ligand can be purified as required. The purification method can be, but is not limited to, reprecipitation, dialysis, column chromatography, or the like.

The copolymer is produced by any method for producing the copolymer with the above structure and is produced in the same manner as the shell-like ligand.

At this time, apart from a monomer with a structural unit corresponding to at least one of the formulae (1) to (3) and a monomer corresponding to the formula (6), a polymerizable monomer may be further added for polymerization.

### (Polymerizable Compound)

Supplied with energy, such as light, heat, or an electromagnetic wave, a polymerizable compound can polymerize itself and impart viscosity to and cure a liquid or paste intermediate.

To make the photoresponsive material 100 according to the present embodiment a photoresponsive composition that cures in response to an external stimulus, a polymerizable monomer can also be used as a medium.

The polymerizable monomer may be an ultraviolet-curable UV monomer, UV dimer, or UV oligomer, a thermally polymerizable monomer, a thermally polymerizable dimer, a thermally polymerizable oligomer, or the like, which may be referred to as a photopolymerizable compound or a thermopolymerizable compound, respectively.

### <Modified Embodiment of First Embodiment>

Although the shell-like ligand 20 covers the entire sphere (corresponding to a solid angle of 4π) of the nanoparticle 10 in the photoresponsive material 100 according to the first embodiment as illustrated in Fig. 1A, the shell-like ligand 20 does not necessarily cover the entire nanoparticle 10 in an embodiment of the present invention. Fig. 1B illustrates a schematic cross-section of a photoresponsive material 120 corresponding to a modified embodiment of the first embodiment. The photoresponsive material 120 according to the present modified embodiment is different from the photoresponsive material 100 according to the first embodiment in that the shell-like ligand 20 does not cover a portion of the nanoparticle 10. In the photoresponsive material 120 according to the present modified embodiment, the organic polymer portion 40 is bound to the nanoparticle 10 at a plurality of positions via a plurality of binding portions 30, and the shell-like ligand 20 coordinates to the nanoparticle 10.

The shell-like ligand 20 according to the present modified embodiment has at least a portion coordinated to the nanoparticle 10 as in the shell-like ligand 20 according to the first embodiment. A portion of the shell-like ligand 20 that does not cover a portion of the nanoparticle 10 corresponds to a discontinuous portion 40u.

### (Non-Shell-Like Ligand)

The photoresponsive material 100 according to the present embodiment may have a non-shell-like ligand bound to the surface of a core containing a semiconductor nanoparticle with a perovskite crystal structure. The non-shell-like ligand may further improve stability, such as dispersion stability or spectral characteristics. The non-shell-like ligand may contain at least one compound or ion selected from the group consisting of an acid, such as carboxylic acid, sulfonic acid, or phosphonic acid, a base, such as ammonia or an amine, a betaine group, and a salt or ion thereof. From the perspective of dispersion stability, the non-shell-like ligand is preferably at least one compound or ion selected from the group consisting of an organic acid, an organic base, a salt or ion thereof, and a betaine group.

The organic acid is, for example, a branched or linear fatty acid with 1 to 30 carbon atoms. The fatty acid may be saturated or unsaturated. In particular, from the perspective of solubility and stability in a solvent, a linear fatty acid is preferred, and oleic acid is more preferred.

A salt component in an organic acid salt may be any metal cation.

The salt component in the organic acid salt is preferably an alkali metal cation or an alkaline-earth metal cation, more preferably an alkali metal cation. Among alkali metal cations, sodium and potassium are preferred, and sodium is more preferred.

The organic base is, for example, a branched or linear organic base with 1 to 30 carbon atoms. The organic base may be saturated or unsaturated. In particular, from the perspective of solubility and stability in a solvent, a linear organic base is preferred, and oleylamine is more preferred.

The betaine group is preferably a compound with a phosphobetaine group or a sulfobetaine group from the perspective of solubility and stability in a solvent containing a compound selected from the group consisting of a phosphobetaine group, a sulfobetaine group, and a carboxybetaine group.

The non-shell-like ligand may be used alone or in combination of two or more thereof.

### (Polymerization Initiator)

In a polymerization reaction, a polymerization initiator and a polymerizable compound are typically used in combination. The polymerization initiator is a compound that produces an active species for initiating a polymerization reaction by active energy ray irradiation or heat, and can be a known polymerization initiator. A main active species for initiating a polymerization reaction may be a radical polymerization initiator for producing a radical or a cationic polymerization initiator for producing an acid. These may be used in combination. A radical photopolymerization initiator that produces a radical by active energy radiation is, for example, an acetophenone, such as diethoxyacetophenone, 2-hydroxy-2-methyl-1-phenylpropan-1-one, benzyl methyl ketal, 4-(2-hydroxyethoxy)phenyl-(2-hydroxy-2-propyl)ketone, 1-hydroxycyclohexyl phenyl ketone, 2-methyl-1-[4-(methylthio)phenyl]-2-morpholinopropan-1-one, 2-benzyl-2-dimethylamino-1-(4-morpholinophenyl)butane, oligo[2-hydroxy-2-methyl-1-[4-(1-methyl vinyl)phenyl]propanone], or 2-hydroxy-1-[4-[4-(2-hydroxy-2-methylpropionyl)benzyl]phenyl]-2-methylpropan-1-one; a benzoin, such as benzoin, benzoin methyl ether, benzoin ethyl ether, benzoin isopropyl ether, or benzoin isobutyl ether; a phosphine, such as 2,4,6-trimethylbenzoyl-diphenyl-phosphine oxide or bis(2,4,6-trimethylbenzoyl)-phenylphosphine oxide; or a phenyl glyoxylic methyl ester.

Among the radical photopolymerization initiators, an acetophenone, a phosphine, or an oxime ester compound exemplified by an aminoketone is preferred. These may be used alone or in combination depending on the characteristics required for a cured product. The amount of the radical polymerization initiator when used preferably ranges from 0.01 to 100 parts by mass, more preferably 0.1 to 50 parts by mass, per 100 parts by mass of the total solid amount of the composition.

### (Polymerizable Compound)

A polymerizable compound undergoes polymerization upon receiving energy, such as light or heat, and imparts viscosity to and cure a photoresponsive composition. The polymerizable compound may be a radically polymerizable compound or a cationically polymerizable compound. These may be used alone or in combination of two or more thereof.

Furthermore, either a photopolymerizable compound or a thermopolymerizable compound can be used.

The radically polymerizable compound is, for example, a monofunctional (meth)acrylate compound, a bifunctional (meth)acrylate compound, a trifunctional or higher functional (meth)acrylate compound, a (meth)acrylate compound with a hydroxy group, a (meth)acrylate compound with a carboxy group, a vinyl compound, or the like.

The monofunctional (meth)acrylate is, for example, methyl (meth)acrylate, ethyl (meth)acrylate, propyl (meth)acrylate, isopropyl (meth)acrylate, butyl (meth)acrylate, hexyl (meth)acrylate, 2-ethylhexyl (meth)acrylate, cyclohexyl (meth)acrylate, dicyclopentenyl (meth)acrylate, dicyclopentenyloxyethyl (meth)acrylate, benzyl (meth)acrylate, 3,3,5-trimethylcyclohexyl acrylate, tetrahydrofurfuryl (meth)acrylate, phenoxyethyl (meth)acrylate, methoxyethyl (meth)acrylate, ethylcarbitol (meth)acrylate, isobornyl (meth)acrylate, methoxytriethylene glycol (meth)acrylate, (2-methyl-2-ethyl-1,3-dioxolan-4-yl)methyl (meth)acrylate, (3-ethyloxetan-3-yl)methyl (meth)acrylate, or cyclic trimethylolpropaneformal (meth)acrylate.

The bifunctional (meth)acrylate compound is, for example, 1,4-butanediol di(meth)acrylate, 1,6-hexanediol di(meth)acrylate, 1,9-nonanediol di(meth)acrylate, ethylene glycol di(meth)acrylate, diethylene glycol di(meth)acrylate, triethylene glycol di(meth)acrylate, tetraethylene glycol di(meth)acrylate, poly(ethylene glycol) 200 di(meth)acrylate, poly(ethylene glycol) 300 di(meth)acrylate, poly(ethylene glycol) 400 di(meth)acrylate, poly(ethylene glycol) 600 di(meth)acrylate, dipropylene glycol di(meth)acrylate, tripropylene glycol di(meth)acrylate, tetrapropylene glycol di(meth)acrylate, poly(propylene glycol) 400 di(meth)acrylate, poly(propylene glycol) 700 di(meth)acrylate, neopentyl glycol di(meth)acrylate, neopentyl glycol PO-modified di(meth)acrylate, EO-modified bisphenol A di(meth)acrylate, PO-modified bisphenol A di(meth)acrylate, or neopentyl glycol hydroxypivalate di(meth)acrylate.

The trifunctional or higher functional (meth)acrylate compound is, for example, trimethylolpropane triacrylate, trimethylolpropane EO-modified tri(meth)acrylate, trimethylolpropane PO-modified tri(meth)acrylate, glycerin propoxy tri(meth)acrylate, pentaerythritol tri(meth)acrylate, tris(acryloxyethyl) isocyanurate, or EO-modified pentaerythritol tetraacrylate.

The (meth)acrylate compound with a hydroxy group is, for example, a hydroxyalkyl (meth)acrylate, such as 2-hydroxyethyl (meth)acrylate, 2-hydroxypropyl (meth)acrylate, 2-hydroxybutyl (meth)acrylate, 4-hydroxybutyl (meth)acrylate, or 6-hydroxyhexyl (meth)acrylate, 2-hydroxyethylacryloyl phosphate, 2-(meth)acryloyloxyethyl-2-hydroxypropyl phthalate, caprolactone-modified 2-hydroxyethyl (meth)acrylate, dipropylene glycol (meth)acrylate, fatty-acid-modified glycidyl (meth)acrylate, poly(ethylene glycol) mono(meth)acrylate, poly(propylene glycol) mono(meth)acrylate, 2-hydroxy-3-(meth)acryloyloxypropyl (meth)acrylate, glycerin di(meth)acrylate, or 2-hydroxy-3-acryloyl-oxypropyl methacrylate.

The (meth)acrylate compound with a carboxy group is, for example, β-carboxyethyl (meth)acrylate, a succinic acid mono(meth)acryloyloxyethyl ester, or ω-carboxy polycaprolactone mono(meth)acrylate.

The vinyl compound is, for example, vinyl acetate, vinyl benzoate, vinyl pivalate, vinyl butyrate, vinyl methacrylate, or N-vinylpyrrolidone.

The cationically polymerizable compound may be of a photopolymerization type or a thermal polymerization type. These may be used alone or in combination of two or more thereof. A typical cationically polymerizable compound is, for example, an epoxy compound, an oxetane compound, or a vinyl ether compound.

The amount of the polymerizable compound including the radically polymerizable compound and the cationically polymerizable compound to be used preferably ranges from 1 to 99 parts by mass, more preferably 5 to 95 parts by mass, still more preferably 10 to 90 parts by mass, per 100 parts by mass of the ink composition.

### (Solvent)

The polymerizable compound may contain a solvent as required. The solvent is, for example, an alkane, such as pentane or hexane, a cycloalkane, such as cyclopentane or cyclohexane, an ester, such as ethyl acetate, butyl acetate, or benzyl acetate, an ether, such as diethyl ether or tetrahydrofuran, a ketone, such as cyclohexanone or acetone, or an alcohol, such as methanol, ethanol, isopropanol, butanol, or hexanol. The solvent may also be a monoacetate compound, such as diethylene glycol monoethyl ether acetate, ethylene glycol monoethyl ether acetate, diethylene glycol monobutyl ether acetate, or dipropylene glycol methyl ether acetate, a diacetate compound, such as 1,4-butanediol diacetate or propylene glycol diacetate, or a triacetate compound, such as glyceryl triacetate.

To easily remove the solvent before curing the polymerizable compound 50, the solvent has a boiling point of 300°C or less. The solvent may also be referred to as a solvent medium.

### (Other Additive Agents)

In the present embodiment, if necessary, the ink composition may be used in a mixture with a deoxidizer, an antioxidant, a scattering agent, such as titanium oxide, a surfactant, a fungicide, a light stabilizer, an additive agent imparting other characteristics, a diluting solvent, or the like.

### (Wavelength Conversion Member)

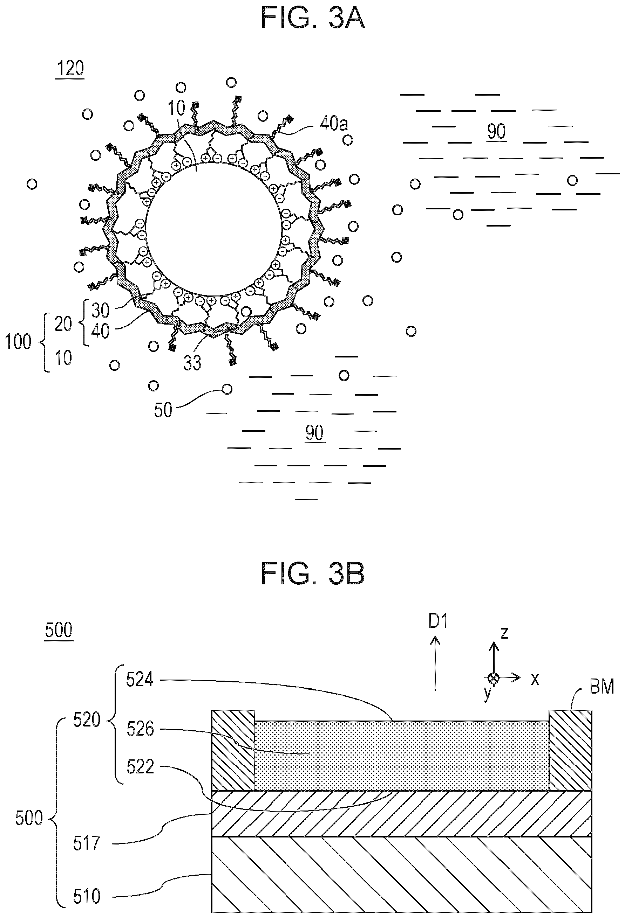

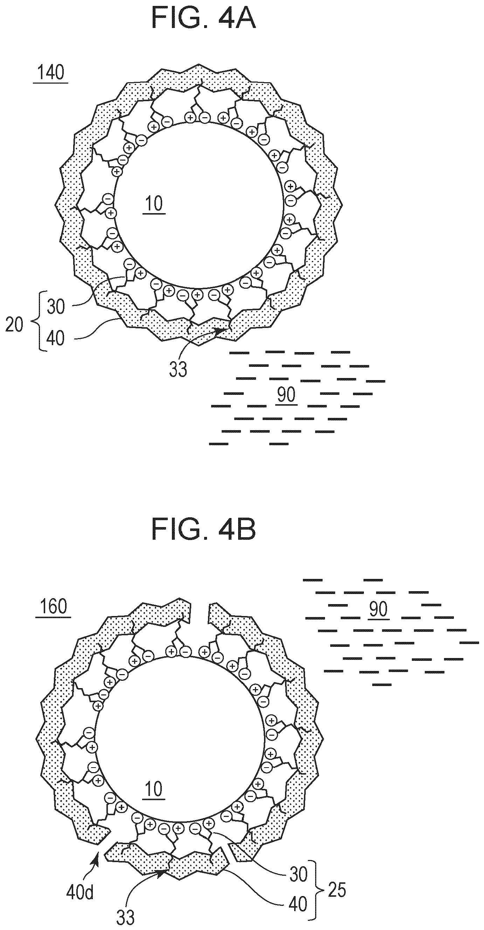

A wavelength conversion member according to the present embodiment is a member produced on a substrate by curing a photoresponsive composition 200 (ink composition 200) containing the photoresponsive material 100 and a polymerizable compound 50 in a co-dispersion state illustrated in Fig. 3A. The wavelength conversion member has a layer form supported by another member and may be referred to as a wavelength conversion layer 520, as illustrated in Fig. 4B. The support form includes a layered form and a dispersed form dispersed in a matrix material. The wavelength conversion layer 520 may be a film, a sheet, or a patterned pixel produced by applying the photoresponsive composition 200 to a supporting member (substrate) and curing the composition.

### (Method for Forming Wavelength Conversion Layer)

The wavelength conversion layer 520 may be formed by any method, for example, a method of applying a photoresponsive composition to a substrate, predrying the photoresponsive composition as required, and heating the photoresponsive composition or irradiating the photoresponsive composition with an active energy ray as required to cure the film. The wavelength conversion layer after curing preferably has a thickness in the range of 0.1 to 200 µm, more preferably 1 to 100 µm.

The active energy ray in the active energy ray irradiation is appropriately selected from an electromagnetic wave, such as a heat ray, ultraviolet light, visible light, near-infrared light, or an electron beam, that reduces fluidity by polymerization, cross-linking, drying, or the like and promotes curing. A light source for applying the active energy ray is preferably a light source with a main emission wavelength in the wavelength region of 100 to 450 nm. Such a light source is, for example, an ultra-high-pressure mercury lamp, a high-pressure mercury lamp, a medium-pressure mercury lamp, a mercury-xenon lamp, a metal halide lamp, a high-power metal halide lamp, a xenon lamp, a pulsed xenon lamp, a deuterium lamp, a fluorescent lamp, a ND-YAG third harmonic laser, a HE-CD laser, a nitrogen laser, a XE-Cl excimer laser, a XE-F excimer laser, a semiconductor-pumped solid-state laser, an LED lamp light source with an emission wavelength of 365, 375, 385, 395, or 405 nm, or the like.

### <Second Embodiment>

Fig. 3A is a view of the dispersion state of a photoresponsive composition 200 according to a second embodiment.

The photoresponsive composition 200 is changed in viscosity and is cured due to the polymerization of the polymerizable compound contained therein. Thus, the photoresponsive composition 200 in Fig. 3A corresponding to the stage before curing is in the form of a fluid ink and may therefore be referred to as the ink composition 200. Curing may also be referred to as solidifying. The light-emitting material 200 contains the photoresponsive material 100 and the polymerizable compound 50. The light-emitting material 200 contains the photoresponsive material 100 and the polymerizable compound 50 dispersed in the solvent 90.

As illustrated in Fig. 3A, in the photoresponsive composition 200 according to the present embodiment, the shell-like ligand 20 covers the entire sphere (corresponding to a solid angle of 4π) of the nanoparticle 10. In the photoresponsive composition 200 according to the present embodiment, an organic group 40a compatible with the polymerizable compound 50 contained in the medium is a portion of the structure contained in the organic polymer portion 40.

The shell-like ligand 20 according to the present modified embodiment has at least a portion coordinated to the nanoparticle 10. The shell-like ligand 20 in the photoresponsive composition 200 has a discontinuous portion (not shown) that does not cover a portion of the nanoparticle 10. The discontinuous portion (not shown) that does not cover a portion of the nanoparticle 10 has a mesh opening formed by linear organic polymer portions 40 extending in different directions overlapping along the shell of the shell-like ligand 20.

An embodiment having an organic group as a portion of the structure of each binding portion is also included as a modified embodiment of the present embodiment. In such a modified embodiment (not shown), the organic group protrudes toward the outside of the shell-like ligand through the mesh of the network structure constituted by the polymer portions.

The photoresponsive composition 200 constitutes a film-like wavelength converter 526 by the polymerizable compound 50 being cured by polymerization.

### <Third Embodiment>

Fig. 3B illustrates a cross-sectional structure of a display element 500 according to a third embodiment.

The display element 500 includes a light-emitting layer 510, a dielectric multilayer film 517, and a wavelength conversion layer 520 stacked in the stacking direction D1. The downstream side in the stacking direction D1 corresponds to the side on which a user viewing an image on the display element is positioned. The wavelength conversion layer 520 is separated from a wavelength conversion layer corresponding to an adjacent element by a black matrix BM that separates pixels.

As described above, the photoresponsive composition 200 is cured together with the polymerizable compound 50 by polymerization treatment, such as photopolymerization treatment. The photoresponsive composition 200 is cured and constitutes the wavelength conversion layer 520 of the display element 500 satisfying a predetermined dimension. Thus, the wavelength conversion layer 520 is a layer solidified by being cured together with the polymerizable compound 50.

The light-emitting layer 510 corresponds to a light source that emits light L1 with a first wavelength λ1. The wavelength conversion layer 520 has an optical coupling surface 522 optically coupled to the light-emitting layer 510 on the side of the light-emitting layer 510 and has an extraction surface 524 for extracting secondary light L2 converted by the wavelength conversion layer 520 on the opposite side of the light-emitting layer 510.

The wavelength conversion layer 520 according to the present embodiment receives primary light L1 of a wavelength λ1 propagating through the dielectric multilayer film 917. The dielectric multilayer film 517 provides the display element 500 with the spectral transmission characteristics of the primary light from the light-emitting layer 510 and with the spectral reflection characteristics of the secondary light L2 of a wavelength λ2 emitted in the wavelength conversion layer 520. The wavelength λ2 of the secondary light L2 is longer than the wavelength λ1 of the primary light L1.

The dielectric multilayer film 917 can be replaced with another optical member optically transparent to light with the first wavelength λ1 emitted by the light-emitting layer 510. Furthermore, another optical member (not shown) can be disposed in front of the extraction surface 524 (on the side opposite the light-emitting layer 510).

### <First Reference Embodiment>

Fig. 2 shows the dispersibility of a photoresponsive material 800 according to a first reference embodiment in the solvent 90. The photoresponsive material 800 according to the present reference embodiment has the betaine structure 30b but no shell-like ligand 20, and only a non-shell-like ligand 60 with a linear backbone or a branched backbone extending approximately radially from the surface of the nanoparticle 10 coordinates to the surface of the light-emitting nanoparticle 10. In other words, the photoresponsive material 800 according to the present reference embodiment has the betaine structure 30b, which is a zwitterionic structure, but no shell-like ligand 20, and only the non-shell-like ligand 60 coordinates to the surface of the light-emitting nanoparticle 10. The non-shell-like ligand 60 in the photoresponsive material 800 according to the present reference embodiment has the betaine structure 30b but no shell-like ligand 20, that is, no organic polymer 20 that surrounds the nanoparticle 10 in a shell form and coordinates in parallel at a plurality of positions via a plurality of binding portions 30.

Thus, the ligand coordinated to the nanoparticle 10 in the photoresponsive material 800 according to the present reference embodiment has a weaker bond than that in the photoresponsive material 100 according to the first embodiment. Consequently, it is assumed that the light-emitting nanoparticle 10 in the photoresponsive material 800 according to the present reference embodiment is easily attacked by the solvent 90 containing a polar molecule, and this changes the semiconductor composition or causes a defect in the perovskite crystal structure in a portion of the surface of the nanoparticle 10.

### ((Storage Method))

The emission properties of a light-emitting nanoparticle with a perovskite crystal structure are easily degraded not only by a polar solvent but also by light or heat. Thus, the photoresponsive materials 100 and 200 according to the present embodiment are preferably stored in a refrigerator or a darkroom shielded from external light. This can reduce the degradation of the photoresponsive materials 100 and 200 according to the present embodiment due to light or heat during storage.

### ((Measurement Method))

Various physical properties can be measured as described below.

### ((Measurement of Molecular Weight Distribution))

The molecular weight distribution of the shell-like ligand can be calculated in terms of monodisperse poly(methyl methacrylate) by gel permeation chromatography (GPC). The molecular weight can be measured by GPC, for example, in the following manner.

A sample is added to the following eluent at a sample concentration of 1% by mass and is allowed to stand at room temperature for 24 hours to dissolve the sample. The resulting solution is filtered through a solvent-resistant membrane filter with a pore size of 0.45 um to prepare a sample solution, which is subjected to measurement under the following conditions.
Apparatus: Agilent 1260 infinity system (manufactured by Agilent Technologies)
Column: PFG analytical linear M columns (manufactured by PSS)
Eluent: 2,2,2-trifluoroethanol
Flow rate: 0.2 ml/min
Oven temperature: 40°C
Sample injection amount: 20µL

A molecular weight calibration curve prepared with a standard poly(methyl methacrylate) resin (EasiVial PM Polymer Standard Kit manufactured by Agilent Technologies) is used to calculate the molecular weight distribution of the sample.

### ((Composition Analysis))

The composition of the shell-like ligand can be analyzed by nuclear magnetic resonance (NMR). For example, 1H-NMR and 13C-NMR spectra are measured with ECA-600 (600 MHz) manufactured by JEOL Ltd. The measurement is performed at 25°C in a deuterated solvent containing tetramethylsilane as an internal standard substance. The chemical shift is read as a ppm shift (δ value) with the chemical shift value of the internal standard tetramethylsilane being 0.

### ((Crystal Structure Analysis))

The crystal structure and composition of the nanoparticle 10 can be analyzed by X-ray photoelectron spectroscopy (XPS). For example, the crystal structure can be analyzed by measuring an X-ray diffraction pattern using RINT 2100 (manufactured by Rigaku Corporation).

### ((Composition Analysis))

The composition of the nanoparticle 10 can be analyzed by XPS and ICP spectroscopy. The mole ratio of A and B can be measured from the signal intensity of XPS, and the concentration of X can be measured from the light emission intensity of ICP spectroscopy (for example, CIROS CCD (manufactured by SPECTRO)).

### ((Method for Verifying Coordination of Ligand to Nanoparticle))

Whether or not the shell-like ligand 20 coordinates to the nanoparticle 10 can be examined by infrared spectroscopy (IR). A dispersion liquid containing the nanoparticle 10 and the shell-like ligand 20, to which a poor solvent is added as required, is subjected to centrifugation. The supernatant is then removed, and the precipitate is dried. The shell-like ligand 20 not bound to the nanoparticle 10 is removed together with the supernatant. A signal of a binding portion observed in the measurement of an IR absorption spectrum of the resulting solid shows that the shell-like ligand 20 coordinates to the nanoparticle 10. At that time, the coordination may shift the signal of the binding portion by several nanometers.

The coordination can also be examined by observation with a transmission electron microscope (TEM). In general, a photoresponsive nanoparticle with a perovskite crystal structure is observed in a regularly arranged form. When a shell-like ligand coordinates, however, steric repulsion between the shell-like ligands or steric repulsion between the shell-like ligand and a substrate disturbs the arrangement. The coordination can be examined in this respect.

### ((Photoresponsive Nanoparticle Content))

The photoresponsive nanoparticle content of a photoresponsive material or a photoresponsive composition can be measured by ICP spectroscopy and NMR. For example, the amount of Pb is measured from the light emission intensity of ICP spectroscopy, and the amount of ligand is measured from the signal intensity of NMR. The photoresponsive nanoparticle content can be determined from the composition information of the photoresponsive nanoparticle obtained by the above method.

### ((Polymer Content))

The polymer content of a photoresponsive material or a photoresponsive composition can be determined from the TG-DTA measurement described above or NMR integrated intensity.

### ((Betaine Group Content of Polymer))

The betaine group content of a polymer can be determined from the NMR integrated intensity ratio between the betaine portion and another moiety in the polymer.

### ((Number of Millimoles of Betaine Group per Gram of Photoresponsive Nanoparticle))

The number of millimoles of a betaine group per gram of a photoresponsive nanoparticle can be calculated from the photoresponsive nanoparticle content, the polymer content, and the betaine group content of a polymer determined by the methods described above.

### <Fourth Embodiment>

A photoresponsive material 140 according to the present embodiment is different from the photoresponsive material 100 according to the first embodiment in that the zwitterionic structural unit in the plurality of binding portions 30 is a quaternary ammonium salt.

### (Shell-Like Ligand)

As illustrated Fig. 4A, the photoresponsive material 140 according to the present embodiment includes a nanoparticle 10 with a perovskite crystal structure and a shell-like ligand 20 bound to the surface of the nanoparticle 10 at a plurality of positions. The shell-like ligand 20 has a plurality of binding portions 30 and an organic polymer portion 40 bound to the nanoparticle 10 at a plurality of positions via the plurality of binding portions 30.

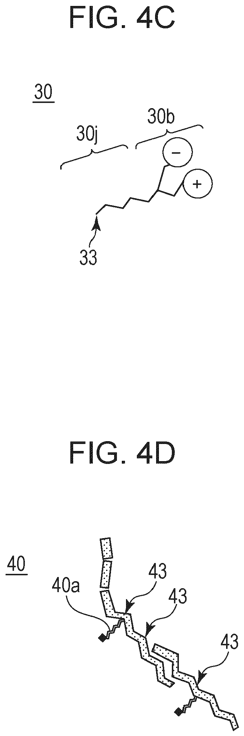

As illustrated in Fig. 4C, each binding portion 30 has a quaternary ammonium salt 30b related to bonding to the nanoparticle, and a linking portion 30j related to bonding to the organic polymer portion 40 and having a bonding arm 33 at an end. The quaternary ammonium salt 30b refers to a salt of a cation of an ammonia molecule tetrasubstituted with a substituent containing carbon and another anion.

The shell-like ligand 20 including a structural unit containing the quaternary ammonium salt 30b can coordinate strongly to the surface of the nanoparticle 10. The quaternary ammonium salt 30b corresponds to a zwitterionic structural unit that has a positive charge and a negative charge at positions not adjacent to each other in the same molecule and that has no electric charge as a whole molecule. Thus, in other words, the shell-like ligand 20 according to the present embodiment is a ligand that has a plurality of binding portions with a zwitterionic structural unit and the polymer portion 40 coordinated to the photoresponsive nanoparticle 10 via the plurality of binding portions 30. Furthermore, because the shell-like ligand 20 has a plurality of quaternary ammonium salts 30b in the same molecule, even if some stimulus partially cleaves some bonds on the surface of the nanoparticle 10, the shell-like ligand 20 can be easily bound again. Furthermore, a polymer chain of the organic polymer portion 40 performs a protective function as a shell for the core of the nanoparticle 10 and reduces the effects of a substance, such as a polar solvent, on the nanoparticle 10.

It is thought that this improves the stability of the structure and composition of the nanoparticle 10 and improves the stability of photoresponsivity. In other words, the zwitterionic structure is a form with a structural unit partially having an ionic property.

The shell-like ligand 20 according to the present embodiment has at least a portion bound to the nanoparticle 10. In the shell-like ligand 20, the organic polymer portion 40 is bound so as to cover the outer periphery of the nanoparticle 10. As described later, the shell-like ligand 20 does not necessarily completely cover the outer periphery of the nanoparticle 10, that is, does not necessarily have a coverage of 100%, and the organic polymer portions 40 may be locally unconnected to each other, as illustrated in Fig. 4D. In other words, the shell-like ligand 20 may have a coordination form with the organic polymer portions 40 locally unconnected to each other. The organic polymer portion 40 has a plurality of bonding arms 43 bound to the nanoparticle 10 via the binding portions 30. Furthermore, the organic polymer portion 40 may have an organic group 40a in a side chain. The organic group 40a exhibits dispersibility of the photoresponsive material 140 in a media 90.

From the perspective of the stability of the nanoparticle 10 in a polar solvent, the shell-like ligand 20 preferably has a weight-average molecular weight of 1,000 or more and 100,000 or less. Likewise, the shell-like ligand 20 more preferably has a weight-average molecular weight of 2,000 or more and 50,000 or less. When the ratio of the organic polymer portion 40 to the shell-like ligand 20 is dominant over the ratio of the binding portions 30 to the shell-like ligand 20, the weight-average molecular weight of the organic polymer portion 40 may substitute for the weight-average molecular weight of the shell-like ligand 20.

In the photoresponsive material 140, as illustrated in Fig. 4A, the shell-like ligand 20 between the perovskite nanoparticle 10 and the medium 90 protects the nanoparticle 10 from the effects of the medium 90.

### (Binding Portion)

In the present embodiment, the binding portions 30 of the shell-like ligand 20 has a structural unit represented by the formula (4).

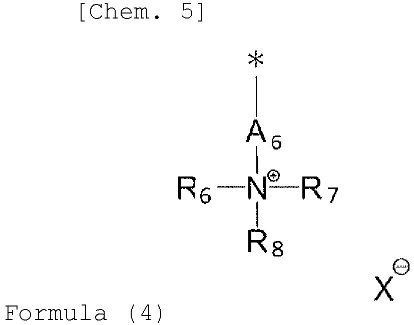

In the formula (4), R₆ to R₈ each independently denote any one of an alkyl group and an aryl group, N denotes a nitrogen atom, N denotes a nitrogen atom, A₆ denotes a linking group, X⁻ denotes an anion, and "*" denotes a bonding arm to the polymer portion.

In the present embodiment, the shell-like ligand 20 is preferably a copolymer with a binding portion 30 represented by the formula (4).

In the formula (4), A₆ denotes a linking group that links the polymer chain and the quaternary ammonium moiety and may be an alkylene group, an arylene group, an aralkylene group, a-COOR₂₃-b, a-CONHR₂₃-b, a-OR₂₃-b, or the like. "a" denotes a binding site for the organic polymer portion, "b" denotes a binding site for the quaternary ammonium moiety, and R₂₃ denotes an alkylene group or an arylene group.

The alkylene group in the linking group A₆ may be linear or branched and is preferably an alkylene group with 1 to 4 carbon atoms. Examples thereof include a methylene group, an ethylene group, a propylene group, and a butylene group.

The arylene group in the linking group A₆ is, for example, a 1,2-phenylene group, a 1,3-phenylene group, a 1,4-phenylene group, a naphthalene-1,4-diyl group, a naphthalene-1,5-diyl group, a naphthalene-2,6-diyl group, or the like.

The aralkylene group in the linking group A₆ is, for example, an aralkylene group with 7 to 15 carbon atoms.

When the linking group A₆ is a-COOR₂₃-b, a-CONHR₂₃-b, or a-OR₂₃-b, the alkylene group in R₂₃ may be linear or branched and is preferably an alkylene group with 1 to 4 carbon atoms. Examples thereof include a methylene group, an ethylene group, a propylene group, and a butylene group. "a" denotes a binding site for the organic polymer portion, "b" denotes a binding site for the quaternary ammonium moiety, and R₂₃ denotes an alkylene group or an arylene group.

The arylene group in the linking group R₂₃ is, for example, a 1,2-phenylene group, a 1,3-phenylene group, a 1,4-phenylene group, a naphthalene-1,4-diyl group, a naphthalene-1,5-diyl group, a naphthalene-2,6-diyl group, or the like.

The linking group A₆ may be further substituted in any way without significantly reducing the characteristics, such as photoresponsivity and dispersion stability, of the nanoparticle.

The linking group A₆ is not particularly limited as described above but is more preferably a-COOR₂₃-b from the perspective of the availability of a raw material and the ease of production.

The binding portions 30 in the shell-like ligand 20 may be bound to the polymer main chain via a linking group A₇, as represented by the formula (5).

In the formula (5), R₉ to R₁₁ each independently denote any one of an alkyl group and an aryl group, R₁₂ denotes any one of a hydrogen atom and an alkyl group, N denotes a nitrogen atom, A₇ denotes a linking group, and X- denotes an anion.

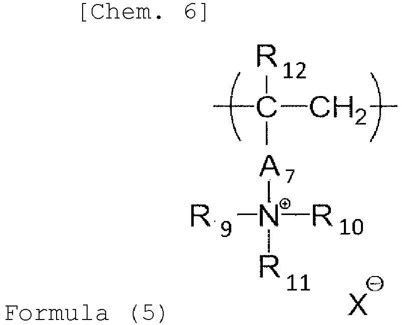

In the formula (5), the organic group in R₁₂ is preferably an alkyl group with 1 to 4 carbon atoms. Examples thereof include a methyl group, an ethyl group, a n-propyl group, an isopropyl group, and a n-butyl group. R₉ in the formula (5) can be arbitrarily selected from the substituents listed above and a hydrogen atom and is preferably a hydrogen atom or a methyl group from the perspective of the production of a polymer (polymerizability).

Similarly to the shell-like ligand according to the first embodiment, the shell-like ligand 20 according to the present embodiment is preferably a copolymer having the structural unit represented by the formula (6) as the organic polymer portion 40 together with the binding portions 30.

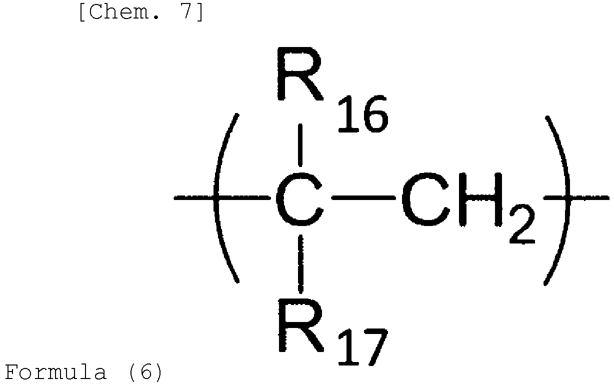

In the formula (4) or (5), X⁻ denotes an anion.

X⁻ may be a halide ion, such as a chloride ion, a bromide ion, an iodide ion, or a fluoride ion, an anion with COO- or SO₃⁻ in its structure, or a monovalent anion, such as BF₄⁻, PF₆⁻, ClO₄⁻, or N₃⁻.

The anion with a COO⁻ group is, for example, an acetate anion, a propionate anion, a benzoate anion, or the like.

The anion with SO₃⁻ in X- is, for example, a methanesulfonate anion, a trifluoromethanesulfonate anion, a benzenesulfonate anion, a p-toluenesulfonate anion, a methyl sulfate anion, or the like.

X⁻ may be used alone or in combination of two or more thereof.

In the present embodiment, the mole ratio of the structural unit represented by the formula (4) or (5) to the structural unit represented by the formula (6) in the copolymer preferably ranges from 0.01:99.99 to 50:50, more preferably 1:99 to 30:70. A copolymerization composition ratio in such a range results in a photoresponsive material with improved stability due to strong bonding to the nanoparticle.

The shell-like ligand 20 content of the photoresponsive material 140 is preferably 1 part by mass to 1000 parts by mass, preferably 5 parts by mass to 500 parts by mass, more preferably 10 parts by mass to 300 parts by mass, per 100 parts by mass of the photoresponsive nanocrystal. A content of less than 1 part by mass may result in an insufficient effect as a shell and unimproved stability. A content of more than 1000 parts by mass may result in a shell-like ligand with reduced solubility and dispersibility in a medium and a photoresponsive material with unimproved stability. The shell-like ligand 20 content of the photoresponsive material 140 may be appropriately adjusted according to the type and use of the nanoparticle 10 and the shell-like ligand 20.

The shell-like ligand 20 content in the present embodiment is determined by TG-DTA measure of a mixture containing the nanoparticle 10 and the shell-like ligand 20.

A mixture (not shown) composed of the nanoparticle 10 and the shell-like ligand 20 can be produced by adding a poor solvent to a mixture containing the nanoparticle, precipitating the mixture composed of the nanoparticle 10 and the shell-like ligand 20 by centrifugation, and then drying the precipitate.

The shell-like ligand 20 may coordinate to the surface of the nanoparticle 10 by a method of allowing the shell-like ligand 20 to replace a non-shell-like ligand described later after the synthesis of the nanoparticle 10, a method of allowing the shell-like ligand 20 to coexist for bonding during the synthesis of the nanoparticle 10, or the like. When the shell-like ligand 20 is bound in place of the non-shell-like ligand as described above, an excess free ligand can be removed by centrifugation.

A method for producing the shell-like ligand and a copolymer (hereinafter also collectively referred to as a shell-like ligand) is described in detail below.

The shell-like ligand may be produced by any method for producing the shell-like ligand with the above structure, for example, by the following method.

The shell-like ligand 20 can be produced by (i) a method of producing a monomer including a structural unit corresponding to the formula (4) or (5) and then polymerizing the monomer. The shell-like ligand 20 can also be produced by (ii) a method of synthesizing the shell-like ligand 20 with a polymer main chain and then binding or forming a quaternary ammonium salt by a polymer reaction.

From the perspective of the availability of the monomer and control of the amount of functional group, the production method (i) is preferred. A method for synthesizing the shell-like ligand 20 including the structural unit represented by the formula (5) using the method (i) is described in detail below.

A monomer for introducing the structural unit represented by the formula (5) into a shell-like ligand may be a vinyl ether derivative, an acrylate derivative, a methacrylate derivative, an α-olefin derivative, an aromatic vinyl derivative, or the like, depending on the structure of the linking group A. From the perspective of the ease of production of a monomer, a monomer for introducing the structural unit represented by the formula (5) into a shell-like ligand is preferably an acrylate derivative or a methacrylate derivative

A corresponding acrylate derivative or methacrylate derivative can be produced by a method described in the following literature.

K. Ishihara et al., "Polymer Journal", (Japan), the Society of Polymer Science, Japan, 1990, vol. 22, pp. 355-360.

The method for polymerizing the monomer may be radical polymerization or ionic polymerization, or living polymerization for the purpose of molecular weight distribution control or structure control. Industrially, radical polymerization is preferably used.

The radical polymerization can be performed by the use of a radical polymerization initiator, by irradiation with light, such as a radioactive ray or laser light, by a combined use of a photopolymerization initiator and irradiation with light, by heating, or the like. The radical polymerization initiator may be any radical polymerization initiator that can produce a radical and initiate a polymerization reaction, and is selected from compounds that produce a radical by the action of heat, light, radiation, a redox reaction, or the like.

The radical polymerization initiator may be an azo compound, an organic peroxide, an inorganic peroxide, an organometallic compound, a photopolymerization initiator, or the like.

More specifically, the radical polymerization initiator may be an azo compound, such as 2,2'-azobisisobutyronitrile (AIBN) or 2,2'-azobis(2,4-dimethylvaleronitrile), an organic peroxide, such as benzoyl peroxide (BPO), tert-butyl peroxypivalate, or tert-butyl peroxyisopropyl carbonate, an inorganic peroxide, such as potassium persulfate or ammonium persulfate, a redox initiator, such as a hydrogen peroxide-iron (II) salt system, a BPO-dimethylaniline system, or a cerium (IV) salt-alcohol system, a photopolymerization initiator, such as acetophenone, benzoin ether, or ketal, or the like.

These radical polymerization initiators may be used in combination of two or more thereof.

The polymerization temperature of the monomer has a preferred temperature range depending on the type of the polymerization initiator to be used and is not particularly limited. However, the polymerization is typically performed at a temperature in the range of -30°C to 150°C, more preferably 40°C to 120°C.

The amount of the polymerization initiator to be used is preferably adjusted in the range of 0.1 parts by mass or more and 20 parts by mass or less per 100 parts by mass of the monomer so as to produce a shell-like ligand with a target molecular weight distribution.

The polymerization method may be, but is not limited to, solution polymerization, suspension polymerization, emulsion polymerization, dispersion polymerization, precipitation polymerization, bulk polymerization, or the like.

The resulting shell-like ligand can be purified as required. The purification method can be, but is not limited to, reprecipitation, dialysis, column chromatography, or the like.

The copolymer is produced by any method for producing the copolymer with the above structure and is produced in the same manner as the shell-like ligand.

For example, the method may include producing a monomer corresponding to the formula (5) and a monomer corresponding to the formula (6) and then polymerizing these monomers.

At this time, a polymerizable monomer other than the monomer corresponding to the formula (5) and the monomer corresponding to the formula (6) can be further added for polymerization.

### <Modified Embodiment of Fourth Embodiment>

Although the entire sphere of the nanoparticle 10 is covered with the shell-like ligand 20 in the photoresponsive material 140 according to the fourth embodiment as illustrated in Fig. 4A, one aspect of the present invention also includes the nanoparticle 10 not entirely covered with the shell-like ligand 20. The entire sphere corresponds to a solid angle of 4π. Fig. 4B illustrates a schematic cross-section of a photoresponsive material 1600 corresponding to a modified embodiment of the fourth embodiment. The photoresponsive material 160 according to the present modified embodiment is different from the photoresponsive material 100 according to the fourth embodiment in that a shell-like ligand 25 does not cover a portion of the nanoparticle 10. In the photoresponsive material 160 according to the present modified embodiment, an organic polymer portion 44 is bound to the nanoparticle 10 at a plurality of positions via a plurality of binding portions 30, and the shell-like ligand 25 coordinates to the nanoparticle 10.

The shell-like ligand 25 according to the present modified embodiment has at least a portion coordinated to the nanoparticle 10 in the same manner as the shell-like ligand 20.

### <Second Reference Embodiment>

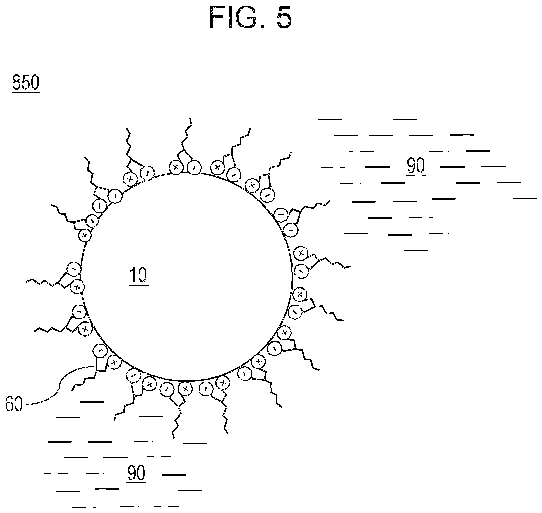

Fig. 5 shows the dispersibility of a photoresponsive material 850 according to a second reference embodiment in a medium 90. The photoresponsive material 850 according to the present reference embodiment has an ammonium salt 30b but no shell-like ligand 20, and a non-shell-like ligand 60 with a linear backbone or a branched backbone extending approximately radially from the surface of the nanoparticle 10 coordinates to the surface of the light-emitting nanoparticle 10. In other words, the photoresponsive material 850 according to the present reference embodiment has the ammonium salt 30b, which is a zwitterionic structure, but no shell-like ligand 20, and only the non-shell-like ligand 60 coordinates to the surface of the light-emitting nanoparticle 10. The non-shell-like ligand 60 in the photoresponsive material 850 according to the present reference embodiment has the ammonium salt 30b but no shell-like ligand 20, that is, no organic polymer portion 40 that surrounds the nanoparticle 10 in a shell form and coordinates in parallel at a plurality of positions via a plurality of binding portions 30.

Thus, the ligand coordinated to the nanoparticle 10 in the photoresponsive material 850 according to the present reference embodiment has a weaker bond than that in the photoresponsive material 140 according to the fourth embodiment. Consequently, it is assumed that the nanoparticle 10 in the photoresponsive material 850 according to the present reference embodiment is easily attacked by the medium 90 containing a polar molecule, and this changes the semiconductor composition or causes a defect in the perovskite crystal structure in a portion of the surface of the nanoparticle 10.

### <Fifth Embodiment>

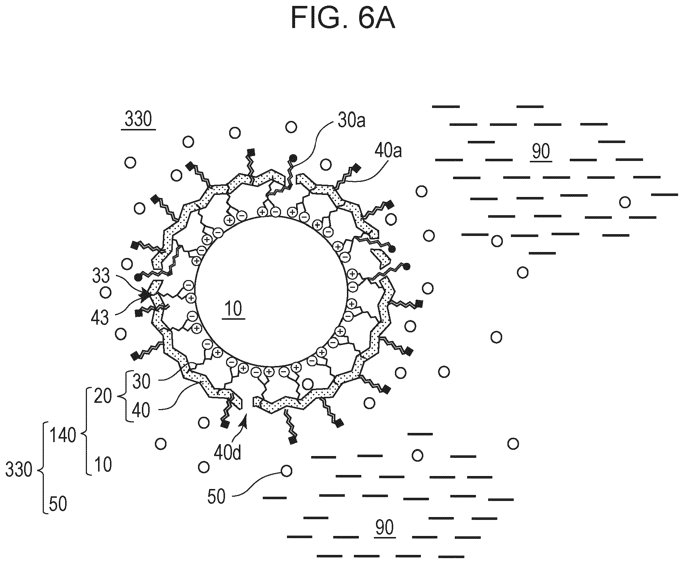

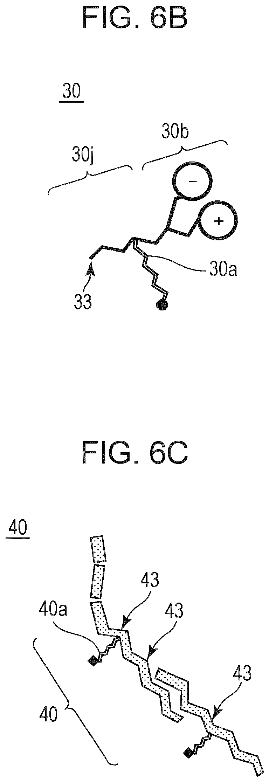

Next, an ink composition 330 (photoresponsive composition 330) according to a fifth embodiment is described with reference to Figs. 6A, 6B, and 6C.

Furthermore, to produce an ink composition curable in response to an external stimulus using photoresponsive materials 140 and 160 according to the fifth embodiment and a modified embodiment thereof, a polymerizable compound 50 can be dispersed or dissolved in a medium 90. The polymerizable compound 50 may be an ultraviolet-curable UV monomer, UV dimer, UV oligomer, or the like and may also be referred to as a photopolymerizable compound.

### (Shell-Like Ligand)

As illustrated in Fig. 6A, the ink composition 330 according to the present embodiment includes a photoresponsive nanoparticle 10 and a shell-like ligand 20 bound for coordination to the surface of the nanoparticle 10 at a plurality of positions. The shell-like ligand 20 has a plurality of binding portions 30 containing a quaternary ammonium salt 30b, and an organic polymer portion 40 bound to the nanoparticle 10 at a plurality of positions via the plurality of binding portions 30.

The quaternary ammonium salt 30b refers to a salt of a cation of an ammonia molecule tetrasubstituted with a substituent containing carbon and another anion. As illustrated in Fig. 6B, each binding portion 30 has the quaternary ammonium salt 30b related to bonding to the nanoparticle 10, and a linking portion 30j related to bonding to the organic polymer portion 40 and having a bonding arm 33 at an end. Furthermore, as illustrated in Figs. 6A to 6C, at least one of the binding portions 30 and the organic polymer portion 40 has an organic group 30a or 40a. The organic group 30a extends to the outside of the shell through a discontinuous portion 40d of the organic polymer portion 40 constituting the shell-like ligand 20. A portion where the organic polymer portions 40 are not connected to each other is shown as the discontinuous portion 40d in Fig. 4B.
The discontinuous portion 40d may extend in a network shape or a linear shape in the shell-like ligand 20 or may be discretely present as an independent hole opened in part of the organic polymer portion 40 extending in a two-dimensional shape.

The ink composition 330 illustrated in Fig. 6A is stably dispersed in a medium containing the medium 90 and the polymerizable compound 50 due to the organic groups 30a and 40a of the shell-like ligand 20 coordinated so as to cover the nanoparticle 10. The present inventors presume that this is an effect brought about by the organic groups 30a and 40a compatible with the polymerizable compound 50 in the medium due to an appropriate affinity (miscibility) for the polymerizable compound 50. In the present description, the bond between the binding portions 30 and the nanoparticle 10 corresponds to an ionic bond due to electrostatic interaction. In other words, the bond between the binding portions 30 and the nanoparticle 10 may be distinguished from a covalent bond and may correspond to a noncovalent bond.

The organic groups 30a and 40a extend to the outside of the shell-like organic polymer portion 40. This is assumed to be caused by the difference in polarity between the organic groups 30a and 40a and the quaternary ammonium salt 30b. More specifically, the binding portions 30 coordinate to the nanoparticle 10 by the quaternary ammonium salt 30b with strong polarity, and the organic groups 30a and 40a with relatively low polarity extend approximately radially to the medium side on which the medium 90 and the polymerizable compound 50 are present.

The organic groups 30a and 40a extending from the shell-like ligand 20 are compatibly mixed with the polymerizable compound 50 in the medium, and the nanoparticles 10 are therefore less likely to aggregate. Furthermore, the organic groups 30a and 40a extending from the shell-like ligand 20 are compatibly mixed with the polymerizable compound 50 in the medium, and the nanoparticle 10 is protected by the shell-like ligand 20 even when the nanoparticle 10 is close to a polar molecule or the polymerizable compound 50 in the medium 90.

The organic groups 30a and 40a

As illustrated in Fig. 6A, the photoresponsive nanoparticle 10 surrounded by the coordinated shell-like ligand 20 is dispersed in the medium 90 and is protected from the medium 90 and the polymerizable compound described later by the shell-like ligand 20. The nanoparticle 10 may also be protected from attack by a dispersed component or a dissolved component (not shown) dispersed or dissolved in the medium 90.

The shell-like ligand 20 including a structural unit containing the quaternary ammonium salt 30b can coordinate strongly to the surface of the nanoparticle 10 (light-emitting nanocrystal).

Furthermore, because the shell-like ligand 20 has a plurality of quaternary ammonium salts 30b in the same molecule, even if some stimulus partially eliminates some coordination from the surface of the nanoparticle 10, the shell-like ligand 20 can coordinate easily again. Furthermore, a polymer chain of the organic polymer portion 40 performs a protective function as a shell for the core of the nanoparticle 10 and reduces the effects of a substance, such as a polar solvent, on the nanoparticle 10. It is thought that this improves the stability of the structure and composition of the nanoparticle 10, which is a light-emitting nanocrystal, and improves the stability of emission properties.

### (Polymerizable Compound)

As illustrated in Figs. 6A to 6C, the ink composition 330 contains the polymerizable compound 50. The polymerizable compound 50 undergoes polymerization upon receiving energy, such as light or heat, and imparts viscosity to and cure the ink composition. The polymerizable compound 50 may be a radically polymerizable compound or a cationically polymerizable compound. These may be used alone or in combination of two or more thereof. Furthermore, either a photopolymerizable compound or a thermopolymerizable compound can be used.

Any one of the polymerizable compound 50, a polymerization accelerator, a solvent, and another additive agent may be in conformity with the ink composition 330 (photoresponsive composition) according to the second embodiment.

A storage method and a measurement method described below in the fourth embodiment and the fifth embodiment may be the same as those in the first embodiment and the second embodiment.

The radically polymerizable compound is, for example, a monofunctional (meth)acrylate compound, a bifunctional (meth)acrylate compound, a trifunctional or higher functional (meth)acrylate compound, a (meth)acrylate compound with a hydroxy group, a (meth)acrylate compound with a carboxy group, a vinyl compound, or the like.

The monofunctional (meth)acrylate is, for example, methyl (meth)acrylate, ethyl (meth)acrylate, propyl (meth)acrylate, isopropyl (meth)acrylate, butyl (meth)acrylate, hexyl (meth)acrylate, 2-ethylhexyl (meth)acrylate, cyclohexyl (meth)acrylate, dicyclopentenyl (meth)acrylate, dicyclopentenyloxyethyl (meth)acrylate, benzyl (meth)acrylate, 3,3,5-trimethylcyclohexyl acrylate, tetrahydrofurfuryl (meth)acrylate, phenoxyethyl (meth)acrylate, methoxyethyl (meth)acrylate, ethylcarbitol (meth)acrylate, isobornyl (meth)acrylate, methoxytriethylene glycol (meth)acrylate, (2-methyl-2-ethyl-1,3-dioxolan-4-yl)methyl (meth)acrylate, (3-ethyloxetan-3-yl)methyl (meth)acrylate, or cyclic trimethylolpropaneformal (meth)acrylate.

The bifunctional (meth)acrylate compound is, for example, 1,4-butanediol di(meth)acrylate, 1,6-hexanediol di(meth)acrylate, 1,9-nonanediol di(meth)acrylate, ethylene glycol di(meth)acrylate, diethylene glycol di(meth)acrylate, triethylene glycol di(meth)acrylate, tetraethylene glycol di(meth)acrylate, poly(ethylene glycol) 200 di(meth)acrylate, poly(ethylene glycol) 300 di(meth)acrylate, poly(ethylene glycol) 400 di(meth)acrylate, poly(ethylene glycol) 600 di(meth)acrylate, dipropylene glycol di(meth)acrylate, tripropylene glycol di(meth)acrylate, tetrapropylene glycol di(meth)acrylate, poly(propylene glycol) 400 di(meth)acrylate, poly(propylene glycol) 700 di(meth)acrylate, neopentyl glycol di(meth)acrylate, neopentyl glycol PO-modified di(meth)acrylate, EO-modified bisphenol A di(meth)acrylate, PO-modified bisphenol A di(meth)acrylate, or neopentyl glycol hydroxypivalate di(meth)acrylate.

The trifunctional or higher functional (meth)acrylate compound is, for example, trimethylolpropane triacrylate, trimethylolpropane EO-modified tri(meth)acrylate, trimethylolpropane PO-modified tri(meth)acrylate, glycerin propoxy tri(meth)acrylate, pentaerythritol tri(meth)acrylate, tris(acryloxyethyl) isocyanurate, or EO-modified pentaerythritol tetraacrylate.

The (meth)acrylate compound with a hydroxy group is, for example, a hydroxyalkyl (meth)acrylate, such as 2-hydroxyethyl (meth)acrylate, 2-hydroxypropyl (meth)acrylate, 2-hydroxybutyl (meth)acrylate, 4-hydroxybutyl (meth)acrylate, or 6-hydroxyhexyl (meth)acrylate, 2-hydroxyethylacryloyl phosphate, 2-(meth)acryloyloxyethyl-2-hydroxypropyl phthalate, caprolactone-modified 2-hydroxyethyl (meth)acrylate, dipropylene glycol (meth)acrylate, fatty-acid-modified glycidyl (meth)acrylate, poly(ethylene glycol) mono(meth)acrylate, poly(propylene glycol) mono(meth)acrylate, 2-hydroxy-3-(meth)acryloyloxypropyl (meth)acrylate, glycerin di(meth)acrylate, or 2-hydroxy-3-acryloyl-oxypropyl methacrylate.

The (meth)acrylate compound with a carboxy group is, for example, β-carboxyethyl (meth)acrylate, a succinic acid mono(meth)acryloyloxyethyl ester, or ω-carboxy polycaprolactone mono(meth)acrylate.

The vinyl compound is, for example, vinyl acetate, vinyl benzoate, vinyl pivalate, vinyl butyrate, vinyl methacrylate, or N-vinylpyrrolidone.

The cationically polymerizable compound may be of a photopolymerization type or a thermal polymerization type. These may be used alone or in combination of two or more thereof. A typical cationically polymerizable compound is, for example, an epoxy compound, an oxetane compound, or a vinyl ether compound.

The amount of the polymerizable compound including the radically polymerizable compound and the cationically polymerizable compound to be used preferably ranges from 1 to 99 parts by mass, more preferably 3 to 90 parts by mass, still more preferably 5 to 80 parts by mass, per 100 parts by mass of the ink composition 300.

### (Solvent)

The ink composition 300 may contain a solvent as a component of the medium, as required. The solvent is, for example, an alkane, such as pentane or hexane, a cycloalkane, such as cyclopentane or cyclohexane, an ester, such as ethyl acetate, butyl acetate, or benzyl acetate, an ether, such as diethyl ether or tetrahydrofuran, a ketone, such as cyclohexanone or acetone, or an alcohol, such as methanol, ethanol, isopropanol, butanol, or hexanol. The solvent may also be a monoacetate compound, such as diethylene glycol monoethyl ether acetate, ethylene glycol monoethyl ether acetate, diethylene glycol monobutyl ether acetate, or dipropylene glycol methyl ether acetate, a diacetate compound, such as 1,4-butanediol diacetate or propylene glycol diacetate, or a triacetate compound, such as glyceryl triacetate.

To easily remove the solvent before the polymerizable compound is cured, the solvent has a boiling point of 300°C or less. The solvent may also be referred to as a solvent medium.

### (Other Additive Agents)

In the present embodiment, if necessary, the ink composition may be used in a mixture with a polymerization initiator, a deoxidizer, an antioxidant, a scattering agent, such as titanium oxide, a surfactant, a fungicide, a light stabilizer, an additive agent imparting other characteristics, a diluting solvent, or the like.

### (Measurement Method)

The molecular weight distribution measurement, the composition analysis, the crystal structure analysis, a method for examining a ligand coordinated to a nanoparticle, the photoresponsive nanoparticle content, the polymer content, and a method for measuring the number of millimoles of a betaine group per gram of a photoresponsive nanoparticle are the same as in the first embodiment.

### (Analysis of Anionic Species in Quaternary Ammonium Salt)

An anionic species in a quaternary ammonium salt can be analyzed by combustion-ion chromatography. A sample is burned in an airflow containing oxygen, the evolved gas is recovered, and the resulting ions are separated and quantified by ion chromatography to analyze anionic species. For example, an automatic sample combustion system AQF-2100 (manufactured by Mitsubishi Chemical Analytech Co., Ltd.) and an ion chromatograph IC-2010 (manufactured by Tosoh Corporation) can be used.

### <Sixth Embodiment>

A photoresponsive material 180 according to the present embodiment is different from the photoresponsive materials 100, 120, 140, and 160 according to the first to sixth embodiments in that an organosilicon polymer portion 44 is included instead of the organic polymer portion 40. The photoresponsive materials 100 to 180 according to the first to sixth embodiments including the present embodiment are common in that they have the shell-like polymer portions 40 and 44 bound to the photoresponsive nanoparticle 10 at a plurality of positions via a plurality of binding portions 30 with a zwitterionic structural unit.

### (Organosilicon Polymer portion)

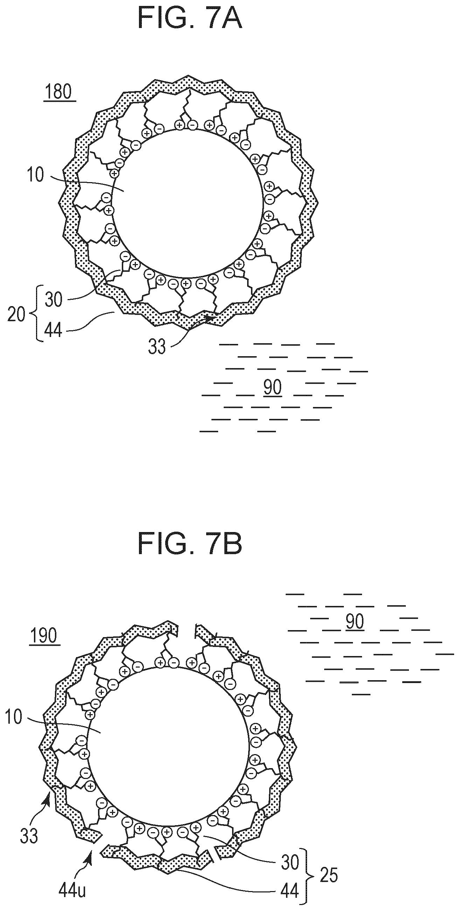

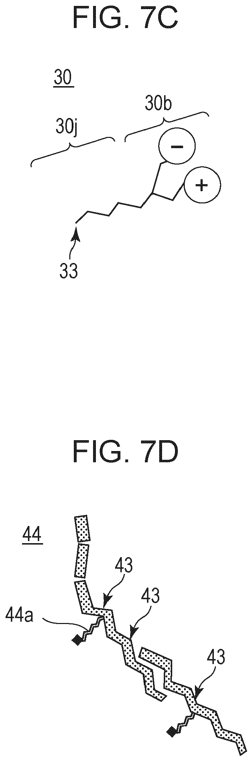

As illustrated in Fig. 7D, the organosilicon polymer portion 44 in the shell-like ligand 20 has a polymer chain constituting a linear or branched shell structure. The polymer chain has a bonding arm 43. The bonding arm 43 is a portion related to bonding to the binding portions 30 and corresponds to the bonding arm 33 of the binding portion 30 illustrated in Fig. 7C. The shell-like ligand 20 with the organosilicon polymer portion 44 and the organosilicon polymer portion 44 may also be referred to as a silica shell 44.

The organosilicon polymer portion 44 may have a plurality of bonding arms 33. The organosilicon polymer portion 44 and an adjacent organosilicon polymer portion 44 overlap and are entangled with each other, forming an organic polymer network constituting the shell-like ligand 20.

A discontinuous portion 44u in Fig. 7B is a gap between the adjacent organosilicon polymer portions 44 and may have a plurality of forms, including a linear or branched slit type and an independent opening type corresponding to a mesh of an organic polymer chain constituting the shell structure.

The organosilicon polymer portion 44 contains a polysiloxane compound with Si-O- linked to the main chain. The organosilicon polymer portion 44 may be a copolymer having a structural unit represented by at least one of the formulae (4) and (5) and preferably contains a copolymer having structural units represented by the formulae (4) and (5). The organosilicon polymer portion 44 may also be referred to as a polysiloxane compound portion 44 or an organosilicon compound portion 44.

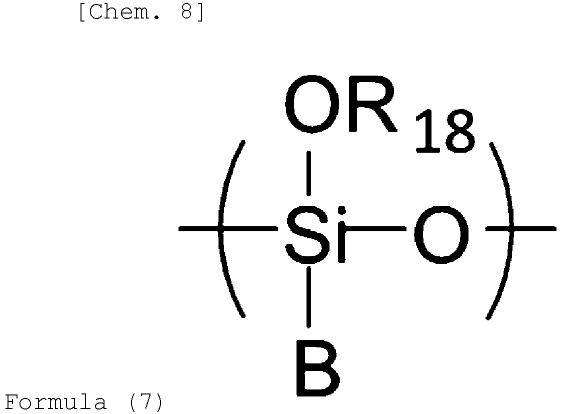

In the formula (7), R₁₈ denotes any one of a hydrogen atom and an alkyl group, and B denotes a bonding arm to one of the binding portions.

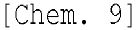

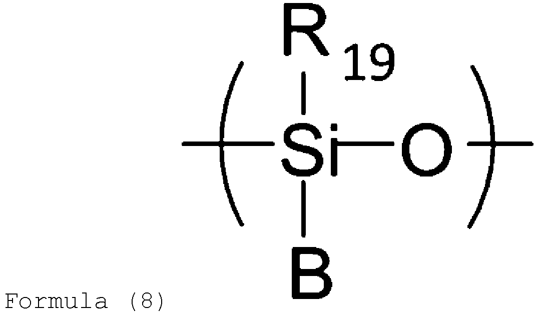

In the formula (8), R₁₉ denotes an alkyl group, and B denotes a bonding arm to one of the binding portions.

The alkyl group in R₁₈ can be an alkyl group with 1 to 30 carbon atoms, preferably an alkyl group with 1 to 4 carbon atoms. Examples thereof include a methyl group, an ethyl group, a n-propyl group, an isopropyl group, and a n-butyl group.

In the formula (7), R₁₈ can be arbitrarily selected from the substituents listed above and a hydrogen atom and is preferably a methyl group or an ethyl group from the perspective of the production of a copolymer (polymerizability).

Furthermore, the Si-OR₁₈ bond may be hydrolyzed and form a Si-O-Si bond. The Si-O-Si bond may be formed by an intermolecular condensation reaction or an intramolecular condensation reaction.

In the formula (7), R₁₈ can be arbitrarily selected from the substituents listed above, and an appropriate substituent may be selected according to the intended use.

The alkyl group in R₁₉ can be an alkyl group with 1 to 30 carbon atoms, preferably an alkyl group with 1 to 4 carbon atoms. Examples thereof include a methyl group, an ethyl group, a n-propyl group, an isopropyl group, and a n-butyl group.

For example, when the photoresponsive material is used in a highly hydrophobic medium, a substituent with a long alkyl chain is preferably selected to improve dispersibility and stability.

The copolymerization ratio of the shell-like ligand 20 corresponds to the ratio M30/M44 of the total number of moles M30 of the binding portions 30 including the structural unit represented by any one of the formulae (1) to (3) to the total number of moles M44 of the organosilicon polymer portion 44 including the structural unit represented by the formula (7) or (8). The copolymerization ratio of the shell-like ligand 20 is preferably 0.01/99.99 or more and 50/50 or less, more preferably 1/99 or more and 30/70 or less. A copolymerization composition ratio in such a range results in the photoresponsive material 100 with improved stability due to the shell-like ligand 20 strongly coordinated to the nanoparticle 10.

The organosilicon polymer portion 44 content may be appropriately adjusted according to the type and use of the nanoparticle 10 and the organosilicon polymer portion 44 and is 0.01% by weight or more and 10% by weight or less of the nanoparticle 10 content. The organosilicon polymer portion 44 content is preferably 0.05% by weight or more and 5% by weight or less, more preferably 0.1% by weight or more and 3% by weight or less. When the organosilicon polymer portion 44 content is less than 0.01% by weight, the effects as a shell are not sufficiently exhibited, and the dispersion stability of the nanoparticle 10 may not be maintained. An organosilicon polymer portion 44 content of more than 10% by weight may result in an organosilicon polymer portion with reduced solubility and dispersibility in a medium and a photoresponsive material with unimproved stability.

The organosilicon polymer portion 44 may be produced by any method, for example, by the following method.

The organosilicon polymer portion 44 can be produced by hydrolyzing betaine silane with an alkylsilane main chain connected to a betaine structure to form a Si-O-Si bond.

The organosilicon polymer portion 44 may be bound to the surface of the nanoparticle 10 by a method of coordinating a silane compound with the betaine structure 30b (hereinafter referred to as a betaine silane compound) after the synthesis of the nanoparticle 10 and then forming the organosilicon polymer portion 44 by hydrolysis. The organosilicon polymer portion 44 may also be bound to the surface of the nanoparticle 10 by a method of allowing a silane compound with the betaine structure 30b to coexist for bonding during the synthesis of the nanoparticle 10 and forming the organosilicon polymer portion by hydrolysis after purification.

The betaine silane compound can be a sulfobetaine silane compound with a SO₃⁻ group as a counter anion of the quaternary ammonium moiety, a carboxybetaine silane compound with a COO⁻ group as a counter anion of the quaternary ammonium moiety, or a phosphobetaine silane compound with a HPO₃⁻ group as a counter anion of the quaternary ammonium moiety.

A sulfobetaine silane can be produced, for example, by a method described in the following literature.

### Langmuir 30. 38 (2014): 11386-11393.

A sulfobetaine silane compound can be produced by a reaction of an aminoalkyl silane with sultone. [3-(N,N-dimethylamino)propyl]trimethoxysilane is preferably used as an aminoalkyl silane due to the formation of a quaternary ammonium. (N,N-dimethyl-3-aminopropyl)methyldimethoxysilane may also be used. The sultone may be a four- or five-membered ring sultone. The number of carbon atoms in the alkylene group of the linking group A₂ or A₄ that links the quaternary ammonium moiety and the counter anion moiety Y⁻thereof is 3 when a four-membered ring sultone is used or 4 when a five-membered ring sultone is used.

A carboxybetaine silane compound can be produced, for example, by a method described in the following literature. RSC advances 6. 30 (2016): 24827-24834.

A phosphobetaine silane compound can be produced, for example, by a method described in the following literature. ACS applied materials & interfaces 2. 10 (2010): 2781-2788.

The structures of the produced organosilicon polymer portion and the raw material betaine silane compound can be identified by various instrumental analyses. A nuclear magnetic resonance spectrometer (NMR), gel permeation chromatography (GPC), an inductively coupled plasma emission spectrometer (ICP-AES), or the like can be used as an analyzer.

To make the photoresponsive material according to the present embodiment a photoresponsive material composition that cures in response to an external stimulus, a polymerizable monomer can also be used as a medium.

### <Modified Embodiment of Sixth Embodiment>

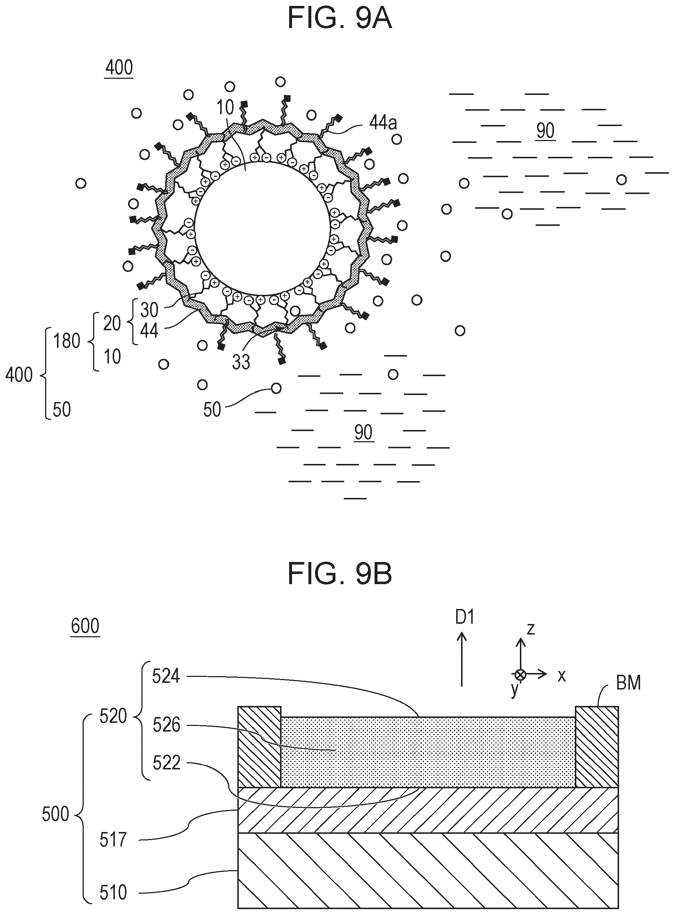

Although the shell-like ligand 20 covers the entire sphere (corresponding to a solid angle of 4π) of the nanoparticle 10 in the photoresponsive material 180 according to the sixth embodiment as illustrated in Fig. 9A, the shell-like ligand 20 does not necessarily cover the entire nanoparticle 10 in an embodiment of the present invention. Fig. 9B illustrates a schematic cross-section of a photoresponsive material 190 corresponding to a modified embodiment of the first embodiment. The photoresponsive material 190 according to the present modified embodiment is different from the photoresponsive material 180 according to the sixth embodiment in that the shell-like ligand 20 does not cover a portion of the nanoparticle 10. In the photoresponsive material 190 according to the present modified embodiment, the organosilicon polymer portion 44 is bound to the nanoparticle 10 at a plurality of positions via a plurality of binding portions 30, and the shell-like ligand 20 coordinates to the nanoparticle 10.

The shell-like ligand 20 according to the present modified embodiment has at least a portion coordinated to the nanoparticle 10 as in the shell-like ligand 20 according to the first embodiment. A portion of the shell-like ligand 20 that does not cover a portion of the nanoparticle 10 corresponds to a discontinuous portion 44u.

### (Non-Shell-Like Ligand)

The photoresponsive material 180 according to the present embodiment may have a non-shell-like ligand bound to the surface of a core containing a semiconductor nanoparticle with a perovskite crystal structure. The non-shell-like ligand may further improve stability, such as dispersion stability or spectral characteristics. The non-shell-like ligand may contain at least one compound or ion selected from the group consisting of an acid, such as carboxylic acid, sulfonic acid, or phosphonic acid, a base, such as ammonia or an amine, and a salt or ion thereof. From the perspective of dispersion stability, the non-shell-like ligand is preferably at least one compound or ion selected from the group consisting of an organic acid, an organic base, and a salt or ion thereof.

The organic acid is, for example, a branched or linear fatty acid with 1 to 30 carbon atoms. The fatty acid may be saturated or unsaturated. In particular, from the perspective of solubility and stability in a solvent, a linear fatty acid is preferred, and oleic acid is more preferred.

A salt component in an organic acid salt may be any metal cation.

The salt component in the organic acid salt is preferably an alkali metal cation or an alkaline-earth metal cation, more preferably an alkali metal cation. Among alkali metal cations, sodium and potassium are preferred, and sodium is more preferred.

The organic base is, for example, a branched or linear organic base with 1 to 30 carbon atoms. The organic base may be saturated or unsaturated. In particular, from the perspective of solubility and stability in a solvent, a linear organic base is preferred, and oleylamine is more preferred.

The non-shell-like ligand may be used alone or in combination of two or more thereof.

### (Polymerization Initiator)

In a polymerization reaction, a polymerization initiator and a polymerizable compound are typically used in combination. The polymerization initiator is a compound that produces an active species for initiating a polymerization reaction by active energy ray irradiation or heat, and can be a known polymerization initiator. A main active species for initiating a polymerization reaction may be a radical polymerization initiator for producing a radical or a cationic polymerization initiator for producing an acid. These may be used in combination. A radical photopolymerization initiator that produces a radical by active energy radiation is, for example, an acetophenone, such as diethoxyacetophenone, 2-hydroxy-2-methyl-1-phenylpropan-1-one, benzyl methyl ketal, 4-(2-hydroxyethoxy)phenyl-(2-hydroxy-2-propyl)ketone, 1-hydroxycyclohexyl phenyl ketone, 2-methyl-1-[4-(methylthio)phenyl]-2-morpholinopropan-1-one, 2-benzyl-2-dimethylamino-1-(4-morpholinophenyl)butane, oligo[2-hydroxy-2-methyl-1-[4-(1-methyl vinyl)phenyl]propanone], or 2-hydroxy-1-[4-[4-(2-hydroxy-2-methylpropionyl)benzyl]phenyl]-2-methylpropan-1-one; a benzoin, such as benzoin, benzoin methyl ether, benzoin ethyl ether, benzoin isopropyl ether, or benzoin isobutyl ether; a phosphine, such as 2,4,6-trimethylbenzoyl-diphenyl-phosphine oxide or bis(2,4,6-trimethylbenzoyl)-phenylphosphine oxide; or a phenyl glyoxylic methyl ester.

Among the radical photopolymerization initiators, an acetophenone, a phosphine, or an oxime ester compound exemplified by an aminoketone is preferred. These may be used alone or in combination depending on the characteristics required for a cured product. The amount of the radical polymerization initiator when used preferably ranges from 0.01 to 100 parts by mass, more preferably 0.1 to 50 parts by mass, per 100 parts by mass of the total solid amount of the composition.

### (Polymerizable Compound)

The ink composition 200 contains the polymerizable compound 50. The polymerizable compound 50 undergoes polymerization upon receiving energy, such as light or heat, and imparts viscosity to and cures the ink composition 200. The polymerizable compound 50 may be a radically polymerizable compound or a cationically polymerizable compound. These may be used alone or in combination of two or more thereof. Furthermore, either a photopolymerizable compound or a thermopolymerizable compound can be used.

The radically polymerizable compound is, for example, a monofunctional (meth)acrylate compound, a bifunctional (meth)acrylate compound, a trifunctional or higher functional (meth)acrylate compound, a (meth)acrylate compound with a hydroxy group, a (meth)acrylate compound with a carboxy group, a vinyl compound, or the like.

The monofunctional (meth)acrylate is, for example, methyl (meth)acrylate, ethyl (meth)acrylate, propyl (meth)acrylate, isopropyl (meth)acrylate, butyl (meth)acrylate, hexyl (meth)acrylate, 2-ethylhexyl (meth)acrylate, cyclohexyl (meth)acrylate, dicyclopentenyl (meth)acrylate, dicyclopentenyloxyethyl (meth)acrylate, benzyl (meth)acrylate, 3,3,5-trimethylcyclohexyl acrylate, tetrahydrofurfuryl (meth)acrylate, phenoxyethyl (meth)acrylate, methoxyethyl (meth)acrylate, ethylcarbitol (meth)acrylate, isobornyl (meth)acrylate, methoxytriethylene glycol (meth)acrylate, (2-methyl-2-ethyl-1,3-dioxolan-4-yl)methyl (meth)acrylate, (3-ethyloxetan-3-yl)methyl (meth)acrylate, or cyclic trimethylolpropaneformal (meth)acrylate.

The bifunctional (meth)acrylate compound is, for example, 1,4-butanediol di(meth)acrylate, 1,6-hexanediol di(meth)acrylate, 1,9-nonanediol di(meth)acrylate, ethylene glycol di(meth)acrylate, diethylene glycol di(meth)acrylate, triethylene glycol di(meth)acrylate, tetraethylene glycol di(meth)acrylate, poly(ethylene glycol) 200 di(meth)acrylate, poly(ethylene glycol) 300 di(meth)acrylate, poly(ethylene glycol) 400 di(meth)acrylate, poly(ethylene glycol) 600 di(meth)acrylate, dipropylene glycol di(meth)acrylate, tripropylene glycol di(meth)acrylate, tetrapropylene glycol di(meth)acrylate, poly(propylene glycol) 400 di(meth)acrylate, poly(propylene glycol) 700 di(meth)acrylate, neopentyl glycol di(meth)acrylate, neopentyl glycol PO-modified di(meth)acrylate, EO-modified bisphenol A di(meth)acrylate, PO-modified bisphenol A di(meth)acrylate, or neopentyl glycol hydroxypivalate di(meth)acrylate.

The trifunctional or higher functional (meth)acrylate compound is, for example, trimethylolpropane triacrylate, trimethylolpropane EO-modified tri(meth)acrylate, trimethylolpropane PO-modified tri(meth)acrylate, glycerin propoxy tri(meth)acrylate, pentaerythritol tri(meth)acrylate, tris(acryloxyethyl) isocyanurate, or EO-modified pentaerythritol tetraacrylate.

The (meth)acrylate compound with a hydroxy group is, for example, a hydroxyalkyl (meth)acrylate, such as 2-hydroxyethyl (meth)acrylate, 2-hydroxypropyl (meth)acrylate, 2-hydroxybutyl (meth)acrylate, 4-hydroxybutyl (meth)acrylate, or 6-hydroxyhexyl (meth)acrylate, 2-hydroxyethylacryloyl phosphate, 2-(meth)acryloyloxyethyl-2-hydroxypropyl phthalate, caprolactone-modified 2-hydroxyethyl (meth)acrylate, dipropylene glycol (meth)acrylate, fatty-acid-modified glycidyl (meth)acrylate, poly(ethylene glycol) mono(meth)acrylate, poly(propylene glycol) mono(meth)acrylate, 2-hydroxy-3-(meth)acryloyloxypropyl (meth)acrylate, glycerin di(meth)acrylate, or 2-hydroxy-3-acryloyl-oxypropyl methacrylate.

The (meth)acrylate compound with a carboxy group is, for example, β-carboxyethyl (meth)acrylate, a succinic acid mono(meth)acryloyloxyethyl ester, or ω-carboxy polycaprolactone mono(meth)acrylate.

The vinyl compound is, for example, vinyl acetate, vinyl benzoate, vinyl pivalate, vinyl butyrate, vinyl methacrylate, or N-vinylpyrrolidone.

The cationically polymerizable compound may be of a photopolymerization type or a thermal polymerization type. These may be used alone or in combination of two or more thereof. A typical cationically polymerizable compound is, for example, an epoxy compound, an oxetane compound, or a vinyl ether compound.

The amount of the polymerizable compound including the radically polymerizable compound and the cationically polymerizable compound to be used preferably ranges from 1 to 99 parts by mass, more preferably 3 to 90 parts by mass, still more preferably 5 to 80 parts by mass, per 200 parts by mass of the ink composition.

### (Solvent)

The ink composition 200 may contain a solvent 90 as required. The solvent 90 is, for example, an alkane, such as pentane or hexane, a cycloalkane, such as cyclopentane or cyclohexane, an ester, such as ethyl acetate, butyl acetate, or benzyl acetate, an ether, such as diethyl ether or tetrahydrofuran, a ketone, such as cyclohexanone or acetone, or an alcohol, such as methanol, ethanol, isopropanol, butanol, or hexanol. The solvent may also be a monoacetate compound, such as diethylene glycol monoethyl ether acetate, ethylene glycol monoethyl ether acetate, diethylene glycol monobutyl ether acetate, or dipropylene glycol methyl ether acetate, a diacetate compound, such as 1,4-butanediol diacetate or propylene glycol diacetate, or a triacetate compound, such as glyceryl triacetate.

To easily remove the solvent before curing the polymerizable compound 50, the solvent 90 has a boiling point of 300°C or less. The solvent 90 may also be referred to as a solvent medium 90.

### (Other Additive Agents)

In the present embodiment, if necessary, the ink composition may be used in a mixture with a deoxidizer, an antioxidant, a scattering agent, such as titanium oxide, a surfactant, a fungicide, a light stabilizer, an additive agent imparting other characteristics, a diluting solvent, or the like.

### (Wavelength Conversion Member)

A wavelength conversion member according to the present embodiment is a member produced on a substrate by curing a photoresponsive composition 200 (ink composition 200) containing the photoresponsive material 100 and a polymerizable compound 50 in a co-dispersion state illustrated in Fig. 3A. The wavelength conversion member has a layer form supported by another member and may be referred to as a wavelength conversion layer 520, as illustrated in Fig. 3B. The support form includes a layered form and a dispersed form dispersed in a matrix material. The wavelength conversion layer 520 may be a film, a sheet, or a patterned pixel produced by applying the photoresponsive composition 200 to a supporting member (substrate) and curing the composition. The photoresponsive composition 200 has fluidity before the polymerizable compound 50 is cured, and may also be referred to as an ink composition 200. Furthermore, when the photoresponsive material 100 in the photoresponsive composition 200 can emit light, the photoresponsive composition 200 is also referred to as a light-emitting composition 200.

### (Method for Forming Wavelength Conversion Layer)

The wavelength conversion layer 520 may be formed by any method, for example, a method of applying a photoresponsive material composition to a substrate, predrying the photoresponsive composition as required, and heating the photoresponsive composition or irradiating the photoresponsive composition with an active energy ray as required to cure the film. The wavelength conversion layer after curing preferably has a thickness in the range of 0.1 to 200 um, more preferably 1 to 100 µm.

The active energy ray in the active energy ray irradiation is appropriately selected from an electromagnetic wave, such as a heat ray, ultraviolet light, visible light, near-infrared light, or an electron beam, that reduces fluidity by polymerization, cross-linking, drying, or the like and promotes curing. A light source for applying the active energy ray is preferably a light source with a main emission wavelength in the wavelength region of 100 to 450 nm. Such a light source is, for example, an ultra-high-pressure mercury lamp, a high-pressure mercury lamp, a medium-pressure mercury lamp, a mercury-xenon lamp, a metal halide lamp, a high-power metal halide lamp, a xenon lamp, a pulsed xenon lamp, a deuterium lamp, a fluorescent lamp, a ND-YAG third harmonic laser, a HE-CD laser, a nitrogen laser, a XE-Cl excimer laser, a XE-F excimer laser, a semiconductor-pumped solid-state laser, an LED lamp light source with an emission wavelength of 365, 375, 385, 395, or 405 nm, or the like.

### <Seventh Embodiment>

Fig. 9A is a view of the dispersion state of a photoresponsive composition 400 (ink composition 400) according to a seventh embodiment.

The photoresponsive composition 400 is changed in viscosity and is cured due to the polymerization of the polymerizable compound contained therein. Thus, the photoresponsive composition 400 in Fig. 9A corresponding to the stage before curing is in the form of a fluid ink and may therefore be referred to as the ink composition 400. Curing may also be referred to as solidifying. The photoresponsive material 400 contains a photoresponsive material 180 and a polymerizable compound 50. In the photoresponsive material 400, the photoresponsive material 180 and the polymerizable compound 50 are co-dispersed in a solvent 90.

As illustrated in Fig. 9A, in the photoresponsive composition 400 according to the present embodiment, the shell-like ligand 20 covers the entire sphere (corresponding to a solid angle of 4π) of the nanoparticle 10. In the photoresponsive composition 400 according to the present embodiment, an alkyl chain 40a compatible with the polymerizable compound 50 contained in the medium is a portion of the structure contained in the organosilicon polymer portion 44.

The shell-like ligand 20 according to the present modified embodiment has at least a portion coordinated to the nanoparticle 10. The shell-like ligand 20 in the photoresponsive composition 400 has a discontinuous portion (not shown) that does not cover a portion of the nanoparticle 10. The discontinuous portion (not shown) that does not cover a portion of the nanoparticle 10 has a mesh opening formed by linear organosilicon polymer portions 44 extending in different directions overlapping along the shell of the shell-like ligand 20.

An embodiment having an alkyl chain as a portion of the structure of each binding portion is also included as a modified embodiment of the present embodiment. In such a modified embodiment (not shown), the alkyl chain protrudes toward the outside of the shell-like ligand through the mesh of the network structure constituted by the polymer portions.

The photoresponsive composition 400 constitutes the film-like wavelength converter 526 by the polymerizable compound 50 being cured by polymerization.

### <Ninth Embodiment>

Fig. 9B illustrates a cross-sectional structure of a display element 500 according to a ninth embodiment.

The display element 500 includes a light-emitting layer 510, a dielectric multilayer film 517, and a wavelength conversion layer 520 stacked in the stacking direction D1. The downstream side in the stacking direction D1 corresponds to the side on which a user viewing an image on the display element is positioned. The wavelength conversion layer 520 is separated from a wavelength conversion layer corresponding to an adjacent element by a black matrix BM that separates pixels.

As described above, the photoresponsive composition 200 is cured together with the polymerizable compound 50 by polymerization treatment, such as photopolymerization treatment. The photoresponsive composition 200 is cured and constitutes the wavelength conversion layer 520 of the display element 500 satisfying a predetermined dimension. Thus, the wavelength conversion layer 520 is a layer solidified by being cured together with the polymerizable compound 50.

The light-emitting layer 510 corresponds to a light source that emits light L1 with a first wavelength λ1. The wavelength conversion layer 520 has an optical coupling surface 522 optically coupled to the light-emitting layer 510 on the side of the light-emitting layer 510 and has an extraction surface 524 for extracting secondary light L2 converted by the wavelength conversion layer 520 on the opposite side of the light-emitting layer 510.

The wavelength conversion layer 520 according to the present embodiment receives the primary light L1 of the wavelength λ1 propagating through the dielectric multilayer film 917. The dielectric multilayer film 517 provides the display element 500 with the spectral transmission characteristics of the primary light from the light-emitting layer 510 and with the spectral reflection characteristics of the secondary light L2 of a wavelength λ2 emitted in the wavelength conversion layer 520. The wavelength λ2 of the secondary light L2 is longer than the wavelength λ1 of the primary light L1.

The dielectric multilayer film 917 can be replaced with another optical member optically transparent to light with the first wavelength λ1 emitted by the light-emitting layer 510. Furthermore, another optical member (not shown) can be disposed in front of the extraction surface 524 (on the side opposite the light-emitting layer 510).

### <Third Reference Embodiment>

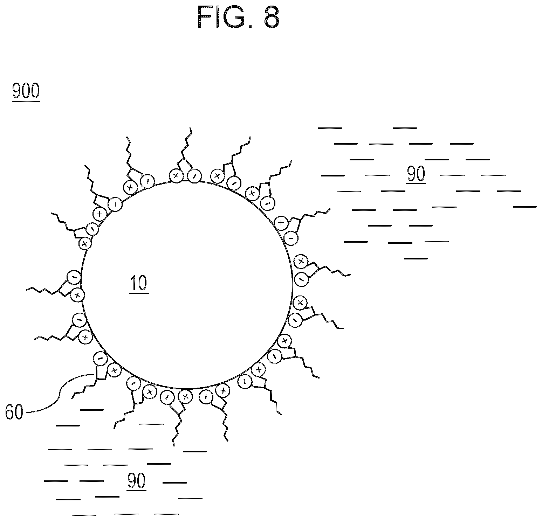

Fig. 8 illustrates the dispersibility of a photoresponsive material 900 according to a third reference embodiment in the solvent 90. The photoresponsive material 900 according to the present reference embodiment has the betaine structure 30b but no shell-like ligand 20, and only a non-shell-like ligand 60 with a linear backbone or a branched backbone extending approximately radially from the surface of the nanoparticle 10 coordinates to the surface of the light-emitting nanoparticle 10. The non-shell-like ligand 60 in the photoresponsive material 900 according to the present reference embodiment has the betaine structure 30b but no shell-like ligand 20, that is, no organic polymer 20 that surrounds the nanoparticle 10 in a shell form and coordinates in parallel at a plurality of positions via a plurality of binding portions 30.

Thus, the ligand coordinated to the nanoparticle 10 in the photoresponsive material 900 according to the present reference embodiment has a weaker bond than that in the photoresponsive material 100 according to Exemplary Embodiment 1. Consequently, it is assumed that the light-emitting nanoparticle 10 in the photoresponsive material 900 according to the present reference embodiment is easily attacked by the solvent 90 containing a polar molecule, and this changes the semiconductor composition or causes a defect in the perovskite crystal structure in a portion of the surface of the nanoparticle 10.

In the photoresponsive composition 400 according to the eighth embodiment, any one of the polymerizable compound 50, a polymerization accelerator, a solvent, and another additive agent may be in conformity with the ink composition 330 (photoresponsive composition) according to the second embodiment.

A storage method and a measurement method described below in the sixth embodiment and the seventh embodiment may be the same as those in the first embodiment, the second embodiment, the fourth embodiment, and the fifth embodiment.

### EXAMPLES

Although the present disclosure is described in more detail below with reference to a first exemplary embodiment group, the present disclosure is not limited thereto.

### [Production of Polymer 1-a]

A reaction vessel equipped with a cooling tube, a stirrer, a thermometer, and a nitrogen inlet tube was prepared. The reaction vessel was charged with 17.9 parts of 2-(methacryloyloxy)ethyl 2-(trimethylammonio)ethyl phosphate, 82.1 parts of octadecyl methacrylate, 4.1 parts of azobisisobutyronitrile, and 900 parts of n-butanol. Furthermore, nitrogen bubbling was performed on the reaction vessel for 30 minutes. The resulting reaction mixture was heated at 65°C for 8 hours in a nitrogen atmosphere to complete the polymerization reaction. The reaction liquid was cooled to room temperature, and the solvent was evaporated under reduced pressure. The resulting residue was dissolved in chloroform and was purified by dialysis using a dialysis membrane (Spectra/Por7 MWCO 1kDa manufactured by Spectrum Laboratories). The solvent was evaporated under reduced pressure, and a polymer 1-a was produced by drying at 50°C under a reduced pressure of 0.1 kPa or less.

The polymer 1-a was analyzed by the analysis method described above and was found to have a weight-average molecular weight (Mw) of 11800, and the structural unit represented by the formula (2) constituted 21% by mole of the total monomer units. The polymer 1-a may also be referred to as an intermediate raw material a or a precursor a of the shell-like ligand 20 coordinated to the particle surface of the nanoparticle 10 dispersed in the solvent 90.

### [Production of Polymer 1-b]

20.5 parts of 2-(methacryloyloxy)ethyl 2-(triethylammonio)ethyl phosphate was used instead of 2-(methacryloyloxy)ethyl 2-(trimethylammonio)ethyl phosphate. Except for this, a polymer 1-b was produced in the same manner as in the production of the polymer 1-a.

### [Production of Polymer 1-c]

18.8 parts of 2-(methacryloyloxy)-1-methylethyl 2-(trimethylammonio)ethyl phosphate was used instead of 2-(methacryloyloxy)ethyl 2-(trimethylammonio)ethyl phosphate. Except for this, a polymer 1-c was produced in the same manner as in the production of the polymer 1-a.

### [Production of Polymer 1-d]

19.6 parts of 2-(methacryloyloxy)ethyl 1,2-dimethyl-2-(trimethylammonio)ethyl phosphate was used instead of 2-(methacryloyloxy)ethyl 2-(trimethylammonio)ethyl phosphate. Except for this, a polymer 1-d was produced in the same manner as in the production of the polymer 1-a.

### [Production of Polymer 1-e]

A polymer 1-e was produced in the same manner as in the production of the polymer 1-a except that 78.7 parts of octadecyl acrylate was used instead of octadecyl methacrylate.

### [Production of Polymer 1-f]

A polymer 1-f was produced in the same manner as in the production of the polymer 1-a except that 48.1 parts of octyl methacrylate was used instead of octadecyl methacrylate.

### [Production of Polymer 1-g]

A polymer 1-g was produced in the same manner as in the production of the polymer 1-a except that 41.3 parts of hexyl methacrylate was used instead of octadecyl methacrylate.

### [Production of Polymer 1-h]

A polymer 1-h was produced in the same manner as in the production of the shell-like ligand 1-a except that 34.5 parts of butyl methacrylate was used instead of octadecyl methacrylate.

### [Production of Polymer 1-i]

2-(methacryloyloxy)ethyl 2-(trimethylammonio)ethyl phosphate was 1.8 parts, and octadecyl methacrylate was 100.5 parts. Except for this, a polymer 1-i was produced in the same manner as in the production of the polymer 1-a.

### [Production of Polymer 1-j]

2-(methacryloyloxy)ethyl 2-(trimethylammonio)ethyl phosphate was 4.5 parts, and octadecyl methacrylate was 97.5 parts. Except for this, a polymer 1-j was produced in the same manner as in the production of the polymer 1-a.

### [Production of Polymer 1-k]

A polymer 1-k was produced in the same manner as in the production of the shell-like ligand 1-a except that 9.8 parts of 2-(methacryloyloxy)ethyl 2-(trimethylammonio)ethyl phosphate and 45.9 parts of hexyl methacrylate instead of octadecyl methacrylate were used.

### [Production of Polymer 1-1]

A polymer 1-l was produced in the same manner as in the production of the polymer 1-a except that 332.2 parts of 2-(methacryloyloxy)ethyl 2-(trimethylammonio)ethyl phosphate and 33.0 parts of hexyl methacrylate instead of octadecyl methacrylate were used.

### [Production of Comparative Polymer 1-m]

A comparative polymer 1-m was produced in the same manner as the polymer 1-a except that 102.6 parts of octadecyl methacrylate was used instead of 17.9 parts of 2-(methacryloyloxy)ethyl 2-(trimethylammonio)ethyl phosphate and 82.1 parts of octadecyl methacrylate.

Table 1 shows the composition ratio and the weight-average molecular weight (Mw) of each of the polymers 1-a to 1-m produced as described above. In Table 1, X denotes a binding site of the structural unit represented by the formula (1) to the polymer main chain, and X' denotes a binding site of the structural unit represented by the formula (1) to the phosphate moiety. Y denotes a binding site of the structural unit represented by the formula (1) to the phosphate moiety, Y' denotes a binding site of the structural unit represented by the formula (1) to the quaternary ammonium salt moiety, and Z denotes a binding site of the structural unit represented by the formula (4) to the polymer main chain.

### [Table 1]

**Table 1**

| Polymer No. | Structure of polymer | | | | | | | Composition ratio (mole ratio) [formula (1):formula (6)] | Mw |
|---|---|---|---|---|---|---|---|---|---|
| | Formula (1) structure | | | | | Formula (6) structure | | | |
| | R₁ | R₂ | R₃ | A₁ | A₂ | R₁₆ | R17 | | |
| Polymer a | CH₃ | CH₃ | CH₃ | 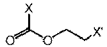 | Y-CH₂-CH₂-Y' | CH₃ | 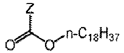 | 21:79 | 11,800 |
| Polymer 1-b | CH₂CH₃ | CH₂CH₃ | CH₂CH₃ | 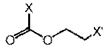 | Y-CH₂-CH₂-Y' | CH₃ | 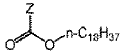 | 21:79 | 12,500 |
| Polymer 1-c | CH₃ | CH₃ | CH₃ | 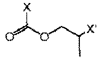 | Y-CH₂-CH₂-Y' | CH₃ | 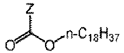 | 20:80 | 11,100 |
| Polymer 1-d | CH₃ | CH₃ | CH₃ | 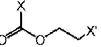 | | CH₃ | 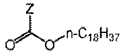 | 20:80 | 11,400 |
| Polymer 1-e | CH₃ | CH₃ | CH₃ | 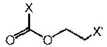 | Y-CH₂-CH₂-Y' | H | 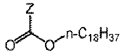 | 19:81 | 11,000 |
| Polymer 1-f | CH₃ | CH₃ | CH₃ | 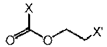 | Y-CH₂-CH₂-Y' | CH₃ | 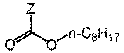 | 22:78 | 10,100, |
| Polymer 1-g | CH₃ | CH₃ | CH₃ | 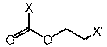 | Y-CH₂-CH₂-Y' | CH₃ | 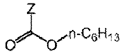 | 19:81 | 10,200 |
| Polymer 1-h | CH₃ | CH₃ | CH₃ | 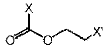 | Y-CH₂-CH₂-Y' | CH₃ | 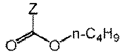 | 19:81 | 9,800 |
| Polymer 1-i | CH₃ | CH₃ | CH₃ | 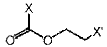 | Y-CH₂-CH₂-Y' | CH₃ | 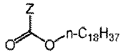 | 2:98 | 12,300 |
| Polymer 1-j | CH₃ | CH₃ | CH₃ | 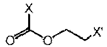 | Y-CH₂-CH₂-Y' | CH₃ | 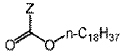 | 5:95 | 10,500 |
| Polymer 1-k | CH₃ | CH₃ | CH₃ | 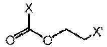 | Y-CH₂-CH₂-Y' | CH₃ | 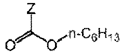 | 11:89 | 14,000 |
| Polymer 1-l | CH₃ | CH₃ | CH₃ | 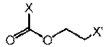 | Y-CH₂-CH₂-Y' | CH₃ | 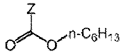 | 36:64 | 17,200 |
| Polymer 1-m | None | | | | | CH₃ | 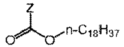 | 0:100 | 11,500 |

### [Production of Polymer 1-n]

A reaction vessel equipped with a cooling tube, a stirrer, a thermometer, and a nitrogen inlet tube was prepared. The reaction vessel was charged with 25.4 parts of 3-[[2-(methacryloyloxy)ethyl]dimethylammonio]propane-1-sulfonic acid, 36.1 parts of hexyl methacrylate, 4.1 parts of azobisisobutyronitrile, and 900 parts of 2,2,2-trifluoroethanol. Furthermore, nitrogen bubbling was performed on the reaction vessel for 30 minutes. The resulting reaction mixture was heated at 78°C for 8 hours in a nitrogen atmosphere to complete the polymerization reaction. The reaction liquid was cooled to room temperature, and the solvent was evaporated under reduced pressure. The resulting residue was dissolved in 2,2,2-trifluoroethanol and was purified by dialysis using a dialysis membrane (Spectra/Por7 MWCO 1kDa manufactured by Spectrum Laboratories). The solvent was evaporated under reduced pressure, and a polymer 1-n was produced by drying at 50°C under a reduced pressure of 0.1 kPa or less.

### [Production of Polymer 1-o]

A polymer 1-o was produced in the same manner as the polymer 1-n except that 42.3 parts of 3-[[2-(methacryloyloxy)ethyl]dimethylammonio]propane-1-sulfonic acid and 25.8 parts of hexyl methacrylate were used.

### [Production of Polymer 1-p]

A polymer 1-p was produced in the same manner as the polymer 1-n except that 22.8 parts of 2-[[2-(methacryloyloxy)ethyl]dimethylammonio]acetic acid and 33.5 parts of hexyl methacrylate were used instead of 3-[[2-(methacryloyloxy)ethyl]dimethylammonio]propane-1-sulfonic acid.

Table 2 shows the composition ratio and the weight-average molecular weight (Mw) of each of the polymers 1-n to 1-p produced as described above. In Table 2, X denotes a binding site of the structural unit represented by the formula (2) to the polymer main chain, and X' denotes a binding site of the structural unit represented by the formula (2) to the quaternary ammonium moiety. Y denotes a binding site of the structural unit represented by the formula (2) to the quaternary ammonium moiety, Y' denotes a binding site of the structural unit represented by the formula (2) to the Y- moiety, and Z denotes a binding site of the structural unit represented by the formula (2) to the polymer main chain.

### [Table 2]

**Table 2**

| Polymer No. | Structure of polymer | | | | | | | Composition ratio (mole ratio) [formula (2):formula (6)] | Mw |
|---|---|---|---|---|---|---|---|---|---|
| | Formula (2) structure | | | | | Formula (6) structure | | | |
| | R₄ | R₅ | A₃ | A₄ | Y- | R₁₆ | R₁₇ | | |
| Polymer 1-n | CH₃ | CH₃ | 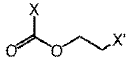 | Y-CH₂-Y' | SO₃- | CH₃ | 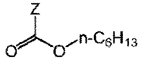 | 18:82 | 13,500 |
| Polymer 1-o | CH₃ | CH₃ | 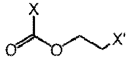 | Y-CH₂-Y' | SO₃- | CH₃ | 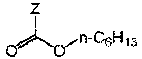 | 34:36 | 15,400 |
| Polymer 1-p | CH₃ | CH₃ | 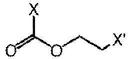 | Y-CH₂-Y' | CO₂- | CH₃ | 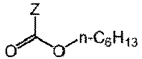 | 22:78 | 11,900 |

### (Exemplary Embodiment 1-1)

### [Preparation of Polymer 1- Solution]

### (Toluene Solution of Polymer 1-a)

A reaction vessel equipped with a stirrer, a thermometer, and a refluxing condenser was charged with 1 part of the polymer 1-a and 99 parts of toluene, was heated to 110°C, and was heated at this temperature for 5 minutes. After confirming that the polymer 1-a was completely dissolved, a toluene solution of the polymer 1-a was produced by cooling to room temperature.

### [Production of Light-Emitting Nanocrystal Dispersion Liquid 1-a]

10 parts of cesium carbonate, 27 parts of oleic acid, and 385 parts of 1-octadecene were placed in a flask, were heated to 120°C, and were degassed with a vacuum pump for 30 minutes. Furthermore, the liquid was heated to 150°C in a dry nitrogen stream and was held for 30 minutes to produce a cation raw material liquid.

Separately, 10 parts of lead (II) bromide and 494 parts of 1-octadecene were placed in a flask, were heated to 120°C, and were degassed with a vacuum pump for 1 hour. 89 parts of oleic acid and 31 parts of oleylamine were added, and the mixture was degassed with a vacuum pump for 30 minutes. The liquid temperature was then altered to 185°C in a nitrogen flow.

40 parts of the cation raw material liquid was added thereto, and the mixture was cooled with ice after 5 seconds. 2000 parts of ethyl acetate was added thereto, the mixture was centrifuged, and the supernatant was removed. The residue was dispersed in toluene to adjust the solid concentration to 1% by weight. Thus, a light-emitting nanocrystal dispersion liquid 1-a with a CsPbBr₃ perovskite crystal structure was produced.

### [Preparation of Photoresponsive Material 1-1]

10 parts of the light-emitting nanocrystal dispersion liquid 1-a was placed in a vessel, and the solvent was evaporated under reduced pressure. 10 parts of the toluene solution of the polymer 1-a was added thereto, and the mixture was stirred for 3 hours to produce a photoresponsive material 1-1.

### (Exemplary Embodiments 1-2 to 1-10)

Photoresponsive materials 1-2 to 1-10 were produced in the same manner as in Exemplary Embodiment 1-1 except that shell-like ligands b to i were respectively used instead of the polymer 1-a.

### [Production of Light-Emitting Nanocrystal Dispersion Liquid 1-b]

A light-emitting nanocrystal dispersion liquid 1-b with a CsPb(Br/I)₃ perovskite crystal structure was produced in the same manner as the light-emitting nanocrystal dispersion liquid 1-a except that 3.2 parts of lead (II) bromide and 9.3 parts of lead (II) iodide were used instead of 10 parts of lead (II) bromide.

### (Exemplary Embodiment 1-11)

A photoresponsive material 1-11 was produced in the same manner as in Exemplary Embodiment 1-1 except that the light-emitting nanocrystal dispersion liquid 1-b was used instead of the light-emitting nanocrystal dispersion liquid 1-a and that 0.8 parts of the polymer 1-g and 99.2 parts of toluene were used instead of 1 part of the polymer 1-a and 99 parts of toluene.

### (Exemplary Embodiment 1-12)

A photoresponsive material 1-12 was produced in the same manner as in Exemplary Embodiment 1-1 except that the light-emitting nanocrystal dispersion liquid 1-b was used instead of the light-emitting nanocrystal dispersion liquid 1-a and that 0.8 parts of the polymer 1-n and 99.2 parts of toluene were used instead of 1 part of the polymer 1-a and 99 parts of toluene.

### (Exemplary Embodiment 1-13)

A photoresponsive material 1-13 was produced in the same manner as in Exemplary Embodiment 1-1 except that the light-emitting nanocrystal dispersion liquid 1-b was used instead of the light-emitting nanocrystal dispersion liquid 1-a and that 0.8 parts of the polymer 1-p and 99.2 parts of toluene were used instead of 1 part of the polymer 1-a and 99 parts of toluene.

### [Production of Light-Emitting Nanocrystal Dispersion Liquid 1-c]

A light-emitting nanocrystal dispersion liquid 1-c with a CsPbI₃ perovskite crystal structure was produced in the same manner as the light-emitting nanocrystal dispersion liquid 1-a except that 12.5 parts of lead (II) iodide was used instead of 10 parts of lead (II) bromide.

### (Exemplary Embodiment 1-14)

A photoresponsive material 1-14 was produced in the same manner as in Exemplary Embodiment 1-1 except that the light-emitting nanocrystal dispersion liquid 1-c was used instead of the light-emitting nanocrystal dispersion liquid 1-a and that 0.8 parts of the polymer 1-g and 99.2 parts of toluene were used instead of 1 part of the polymer 1-a and 99 parts of toluene.

### (Exemplary Embodiment 1-15)

A photoresponsive material 1-15 was produced in the same manner as in Exemplary Embodiment 1-1 except that the light-emitting nanocrystal dispersion liquid 1-c was used instead of the light-emitting nanocrystal dispersion liquid 1-a and that 0.8 parts of the polymer 1-n and 99.2 parts of toluene were used instead of 1 part of the polymer 1-a and 99 parts of toluene.

### (Exemplary Embodiment 1-16)

A photoresponsive material 1-16 was produced in the same manner as in Exemplary Embodiment 1-1 except that the light-emitting nanocrystal dispersion liquid 1-c was used instead of the light-emitting nanocrystal dispersion liquid 1-a and that 0.8 parts of the polymer 1-p and 99.2 parts of toluene were used instead of 1 part of the polymer 1-a and 99 parts of toluene.

### [Production of Light-Emitting Nanocrystal Dispersion Liquid 1-c]

A light-emitting nanocrystal dispersion liquid 1-c with a CsPbI₃ perovskite crystal structure was produced in the same manner as the light-emitting nanocrystal dispersion liquid 1-a except that 12.5 parts of lead (II) iodide was used instead of 10 parts of lead (II) bromide.

### [Production of Light-Emitting Nanocrystal Dispersion Liquid 1-d]

First, an oleate solution of methylamine acetate was synthesized as described below. 40 parts of methylamine acetate and 1290 parts of oleic acid were mixed in a flask and were degassed with a vacuum pump at room temperature for 3 hours. The mixture was heated to 120°C and was degassed for 30 minutes to produce an oleate solution of methylamine acetate.

Next, an oleate solution of formamidine acetate was synthesized as described below. 46 parts of formamidine acetate and 1290 parts of oleic acid were mixed in a flask and were degassed with a vacuum pump at room temperature for 3 hours. The mixture was heated to 120°C and was degassed for 30 minutes to produce an oleate solution of formamidine acetate.

Separately, 10 parts of lead bromide, 129 parts of oleic acid, 59 parts of oleylamine, and 572 parts of octadecene were placed in a flask, were heated to 160°C, and were degassed with a vacuum pump for 100 minutes. 16 parts of the oleate solution of methylamine acetate and 77 parts of the oleate solution of formamidine acetate were mixed and added to the flask all at once. 10 seconds after the addition, the flask was cooled with ice. The ice-cooled solution was centrifuged, and the supernatant was removed. The resulting residue was dispersed in hexane and was further centrifuged to remove a precipitate. The solid concentration was adjusted to 1% by weight to produce a light-emitting nanocrystal dispersion liquid 1-d with a (MA/FA)PbBr₃ perovskite crystal structure.

### (Exemplary Embodiment 1-17)

A photoresponsive material 1-17 was produced in the same manner as in Exemplary Embodiment 1-1 except that the light-emitting nanocrystal dispersion liquid 1-d was used instead of the light-emitting nanocrystal dispersion liquid 1-a and that 0.5 parts of the polymer 1-g and 99.5 parts of toluene were used instead of 1 part of the polymer 1-a and 99 parts of toluene.

### (Exemplary Embodiment 1-18)

A photoresponsive material 1-18 was produced in the same manner as in Exemplary Embodiment 1-1 except that the light-emitting nanocrystal dispersion liquid 1-d was used instead of the light-emitting nanocrystal dispersion liquid 1-a and that 0.5 parts of the polymer 1-n and 99.5 parts of toluene were used instead of 1 part of the polymer 1-a and 99 parts of toluene.

### (Exemplary Embodiment 1-19)

A photoresponsive material 1-19 was produced in the same manner as in Exemplary Embodiment 1-1 except that the light-emitting nanocrystal dispersion liquid 1-c was used instead of the light-emitting nanocrystal dispersion liquid 1-a and that 0.8 parts of the polymer 1-p and 99.2 parts of toluene were used instead of 1 part of the polymer 1-a and 99 parts of toluene.

### (Exemplary Embodiment 1-20)

A photoresponsive material 1-20 was produced in the same manner as in Exemplary Embodiment 1-1 except that 0.14 parts of the polymer 1-l and 99.86 parts of toluene were used instead of 1 part of the polymer 1-a and 99 parts of toluene.

### (Exemplary Embodiment 1-21)

A photoresponsive material 1-21 was produced in the same manner as in Exemplary Embodiment 1-1 except that 0.020 parts of the polymer 1-l and 99.980 parts of toluene were used instead of 1 part of the polymer 1-a and 99 parts of toluene.

### (Exemplary Embodiment 1-22)

A photoresponsive material 1-22 was produced in the same manner as in Exemplary Embodiment 1-1 except that 0.015 parts of the polymer 1-l and 99.985 parts of toluene were used instead of 1 part of the polymer 1-a and 99 parts of toluene.

### (Exemplary Embodiment 1-23)

A photoresponsive material 1-23 was produced in the same manner as in Exemplary Embodiment 1-1 except that 1 part of the polymer 1-j was used instead of 1 part of the polymer 1-a.

### (Exemplary Embodiment 1-24)

A photoresponsive material 1-24 was produced in the same manner as in Exemplary Embodiment 1-1 except that 0.19 parts of the polymer 1-g and 99.81 parts of toluene were used instead of 1 part of the polymer 1-a and 99 parts of toluene.

### (Exemplary Embodiment 1-25)

A photoresponsive material 1-25 was produced in the same manner as in Exemplary Embodiment 1-1 except that 0.3 parts of the polymer 1-k and 99.7 parts of toluene were used instead of 1 part of the polymer 1-a and 99 parts of toluene.

### (Exemplary Embodiment 1-26)

A photoresponsive material 1-26 was produced in the same manner as in Exemplary Embodiment 1-1 except that 3 parts of the polymer 1-i and 97 parts of toluene were used instead of 1 part of the polymer 1-a and 99 parts of toluene.

### (Exemplary Embodiment 1-27)

A photoresponsive material 1-27 was produced in the same manner as in Exemplary Embodiment 1-1 except that 4 parts of the polymer 1-o and 96 parts of toluene were used instead of 1 part of the polymer 1-a and 99 parts of toluene.

### (Exemplary Embodiment 1-28)

A photoresponsive material 1-28 was produced in the same manner as in Exemplary Embodiment 1-1 except that 4 parts of the polymer 1-n and 96 parts of toluene were used instead of 1 part of the polymer 1-a and 99 parts of toluene.

### (Exemplary Embodiment 1-29)

A photoresponsive material 1-29 was produced in the same manner as in Exemplary Embodiment 1-1 except that 5 parts of the polymer 1-j and 95 parts of toluene were used instead of 1 part of the polymer 1-a and 99 parts of toluene.

### (Comparative Example 1-1)

A photoresponsive material 1-30 was produced in the same manner as in Exemplary Embodiment 1-1 except that 100 parts of toluene was used instead of 1 part of the polymer 1-a and 99 parts of toluene.

### (Comparative Example 1-2)

A photoresponsive material 1-31 was produced in the same manner as in Exemplary Embodiment 1-1 except that the polymer 1-m was used instead of the polymer 1-a.

### (Comparative Example 1-3)

A photoresponsive material 1-32 was produced in the same manner as in Exemplary Embodiment 1-1 except that 0.2 parts of an octadecyl dimethyl(3-sulfopropyl)ammonium hydroxide inner salt (ligand 1-a, manufactured by Tokyo Chemical Industry Co., Ltd.) and 99.8 parts of toluene were used instead of 1 part of the polymer 1-a and 99 parts of toluene.

### (Comparative Example 1-4)

A photoresponsive material 1-33 was produced in the same manner as in Exemplary Embodiment 1-1 except that the light-emitting nanocrystal dispersion liquid 1-b was used instead of the light-emitting nanocrystal dispersion liquid 1-a and that 100 parts of toluene was used instead of 1 part of the polymer 1-a and 99 parts of toluene.

### (Comparative Example 1-5)

A photoresponsive material 1-34 was produced in the same manner as in Exemplary Embodiment 1-1 except that the light-emitting nanocrystal dispersion liquid 1-b was used instead of the light-emitting nanocrystal dispersion liquid 1-a and that the polymer 1-m was used instead of the polymer 1-a.

### (Comparative Example 1-6)

A photoresponsive material 1-35 was produced in the same manner as in Exemplary Embodiment 1-1 except that the light-emitting nanocrystal dispersion liquid 1-b was used instead of the light-emitting nanocrystal dispersion liquid 1-a and that 0.2 parts of the ligand 1-a and 99.8 parts of toluene were used instead of 1 part of the polymer 1-a and 99 parts of toluene.

### (Comparative Example 1-7)

A photoresponsive material 1-36 was produced in the same manner as in Exemplary Embodiment 1-1 except that the light-emitting nanocrystal dispersion liquid 1-c was used instead of the light-emitting nanocrystal dispersion liquid 1-a and that 100 parts of toluene was used instead of 1 part of the polymer 1-a and 99 parts of toluene.

### (Comparative Example 1-8)

A photoresponsive material 1-37 was produced in the same manner as in Exemplary Embodiment 1-1 except that the light-emitting nanocrystal dispersion liquid 1-c was used instead of the light-emitting nanocrystal dispersion liquid 1-a and that the polymer 1-m was used instead of the polymer 1-a.

### (Comparative Example 1-9)

A photoresponsive material 1-38 was produced in the same manner as in Exemplary Embodiment 1-1 except that the light-emitting nanocrystal dispersion liquid 1-b was used instead of the light-emitting nanocrystal dispersion liquid 1-c and that 0.2 parts of the ligand 1-a and 99.8 parts of toluene were used instead of 1 part of the polymer 1-a and 99 parts of toluene.

### (Comparative Example 1-10)

A photoresponsive material 1-39 was produced in the same manner as in Exemplary Embodiment 1-1 except that the light-emitting nanocrystal dispersion liquid 1-d was used instead of the light-emitting nanocrystal dispersion liquid 1-a and that 100 parts of toluene was used instead of 1 part of the polymer 1-a and 99 parts of toluene.

### (Comparative Example 1-11)

A photoresponsive material 1-40 was produced in the same manner as in Exemplary Embodiment 1-1 except that the light-emitting nanocrystal dispersion liquid 1-d was used instead of the light-emitting nanocrystal dispersion liquid 1-a and that the polymer 1-m was used instead of the polymer 1-a.

### (Comparative Example 1-12)

A photoresponsive material 1-41 was produced in the same manner as in Exemplary Embodiment 1-1 except that the light-emitting nanocrystal dispersion liquid 1-d was used instead of the light-emitting nanocrystal dispersion liquid 1-a and that 0.2 parts of the ligand 1-a and 99.8 parts of toluene were used instead of 1 part of the polymer 1-a and 99 parts of toluene.

For the photoresponsive materials 1-1 to 1-41, Table 3 shows the type and concentration of the light-emitting nanocrystal, the type and concentration of the added polymer 1- or ligand, and the number of millimoles of the betaine group per gram of the light-emitting nanocrystal.

### [Table 3]

**Table 3**

| Exemplary Embodiment No. | Photoresponsive material | Photoresponsive nanocrystal | | Added polymer or ligand | | Betaine group content mmol/1g |
|---|---|---|---|---|---|---|
| | | Type | Parts | Type | Parts | |
| Exemplary Embodiment 1-1 | Photoresponsive material 1-1 | CsPbBr₃ | 1 | Polymer 1-a | 1 | 0.64 |
| Exemplary Embodiment 1-2 | Photoresponsive material 1-2 | CsPbBr₃ | 1 | Polymer 1-b | 1 | 0.64 |
| Exemplary Embodiment 1-3 | Photoresponsive material 1-3 | CsPbBr₃ | 1 | Polymer 1-c | 1 | 0.61 |
| Exemplary Embodiment 1-4 | Photoresponsive material 1-4 | CsPbBr₃ | 1 | Polymer 1-d | 1 | 0.61 |
| Exemplary Embodiment 1-5 | Photoresponsive material 1-5 | CsPbBr₃ | 1 | Polymer 1-e | 1 | 0.58 |
| Exemplary Embodiment 1-6 | Photoresponsive material 1-6 | CsPbBr₃ | 1 | Polymer 1-f | 1 | 1.00 |
| Exemplary Embodiment 1-7 | Photoresponsive material 1-7 | CsPbBr₃ | 1 | Polymer 1-g | 1 | 0.98 |
| Exemplary Embodiment 1-8 | Photoresponsive material 1-8 | CsPbBr₃ | 1 | Polymer 1-h | 1 | 1.11 |
| Exemplary Embodiment 1-9 | Photoresponsive material 1-9 | CsPbBr₃ | 1 | Polymer 1-n | 1 | 0.95 |
| Exemplary Embodiment 1-10 | Photoresponsive material 1-10 | CsPbBr₃ | 1 | Polymer 1-p | 1 | 1.22 |
| Exemplary Embodiment 1-11 | Photoresponsive material 1-11 | CsPb(Br/I)₃ | 1 | Polymer 1-g | 0.8 | 0.78 |
| Exemplary Embodiment 1-12 | Photoresponsive material 1-12 | CsPb(Br/I)₃ | 1 | Polymer 1-n | 0.8 | 0.76 |
| Exemplary Embodiment 1-13 | Photoresponsive material 1-13 | CsPb(Br/I)₃ | 1 | Polymer 1-p | 0.8 | 0.98 |
| Exemplary Embodiment 1-14 | Photoresponsive material 1-14 | CsPbl₃ | 1 | Polymer 1-g | 0.8 | 0.78 |
| Exemplary Embodiment 1-15 | Photoresponsive material 1-15 | CsPbl₃ | 1 | Polymer 1-n | 0.8 | 0.76 |
| Exemplary Embodiment 1-16 | Photoresponsive material 1-16 | CsPbl₃ | 1 | Polymer 1-p | 0.8 | 0.98 |
| Exemplary Embodiment 1-17 | Photoresponsive material 1-17 | (MA/FA)PbBr₃ | 1 | Polymer 1-g | 0.5 | 0.49 |
| Exemplary Embodiment 1-18 | Photoresponsive material 1-18 | (MA/FA)PbBr₃ | 1 | Polymer 1-n | 0.5 | 0.47 |
| Exemplary Embodiment 1-19 | Photoresponsive material 1-19 | (MA/FA)PbBr₃ | 1 | Polymer 1-p | 0.5 | 0.61 |
| Exemplary Embodiment 1-20 | Photoresponsive material 1-20 | Cs PbBr₃ | 1 | Polymer 1-l | 0.14 | 0.23 |
| Exemplary Embodiment 1-21 | Photoresponsive material 1-21 | CsPbBr₃ | 1 | Polymer 1-l | 0.02 | 0.03 |
| Exemplary Embodiment 1-22 | Photoresponsive material 1-22 | CsPbBr₃ | 1 | Polymer 1-l | 0.015 | 0.03 |
| Exemplary Embodiment 1-23 | Photoresponsive material 1-23 | CsPbBr₃ | 1 | Polymer 1-j | 1 | 0.15 |
| Exemplary Embodiment 1-24 | Photoresponsive material 1-24 | CsPbBr₃ | 1 | Polymer 1-g | 0.19 | 0.19 |
| Exemplary Embodiment 1-25 | Photoresponsive material 1-25 | CsPbBr₃ | 1 | Polymer 1-k | 0.3 | 0.18 |
| Exemplary Embodiment 1-26 | Photoresponsive material 1-26 | CsPbBr₃ | 1 | Polymer 1-i | 3 | 0.18 |
| Exemplary Embodiment 1-27 | Photoresponsive material 1-27 | CsPbBr₃ | 1 | Polymer 1-o | 4 | 6.56 |
| Exemplary Embodiment 1-28 | Photoresponsive material 1-28 | CsPbBr₃ | 1 | Polymer 1-n | 4 | 3.79 |
| Exemplary Embodiment 1-29 | Photoresponsive material 1-29 | CsPbBr₃ | 1 | Polymer 1-j | 5 | 0.74 |
| Comparative Example 1-1 | Photoresponsive material 1-30 | CsPbBr₃ | 1 | - | 0 | 0.00 |
| Comparative Example 1-2 | Photoresponsive material 1-31 | CsPbBr₃ | 1 | Polymer 1-m | 1 | 0.00 |
| Comparative Example 1-3 | Photoresponsive material 1-32 | CsPbBr₃ | 1 | Ligand 1-a | 0.2 | 0.48 |
| Comparative Example 1-4 | Photoresponsive material 1-33 | CsPb(Br/I)₃ | 1 | - | 0 | 0.00 |
| Comparative Example 1-5 | Photoresponsive material 1-34 | CsPb(Br/I)₃ | 1 | Polymer 1-m | 1 | 0.00 |
| Comparative Example 1-6 | Photoresponsive material 1-35 | CsPb(Br/I)₃ | 1 | Ligand 1-a | 0.2 | 0.48 |
| Comparative Example 1-7 | Photoresponsive material 1-36 | CsPbl₃ | 1 | - | 0 | 0.00 |
| Comparative Example 1-8 | Photoresponsive material 1-37 | CsPbl₃ | 1 | Polymer 1-m | 1 | 0.00 |
| Comparative Example 1-9 | Photoresponsive material 1-38 | CsPbl₃ | 1 | Ligand 1-a | 0.2 | 0.48 |
| Comparative Example 1-10 | Photoresponsive material 1-39 | (MA/FA)PbBr₃ | 1 | - | 0.2 | 0.48 |
| Comparative Example 1-11 | Photoresponsive material 1-40 | (MA/FA)PbBr₃ | 1 | Polymer 1-m | 1 | 0.00 |
| Comparative Example 1-12 | Photoresponsive material 1-41 | (MA/FA)PbBr₃ | 1 | Ligand 1-a | 0.2 | 0.48 |

### <Evaluation of Photoresponsive Composition 1->

The photoresponsive material 1 was subjected to the following evaluation. Table 4 shows the results.

### [Evaluation of Emission Properties]

For each photoresponsive material 1, the emission peak wavelength, the full width at half maximum, and the absolute photoluminescence quantum yield (hereinafter referred to as PLQY) were measured immediately after the production and 30 minutes after 2-propanol (hereinafter referred to as IPA) was added so as to be 50% by volume. After the addition of IPA, a sample containing the photoresponsive material 1- for the evaluation of emission properties was stored in a darkroom to prevent the promotion of separation of a non-shell-like ligand by light and the inhibition of coordination of a shell-like ligand.

The emission peak wavelength and the full width at half maximum are values of an emission spectrum from which PLQY is calculated, and PLQY is the number of photons of fluorescence when the number of excitation photons absorbed by a light-emitting nanocrystal is 1. Each photoresponsive material 1 was diluted with toluene before the measurements so that the optical absorptance at an excitation light wavelength ranged from 0.2 to 0.3. The measurement conditions and evaluation criteria are described below.

### <Measurement Conditions>

Measuring apparatus: absolute PL quantum yield measurement system C9920-03 (manufactured by Hamamatsu Photonics K.K.)
Excitation light wavelength: 460 nm
Excitation light integration range: excitation light wavelength ± 10 nm
Light emission integration range: (excitation light wavelength + 20) nm to 770 nm

### <Evaluation Criterion P-1>

PLQY immediately after the production was defined as 100, and PLQY 30 minutes after the addition of the IPA solution was defined as P-1. The evaluation was based on the following criteria.

The phrase "immediately after the production" refers to within 5 minutes from the production of the light-emitting nanocrystal dispersion liquid 1-a.
A: PLQY change rate of 80 or more
B: PLQY change rate of 70 or more and less than 80
C: PLQY change rate of 60 or more and less than 70
D: PLQY change rate of less than 60

The measured value of PLQY may vary by several percent within the limits of error of the measurement system and may slightly exceed the ideal change rate range of 0 to 100.

Some cases have a PLQY change rate of 100 or more, which was rated AA.

### [Table 4]

**Table 4**

| Exemplary Embodiment No. | Photoresponsive material | Peak wavelength/nm | | Full width at half maximum/nm | | PLQY | | P-1 | Rating |
|---|---|---|---|---|---|---|---|---|---|
| | | Immediately after production | 30 minutes after addition of IPA 50% | Immediately after production | 30 minutes after addition of IPA 50% | Immediately after production | 30 minutes after addition of IPA 50% | | |
| Exemplary Embodiment 1-1 | Photoresponsive material 1-1 | 518 | 517 | 23 | 21 | 79% | 79% | 100 | AA |
| Exemplary Embodiment 1-2 | Photoresponsive material 1-2 | 518 | 518 | 23 | 22 | 76% | 78% | 103 | AA |
| Exemplary Embodiment 1-3 | Photoresponsive material 1-3 | 518 | 518 | 22 | 23 | 78% | 78% | 100 | AA |
| Exemplary Embodiment 1-4 | Photoresponsive material 1-4 | 518 | 516 | 23 | 21 | 78% | 77% | 99 | A |
| Exemplary Embodiment 1-5 | Photoresponsive material 1-5 | 517 | 516 | 22 | 22 | 79% | 79% | 100 | AA |
| Exemplary Embodiment 1-6 | Photoresponsive material 1-6 | 518 | 516 | 22 | 22 | 71% | 68% | 95 | A |
| Exemplary Embodiment 1-7 | Photoresponsive material 1-7 | 517 | 516 | 22 | 23 | 75% | 70% | 94 | A |
| Exemplary Embodiment 1-8 | Photoresponsive material 1-8 | 518 | 517 | 23 | 23 | 77% | 71% | 93 | A |
| Exemplary Embodiment 1-9 | Photoresponsive material 1-9 | 517 | 515 | 23 | 24 | 71% | 67% | 94 | A |
| Exemplary Embodiment 1-10 | Photoresponsive material 1-10 | 518 | 516 | 22 | 22 | 71% | 60% | 84 | A |
| Exemplary Embodiment 1-11 | Photoresponsive material 1-11 | 646 | 640 | 38 | 36 | 79% | 66% | 83 | A |
| Exemplary Embodiment 1-12 | Photoresponsive material 1-12 | 647 | 640 | 38 | 38 | 78% | 71% | 91 | A |
| Exemplary Embodiment 1-13 | Photoresponsive material 1-13 | 651 | 640 | 38 | 36 | 74% | 52% | 71 | B |
| Exemplary Embodiment 1-14 | Photoresponsive material 1-14 | 688 | 685 | 41 | 38 | 87% | 75% | 87 | A |
| Exemplary Embodiment 1-15 | Photoresponsive material 1-15 | 686 | 683 | 41 | 40 | 87% | 77% | 88 | A |
| Exemplary Embodiment 1-16 | Photoresponsive material 1-16 | 691 | 685 | 41 | 41 | 79% | 76% | 96 | A |
| Exemplary Embodiment 1-17 | Photoresponsive material 1-17 | 535 | 533 | 22 | 22 | 80% | 77% | 96 | A |
| Exemplary Embodiment 1-18 | Photoresponsive material 1-18 | 536 | 533 | 22 | 22 | 80% | 74% | 93 | A |
| Exemplary Embodiment 1-19 | Photoresponsive material 1-19 | 534 | 533 | 23 | 22 | 76% | 70% | 93 | A |
| Exemplary Embodiment 1-20 | Photoresponsive material 1-20 | 519 | 517 | 24 | 23 | 63% | 67% | 107 | AA |
| Exemplary Embodiment 1-21 | Photoresponsive material 1-21 | 518 | 515 | 24 | 22 | 61% | 44% | 72 | B |
| Exemplary Embodiment 1-22 | Photoresponsive material 1-22 | 517 | 517 | 24 | 21 | 61% | 38% | 63 | C |
| Exemplary Embodiment 1-23 | Photoresponsive material 1-23 | 518 | 516 | 22 | 22 | 62% | 49% | 79 | B |
| Exemplary Embodiment 1-24 | Photoresponsive material 1-24 | 516 | 515 | 24 | 22 | 62% | 49% | 79 | B |
| Exemplary Embodiment 1-25 | Photoresponsive material 1-25 | 517 | 516 | 24 | 24 | 62% | 48% | 77 | B |
| Exemplary Embodiment 1-26 | Photoresponsive material 1-26 | 518 | 515 | 24 | 24 | 53% | 36% | 67 | C |
| Exemplary Embodiment 1-27 | Photoresponsive material 1-27 | 517 | 516 | 23 | 24 | 55% | 44% | 79 | B |
| Exemplary Embodiment 1-28 | Photoresponsive material 1-28 | 517 | 516 | 24 | 24 | 59% | 56% | 95 | A |
| Exemplary Embodiment 1-29 | Photoresponsive material 1-29 | 516 | 515 | 24 | 23 | 58% | 52% | 90 | A |
| Comparative Example 1-1 | Photoresponsive material 1-30 | 518 | 517 | 22 | 23 | 55% | 11% | 20 | D |
| Comparative Example 1-2 | Photoresponsive material 1-31 | 517 | 516 | 24 | 23 | 57% | 30% | 53 | D |
| Comparative Example 1-3 | Photoresponsive material 1-32 | 517 | 517 | 24 | 26 | 79% | 47% | 59 | D |
| Comparative Example 1-4 | Photoresponsive material 1-33 | 651 | 633 | 39 | 51 | 78% | 5% | 6 | D |
| Comparative Example 1-5 | Photoresponsive material 1-34 | 651 | 612 | 39 | 42 | 80% | 5% | 6 | D |
| Comparative Example 1-6 | Photoresponsive material 1-35 | 651 | 641 | 39 | 39 | 80% | 36% | 45 | D |
| Comparative Example 1-7 | Photoresponsive material 1-36 | 688 | 690 | 39 | 33 | 92% | 7% | 8 | D |
| Comparative Example 1-8 | Photoresponsive material 1-37 | 685 | 684 | 42 | 40 | 85% | 26% | 30 | B |
| Comparative Example 1-9 | Photoresponsive material 1-38 | 685 | 682 | 41 | 42 | 84% | 59% | 71 | B |
| Comparative Example 1-10 | Photoresponsive material 1-39 | 535 | 534 | 23 | 21 | 77% | 61% | 78 | B |
| Comparative Example 1-11 | Photoresponsive material 1-40 | 536 | 533 | 23 | 21 | 82% | 63% | 78 | B |
| Comparative Example 1-12 | Photoresponsive material 1-41 | 535 | 535 | 23 | 22 | 82% | 64% | 78 | B |

Table 4 shows that the photoresponsive materials 1-1 to 1-29 according to Exemplary Embodiments 1-1 to 1-29 have a high PLQY and a low full width at half maximum (a narrow full width at half maximum) immediately after the production. Furthermore, as can be seen from the evaluation criterion P-1, the photoresponsive materials 1-1 to 1-29 according to Exemplary Embodiments 1-1 to 1-29 can maintain the PLQY value even after the addition of the polar solvent IPA. This is probably because, in the photoresponsive materials 1-1 to 1-29 according to Exemplary Embodiments 1-1 to 1-29, the shell-like ligand 20 with a specific structure protects the nanoparticle 10 and ensures the stability of the nanoparticle 10.

Furthermore, it is thought that the effects of the shell-like ligand on the stabilization of the nanoparticle 10 do not depend on the composition of the A site and the X site in the light-emitting nanocrystal and are effective for another light-emitting nanocrystal with a perovskite crystal structure. Furthermore, as described later, the effects of the shell-like ligand on the stabilization of the nanoparticle 10 were also observed as an improvement in resistance to heat or light.

By contrast, the photoresponsive material 1 without the shell-like ligand 20 as in Comparative Examples 1-1, 1-4, 1-7, and 1-10 had a wide full width at half maximum or a low PLQY immediately after the production in some cases. Furthermore, in the photoresponsive material 1 without the shell-like ligand 20 as in Comparative Examples 1-1, 1-4, 1-7, and 1-10, the addition of IPA caused deactivation in the emission property PLQY.

Furthermore, as in Comparative Examples 1-2, 1-5, 1-8, and 1-11, the photoresponsive material 1 having the shell-like ligand without the betaine structure had a wide full width at half maximum in some cases. Furthermore, as in Comparative Examples 1-2, 1-5, 1-8, and 1-11, in the photoresponsive material 1 having the shell-like ligand without the betaine structure, the addition of IPA caused deactivation in PLQY.

Furthermore, as in Comparative Examples 1-3, 1-6, 1-9, and 1-12, when the ligand with the betaine structure was used, PLQY immediately after the production was slightly high, but the addition of IPA caused deactivation in PLQY.

### [Production of Photoresponsive Composition 1-]

### (Exemplary Embodiment 1-30)

A photoresponsive composition 1-1 was produced by blending 20 parts of the photoresponsive material 1-1, 76 parts of 3,3,5-trimethylcyclohexyl acrylate (manufactured by Osaka Organic Chemical Industry Ltd., trade name: Viscoat #196) as a polymerizable compound, 4 parts of (1-hydroxycyclohexyl phenyl ketone (manufactured by IGM Resins, trade name: Omnirad 184) as a polymerization initiator, and 4 parts of JR-603 (manufactured by Tayca Corporation) as a scattering agent.

### (Exemplary Embodiments 1-31 to 1-39)

Photoresponsive compositions 1-2 to 1-10 were produced in the same manner as in Exemplary Embodiment 1-30 except that the photoresponsive materials 1-2 to 1-10 were used instead of the photoresponsive material 1-1.

### (Exemplary Embodiments 1-40 to 1-45)

Photoresponsive compositions 1-11 to 1-16 were produced in the same manner as in Exemplary Embodiment 1-30 except that 18 parts of the photoresponsive materials 1-11 to 1-16 and 78 parts of the polymerizable compound were used instead of 20 parts of the photoresponsive material 1-1 and 76 parts of the polymerizable compound.

### (Exemplary Embodiments 1-46 to 48)

Photoresponsive compositions 1-17 to 1-9 were produced in the same manner as in Exemplary Embodiment 1-30 except that 15 parts of the photoresponsive materials 1-17 to 1-19 and 81 parts of the polymerizable compound were used instead of 20 parts of the photoresponsive material 1-1 and 76 parts of the polymerizable compound.

### (Exemplary Embodiment 1-49)

A photoresponsive composition 1-20 was produced in the same manner as in Exemplary Embodiment 1-30 except that 11.4 parts of the photoresponsive material 1-20 and 85 parts of the polymerizable compound were used instead of 20 parts of the photoresponsive material 1-1 and 76 parts of the polymerizable compound.

### (Exemplary Embodiment 1-50)

A photoresponsive composition 1-21 was produced in the same manner as in Exemplary Embodiment 1-30 except that 10.20 parts of the photoresponsive material 1-21 and 86 parts of the polymerizable compound were used instead of 20 parts of the photoresponsive material 1-1 and 76 parts of the polymerizable compound.

### (Exemplary Embodiment 1-51)

A photoresponsive composition 1-22 was produced in the same manner as in Exemplary Embodiment 1-30 except that 10.15 parts of the photoresponsive material 1-22 and 86 parts of the polymerizable compound were used instead of 20 parts of the photoresponsive material 1-1 and 76 parts of the polymerizable compound.

### (Exemplary Embodiment 1-52)

A photoresponsive composition 1-23 was produced in the same manner as in Exemplary Embodiment 1-30 except that the photoresponsive material 1-23 was used instead of the photoresponsive material 1-1.

### (Exemplary Embodiment 1-53)

A photoresponsive composition 1-24 was produced in the same manner as in Exemplary Embodiment 1-30 except that 11.9 parts of the photoresponsive material 1-24 and 84 parts of the polymerizable compound were used instead of 20 parts of the photoresponsive material 1-1 and 76 parts of the polymerizable compound.

### (Exemplary Embodiment 1-54)

A photoresponsive composition 1-25 was produced in the same manner as in Exemplary Embodiment 1-30 except that 13 parts of the photoresponsive material 1-25 and 83 parts of the polymerizable compound were used instead of 20 parts of the photoresponsive material 1-1 and 76 parts of the polymerizable compound.

### (Exemplary Embodiment 1-55)

A photoresponsive composition 1-26 was produced in the same manner as in Exemplary Embodiment 1-30 except that 40 parts of the photoresponsive material 1-26 and 56 parts of the polymerizable compound were used instead of 20 parts of the photoresponsive material 1-1 and 76 parts of the polymerizable compound.

### (Exemplary Embodiments 1-56 and 1-57)

Photoresponsive compositions 1-27 and 1-28 were produced in the same manner as in Exemplary Embodiment 1-30 except that the photoresponsive materials 1-27 and 1-28 were used instead of the photoresponsive material 1-1.

### (Exemplary Embodiment 1-58)

A photoresponsive composition 1-29 was produced in the same manner as in Exemplary Embodiment 1-30 except that 24 parts of the photoresponsive material 1-29 and 72 parts of the polymerizable compound were used instead of 20 parts of the photoresponsive material 1-1 and 76 parts of the polymerizable compound.

### (Comparative Example 1-13)

A photoresponsive composition 1-30 was produced in the same manner as in Exemplary Embodiment 1-30 except that 10 parts of the photoresponsive material 1-30 and 86 parts of the polymerizable compound were used instead of 20 parts of the photoresponsive material 1-1 and 76 parts of the polymerizable compound.

### (Comparative Example 1-14)

A photoresponsive composition 1-31 was produced in the same manner as in Exemplary Embodiment 1-30 except that the photoresponsive material 1-31 was used instead of the photoresponsive material 1-1.

### (Comparative Example 1-15)

A photoresponsive composition 1-32 was produced in the same manner as in Exemplary Embodiment 1-30 except that 12 parts of the photoresponsive material 1-32 and 84 parts of the polymerizable compound were used instead of 20 parts of the photoresponsive material 1-1 and 76 parts of the polymerizable compound.

### (Comparative Example 1-16)

A photoresponsive composition 1-33 was produced in the same manner as in Exemplary Embodiment 1-30 except that 10 parts of the photoresponsive material 1-33 and 86 parts of the polymerizable compound were used instead of 20 parts of the photoresponsive material 1-1 and 76 parts of the polymerizable compound.

### (Comparative Example 1-17)

A photoresponsive composition 1-34 was produced in the same manner as in Exemplary Embodiment 1-30 except that the photoresponsive material 1-34 was used instead of the photoresponsive material 1-1.

### (Comparative Example 1-18)

A photoresponsive composition 1-35 was produced in the same manner as in Exemplary Embodiment 1-30 except that 12 parts of the photoresponsive material 1-35 and 84 parts of the polymerizable compound were used instead of 20 parts of the photoresponsive material 1-1 and 76 parts of the polymerizable compound.

### (Comparative Example 1-19)

A photoresponsive composition 1-36 was produced in the same manner as in Exemplary Embodiment 1-30 except that 10 parts of the photoresponsive material 1-36 and 86 parts of the polymerizable compound were used instead of 20 parts of the photoresponsive material 1-1 and 76 parts of the polymerizable compound.

### (Comparative Example 1-20)

A photoresponsive composition 1-37 was produced in the same manner as in Exemplary Embodiment 1-30 except that the photoresponsive material 1-37 was used instead of the photoresponsive material 1-1.

### (Comparative Example 1-21)

A photoresponsive composition 1-38 was produced in the same manner as in Exemplary Embodiment 1-30 except that 12 parts of the photoresponsive material 1-38 and 84 parts of the polymerizable compound were used instead of 20 parts of the photoresponsive material 1-1 and 76 parts of the polymerizable compound.

### (Comparative Example 1-22)

A photoresponsive composition 1-39 was produced in the same manner as in Exemplary Embodiment 1-30 except that 10 parts of the photoresponsive material 1-39 and 86 parts of the polymerizable compound were used instead of 20 parts of the photoresponsive material 1-1 and 76 parts of the polymerizable compound.

### (Comparative Example 1-23)

A photoresponsive composition 1-40 was produced in the same manner as in Exemplary Embodiment 1-30 except that the photoresponsive material 1-40 was used instead of the photoresponsive material 1-1.

### (Comparative Example 1-24)

A photoresponsive composition 1-41 was produced in the same manner as in Exemplary Embodiment 1-30 except that 12 parts of the photoresponsive material 1-41 and 84 parts of the polymerizable compound were used instead of 20 parts of the photoresponsive material 1-1 and 76 parts of the polymerizable compound.

For the photoresponsive compositions 1-1 to 1-41, Table 5 shows the type and concentration of the photoresponsive material 1-, the concentration of the polymerizable compound, the concentration of the polymerization initiator, and the concentration of the scattering agent.

### [Table 5]

**Table 5**

| Exemplary Embodiment No. | Photoresponsive composition | Photoresponsive material | | Polymerizable compound | Polymerization initiator | Scattering agent |
|---|---|---|---|---|---|---|
| | | Type | Parts | Parts | Parts | Parts |
| Exemplary Embodiment 1-30 | Photoresponsive composition 1-1 | Photoresponsive material 1-1 | 20 | 76 | 4 | 4 |
| Exemplary Embodiment 1-31 | Photoresponsive composition 1-2 | Photoresponsive material 1-2 | 20 | 76 | 4 | 4 |
| Exemplary Embodiment 1-32 | Photoresponsive composition 1-3 | Photoresponsive material 1-3 | 20 | 76 | 4 | 4 |
| Exemplary Embodiment 1-33 | Photoresponsive composition 1-4 | Photoresponsive material 1-4 | 20 | 76 | 4 | 4 |
| Exemplary Embodiment 1-34 | Photoresponsive composition 1-5 | Photoresponsive material 1-5 | 20 | 76 | 4 | 4 |
| Exemplary Embodiment 1-35 | Photoresponsive composition 1-6 | Photoresponsive material 1-6 | 20 | 76 | 4 | 4 |
| Exemplary Embodiment 1-36 | Photoresponsive composition 1-7 | Photoresponsive material 1-7 | 20 | 76 | 4 | 4 |
| Exemplary Embodiment 1-37 | Photoresponsive composition 1-8 | Photoresponsive material 1-8 | 20 | 76 | 4 | 4 |
| Exemplary Embodiment 1-38 | Photoresponsive composition 1-9 | Photoresponsive material 1-9 | 20 | 76 | 4 | 4 |
| Exemplary Embodiment 1-39 | Photoresponsive composition 1-10 | Photoresponsive material 1-10 | 20 | 76 | 4 | 4 |
| Exemplary Embodiment 1-40 | Photoresponsive composition 1-11 | Photoresponsive material 1-11 | 18 | 78 | 4 | 4 |
| Exemplary Embodiment 1-41 | Photoresponsive composition 1-12 | Photoresponsive material 1-12 | 18 | 78 | 4 | 4 |
| Exemplary Embodiment 1-42 | Photoresponsive composition 1-13 | Photoresponsive material 1-13 | 18 | 78 | 4 | 4 |
| Exemplary Embodiment 1-43 | Photoresponsive composition 1-14 | Photoresponsive material 1-14 | 18 | 78 | 4 | 4 |
| Exemplary Embodiment 1-44 | Photoresponsive composition 1-15 | Photoresponsive material 1-15 | 18 | 78 | 4 | 4 |
| Exemplary Embodiment 1-45 | Photoresponsive composition 1-16 | Photoresponsive material 1-16 | 18 | 78 | 4 | 4 |
| Exemplary Embodiment 1-46 | Photoresponsive composition 1-17 | Photoresponsive material 1-17 | 15 | 81 | 4 | 4 |
| Exemplary Embodiment 1-47 | Photoresponsive composition 1-18 | Photoresponsive material 1-18 | 15 | 81 | 4 | 4 |
| Exemplary Embodiment 1-48 | Photoresponsive composition 1-19 | Photoresponsive material 1-19 | 15 | 81 | 4 | 4 |
| Exemplary Embodiment 1-49 | Photoresponsive composition 1-20 | Photoresponsive material 1-20 | 11.4 | 85 | 4 | 4 |
| Exemplary Embodiment 1-50 | Photoresponsive composition 1-21 | Photoresponsive material 1-21 | 10.20 | 86 | 4 | 4 |
| Exemplary Embodiment 1-51 | Photoresponsive composition 1-22 | Photoresponsive material 1-22 | 10.15 | 86 | 4 | 4 |
| Exemplary Embodiment 1-52 | Photoresponsive composition 1-23 | Photoresponsive material 1-23 | 20 | 76 | 4 | 4 |
| Exemplary Embodiment 1-53 | Photoresponsive composition 1-24 | Photoresponsive material 1-24 | 11.9 | 84 | 4 | 4 |
| Exemplary Embodiment 1-54 | Photoresponsive composition 1-25 | Photoresponsive material 1-25 | 13 | 83 | 4 | 4 |
| Exemplary Embodiment 1-55 | Photoresponsive composition 1-26 | Photoresponsive material 1-26 | 40 | 56 | 4 | 4 |
| Exemplary Embodiment 1-56 | Photoresponsive composition 1-27 | Photoresponsive material 1-27 | 20 | 76 | 4 | 4 |
| Exemplary Embodiment 1-57 | Photoresponsive composition 1-28 | Photoresponsive material 1-28 | 20 | 76 | 4 | 4 |
| Exemplary Embodiment 1-58 | Photoresponsive composition 1-29 | Photoresponsive material 1-29 | 24 | 72 | 4 | 4 |
| Comparative Example 1-13 | Photoresponsive composition 1-30 | Photoresponsive material 1-30 | 10 | 86 | 4 | 4 |
| Comparative Example 1-14 | Photoresponsive composition 1-31 | Photoresponsive material 1-31 | 20 | 76 | 4 | 4 |
| Comparative Example 1-15 | Photoresponsive composition 1-32 | Photoresponsive material 1-32 | 12 | 84 | 4 | 4 |
| Comparative Example 1-16 | Photoresponsive composition 1-33 | Photoresponsive material 1-33 | 10 | 86 | 4 | 4 |
| Comparative Example 1-17 | Photoresponsive composition 1-34 | Photoresponsive material 1-34 | 20 | 76 | 4 | 4 |
| Comparative Example 1-18 | Photoresponsive composition 1-35 | Photoresponsive material 1-35 | 12 | 84 | 4 | 4 |
| Comparative Example 1-19 | Photoresponsive composition 1-36 | Photoresponsive material 1-36 | 10 | 86 | 4 | 4 |
| Comparative Example 1-20 | Photoresponsive composition 1-37 | Photoresponsive material 1-37 | 20 | 76 | 4 | 4 |
| Comparative Example 1-21 | Photoresponsive composition 1-38 | Photoresponsive material 1-38 | 12 | 84 | 4 | 4 |
| Comparative Example 1-22 | Photoresponsive composition 1-39 | Photoresponsive material 1-39 | 10 | 86 | 4 | 4 |
| Comparative Example 1-23 | Photoresponsive composition 1-40 | Photoresponsive material 1-40 | 20 | 76 | 4 | 4 |
| Comparative Example 1-24 | Photoresponsive composition 1-41 | Photoresponsive material 1-41 | 12 | 84 | 4 | 4 |

### <Production of Wavelength Conversion Member 1->

The photoresponsive composition 1- was spin-coated on a glass substrate (10 cm × 10 cm). The glass substrate on which the spin-coated photoresponsive composition had been formed was irradiated with ultraviolet light using a belt conveyor type ultraviolet irradiator (a high-pressure mercury lamp 120 W/cm2 lamp) at an integrated light quantity of 400 mJ/cm², thereby forming a cured film with a thickness of 10 um on the glass substrate. A barrier film was then stacked on the surface of the cured film. Thus, wavelength conversion members 1-1 to 1-41 were produced.

### <Evaluation of Wavelength Conversion Member 1->

The wavelength conversion member 1- was subjected to the following evaluation. Tables 6 and 7 show the results.

### [Evaluation of Light Resistance]

Each wavelength conversion member 1- was irradiated with blue light with a wavelength of 460 nm at an intensity of 12,500 cd/cm² for 16 hours. The emission peak wavelength, the full width at half maximum, and the absolute photoluminescence quantum yield (hereinafter referred to as PLQY) were then measured.

The measurement conditions are the same as in the evaluation of polar solvent resistance. The evaluation criteria are described below.

### <Evaluation Criteria>

Initial PLQY was defined as 100, and PLQY after irradiation with blue light for 16 hours was defined as P-2. The evaluation was based on the following criteria.
AA: P-2 is 100 or more
A: P-2 is 80 or more and less than 100
B: P-2 is 70 or more and less than 80
C: P-2 is 60 or more and less than 70
D: P-2 is less than 60

### [Table 6]

**Table 6**

| Exemplary Embodiment No. | Wavelength conversion member | Photoresponsive composition | Peak wavelength/nm | | Full width at half maximum/nm | | PLQY | | P-2 | Rating |
|---|---|---|---|---|---|---|---|---|---|---|
| | | | Immediately after production | 16 hours after B light irradiation | Immediately after production | 16 hours after B light irradiation | Immediately after production | 16 hours after B light irradiation | | |
| Exemplary Embodiment 1-30 | Wavelength conversion member 1-1 | Photoresponsive composition 1-1 | 517 | 518 | 21 | 21 | 69% | 83% | 120 | AA |
| Exemplary Embodiment 1-31 | Wavelength conversion member 1-2 | Photoresponsive composition 1-2 | 517 | 517 | 21 | 21 | 70% | 82% | 117 | AA |
| Exemplary Embodiment 1-32 | Wavelength conversion member 1-3 | Photoresponsive composition 1-3 | 516 | 516 | 21 | 21 | 68% | 82% | 121 | AA |
| Exemplary Embodiment 1-33 | Wavelength conversion member 1-4 | Photoresponsive composition 1-4 | 517 | 516 | 21 | 21 | 71% | 83% | 117 | AA |
| Exemplary Embodiment 1-34 | Wavelength conversion member 1-5 | Photoresponsive composition 1-5 | 518 | 517 | 21 | 21 | 69% | 84% | 122 | AA |
| Exemplary Embodiment 1-35 | Wavelength conversion member 1-6 | Photoresponsive composition 1-6 | 517 | 518 | 21 | 21 | 74% | 88% | 119 | AA |
| Exemplary Embodiment 1-36 | Wavelength conversion member 1-7 | Photoresponsive composition 1-7 | 517 | 518 | 21 | 21 | 81% | 90% | 112 | AA |
| Exemplary Embodiment 1-37 | Wavelength conversion member 1-8 | Photoresponsive composition 1-8 | 516 | 518 | 21 | 22 | 71% | 89% | 126 | AA |
| Exemplary Embodiment 1-38 | Wavelength conversion member 1-9 | Photoresponsive composition 1-9 | 518 | 516 | 21 | 21 | 82% | 91% | 111 | AA |
| Exemplary Embodiment 1-39 | Wavelength conversion member 1-10 | Photoresponsive composition 1-10 | 518 | 518 | 21 | 20 | 70% | 88% | 126 | AA |
| Exemplary Embodiment 1-40 | Wavelength conversion member 1-11 | Photoresponsive composition 1-11 | 650 | 646 | 32 | 32 | 80% | 69% | 86 | A |
| Exemplary Embodiment 1-41 | Wavelength conversion member 1-12 | Photoresponsive composition 1-12 | 652 | 648 | 28 | 28 | 82% | 76% | 93 | A |
| Exemplary Embodiment 1-42 | Wavelength conversion member 1-13 | Photoresponsive composition 1-13 | 651 | 642 | 34 | 38 | 75% | 46% | 61 | C |
| Exemplary Embodiment 1-43 | Wavelength conversion member 1-14 | Photoresponsive composition 1-14 | 688 | 691 | 35 | 36 | 70% | 68% | 98 | A |
| Exemplary Embodiment 1-44 | Wavelength conversion member 1-15 | Photoresponsive composition 1-15 | 690 | 689 | 35 | 37 | 66% | 54% | 82 | A |
| Exemplary Embodiment 1-45 | Wavelength conversion member 1-16 | Photoresponsive composition 1-16 | 691 | 693 | 40 | 38 | 51% | 54% | 106 | AA |
| Exemplary Embodiment 1-46 | Wavelength conversion member 1-17 | Photoresponsive composition 1-17 | 530 | 532 | 22 | 22 | 96% | 96% | 100 | AA |
| Exemplary Embodiment 1-47 | Wavelength conversion member 1-18 | Photoresponsive composition 1-18 | 534 | 533 | 21 | 21 | 91% | 93% | 102 | AA |
| Exemplary Embodiment 1-48 | Wavelength conversion member 1-19 | Photoresponsive composition 1-19 | 530 | 530 | 23 | 23 | 86% | 90% | 104 | AA |
| Exemplary Embodiment 1-49 | Wavelength conversion member 1-20 | Photoresponsive composition 1-20 | 515 | 516 | 23 | 23 | 75% | 90% | 119 | AA |
| Exemplary Embodiment 1-50 | Wavelength conversion member 1-21 | Photoresponsive composition 1-21 | 519 | 519 | 20 | 21 | 56% | 67% | 120 | AA |
| Exemplary Embodiment 1-51 | Wavelength conversion member 1-22 | Photoresponsive composition 1-22 | 518 | 518 | 20 | 21 | 63% | 39% | 62 | C |
| Exemplary Embodiment 1-52 | Wavelength conversion member 1-23 | Photoresponsive composition 1-23 | 517 | 515 | 21 | 21 | 68% | 41% | 60 | C |
| Exemplary Embodiment 1-53 | Wavelength conversion member 1-24 | Photoresponsive composition 1-24 | 520 | 520 | 21 | 21 | 62% | 83% | 135 | AA |
| Exemplary Embodiment 1-54 | Wavelength conversion member 1-25 | Photoresponsive composition 1-25 | 518 | 519 | 20 | 21 | 63% | 76% | 120 | AA |
| Exemplary Embodiment 1-55 | Wavelength conversion member 1-26 | Photoresponsive composition 1-26 | 516 | 515 | 22 | 21 | 65% | 40% | 62 | C |
| Exemplary Embodiment 1-56 | Wavelength conversion member 1-27 | Photoresponsive composition 1-27 | 514 | 515 | 26 | 22 | 73% | 72% | 100 | AA |
| Exemplary Embodiment 1-57 | Wavelength conversion member 1-28 | Photoresponsive composition 1-28 | 513 | 514 | 25 | 22 | 71% | 78% | 110 | AA |
| Exemplary Embodiment 1-58 | Wavelength conversion member 1-29 | Photoresponsive composition 1-29 | 514 | 515 | 24 | 22 | 67% | 73% | 108 | AA |
| Comparative Example 1-13 | Wavelength conversion member 1-30 | Photoresponsive composition 1-30 | 517 | 516 | 23 | 24 | 57% | 23% | 41 | D |
| Comparative Example 1-14 | Wavelength conversion member 1-31 | Photoresponsive composition 1-31 | 517 | 518 | 24 | 23 | 67% | 16% | 24 | D |
| Comparative Example 1-15 | Wavelength conversion member 1-32 | Photoresponsive composition 1-32 | 518 | 517 | 22 | 22 | 66% | 24% | 37 | D |
| Comparative Example 1-16 | Wavelength conversion member 1-33 | Photoresponsive composition 1-33 | 688 | 696 | 43 | 48 | 62% | 35% | 57 | D |
| Comparative Example 1-17 | Wavelength conversion member 1-34 | Photoresponsive composition 1-34 | 654 | 647 | 44 | 41 | 70% | 36% | 52 | D |
| Comparative Example 1-18 | Wavelength conversion member 1-35 | Photoresponsive composition 1-35 | 651 | 638 | 50 | 46 | 61% | 21% | 34 | D |
| Comparative Example 1-19 | Wavelength conversion member 1-36 | Photoresponsive composition 1-36 | 688 | 696 | 43 | 48 | 65% | 39% | 59 | D |
| Comparative Example 1-20 | Wavelength conversion member 1-37 | Photoresponsive composition 1-37 | 686 | 691 | 45 | 49 | 67% | 39% | 59 | D |
| Comparative Example 1-21 | Wavelength conversion member 1-38 | Photoresponsive composition 1-38 | 684 | 694 | 45 | 53 | 54% | 26% | 48 | D |
| Comparative Example 1-22 | Wavelength conversion member 1-39 | Photoresponsive composition 1-39 | 536 | 532 | 21 | 24 | 89% | 17% | 19 | D |
| Comparative Example 1-23 | Wavelength conversion member 1-40 | Photoresponsive composition 1-40 | 535 | 533 | 22 | 24 | 91% | 27% | 30 | D |
| Comparative Example 1-24 | Wavelength conversion member 1-41 | Photoresponsive composition 1-41 | 536 | 533 | 21 | 23 | 88% | 47% | 54 | D |

### [Evaluation of Heat Resistance]

Each wavelength conversion member 1- was heated in an oven at 80°C for 16 hours. The emission peak wavelength, the full width at half maximum, and the absolute photoluminescence quantum yield (hereinafter referred to as PLQY) were then measured.

The measurement conditions are the same as in the evaluation of polar solvent resistance. The evaluation criteria are described below.

### <Evaluation Criteria>

Initial PLQY was defined as 100, and PLQY after heating at 80°C for 16 hours was defined as P-3. The evaluation was based on the following criteria.
AA: P-3 is 100 or more
A: P-3 is 80 or more and less than 100
B: P-3 is 70 or more and less than 80
C: P-3 is 60 or more and less than 70
D: P-3 is less than 60

### [Table 7]

**Table 7**

| Exemplary Embodiment No. | Wavelength conversion member | Photoresponsive composition | Peak wavelength/nm | | Full width at half maximum/nm | | PLQY | | P-3 | Rating |
|---|---|---|---|---|---|---|---|---|---|---|
| | | | Immediately after production | 16 hours after heating at 80°C | Immediately after production | 16 hours after heating at 80°C | Immediately after production | 16 hours after heating at 80°C | | |
| Exemplary Embodiment 1-30 | Wavelength conversion member 1 | Photoresponsive composition 1-1 | 517 | 518 | 21 | 20 | 69% | 62% | 89 | A |
| Exemplary Embodiment 1-31 | Wavelength conversion member 2 | Photoresponsive composition 1-2 | 517 | 517 | 21 | 20 | 70% | 63% | 90 | A |
| Exemplary Embodiment 1-32 | Wavelength conversion member 3 | Photoresponsive composition 1-3 | 516 | 517 | 21 | 20 | 68% | 62% | 91 | A |
| Exemplary Embodiment 1-33 | Wavelength conversion member 4 | Photoresponsive composition 1-4 | 517 | 516 | 21 | 20 | 71% | 65% | 92 | A |
| Exemplary Embodiment 1-34 | Wavelength conversion member 5 | Photoresponsive composition 1-5 | 518 | 517 | 21 | 20 | 69% | 63% | 91 | A |
| Exemplary Embodiment 1-35 | Wavelength conversion member 6 | Photoresponsive composition 1-6 | 517 | 520 | 21 | 21 | 74% | 74% | 101 | AA |
| Exemplary Embodiment 1-36 | Wavelength conversion member 7 | Photoresponsive composition 1-7 | 517 | 519 | 21 | 21 | 81% | 79% | 97 | A |
| Exemplary Embodiment 1-37 | Wavelength conversion member 8 | Photoresponsive composition 1-8 | 516 | 518 | 21 | 21 | 71% | 81% | 113 | AA |
| Exemplary Embodiment 1-38 | Wavelength conversion member 9 | Photoresponsive composition 1-9 | 518 | 518 | 21 | 20 | 82% | 85% | 104 | AA |
| Exemplary Embodiment 1-39 | Wavelength conversion member 10 | Photoresponsive composition 1-10 | 518 | 517 | 21 | 22 | 70% | 65% | 93 | A |
| Exemplary Embodiment 1-40 | Wavelength conversion member 11 | Photoresponsive composition 1-11 | 650 | 644 | 32 | 31 | 80% | 72% | 90 | A |
| Exemplary Embodiment 1-41 | Wavelength conversion member 12 | Photoresponsive composition 1-12 | 652 | 645 | 28 | 28 | 82% | 75% | 91 | A |
| Exemplary Embodiment 1-42 | Wavelength conversion member 13 | Photoresponsive composition 1-13 | 651 | 625 | 34 | 30 | 75% | 50% | 67 | C |
| Exemplary Embodiment 1-43 | Wavelength conversion member 14 | Photoresponsive composition 1-14 | 688 | 688 | 35 | 35 | 70% | 64% | 92 | A |
| Exemplary Embodiment 1-44 | Wavelength conversion member 15 | Photoresponsive composition 1-15 | 690 | 689 | 35 | 36 | 66% | 61% | 93 | A |
| Exemplary Embodiment 1-45 | Wavelength conversion member 16 | Photoresponsive composition 1-16 | 691 | 688 | 40 | 38 | 51% | 49% | 96 | A |
| Exemplary Embodiment 1-46 | Wavelength conversion member 17 | Photoresponsive composition 1-17 | 530 | 531 | 22 | 22 | 96% | 87% | 91 | A |
| Exemplary Embodiment 1-47 | Wavelength conversion member 18 | Photoresponsive composition 1-18 | 534 | 533 | 21 | 21 | 91% | 82% | 90 | A |
| Exemplary Embodiment 1-48 | Wavelength conversion member 19 | Photoresponsive composition 1-19 | 530 | 530 | 23 | 22 | 86% | 74% | 86 | A |
| Exemplary Embodiment 1-49 | Wavelength conversion member 20 | Photoresponsive composition 1-20 | 515 | 515 | 23 | 22 | 75% | 76% | 101 | A |
| Exemplary Embodiment 1-50 | Wavelength conversion member 21 | Photoresponsive composition 1-21 | 519 | 518 | 20 | 21 | 56% | 52% | 93 | B |
| Exemplary Embodiment 1-51 | Wavelength conversion member 22 | Photoresponsive composition 1-22 | 518 | 517 | 20 | 20 | 63% | 46% | 73 | B |
| Exemplary Embodiment 1-52 | Wavelength conversion member 23 | Photoresponsive composition 1-23 | 517 | 517 | 21 | 20 | 68% | 47% | 69 | C |
| Exemplary Embodiment 1-53 | Wavelength conversion member 24 | Photoresponsive composition 1-24 | 520 | 519 | 21 | 21 | 62% | 58% | 94 | A |
| Exemplary Embodiment 1-54 | Wavelength conversion member 25 | Photoresponsive composition 1-25 | 518 | 518 | 20 | 21 | 63% | 54% | 86 | A |
| Exemplary Embodiment 1-55 | Wavelength conversion member 26 | Photoresponsive composition 1-26 | 516 | 517 | 22 | 22 | 65% | 51% | 78 | B |
| Exemplary Embodiment 1-56 | Wavelength conversion member 27 | Photoresponsive composition 1-27 | 514 | 514 | 26 | 25 | 73% | 71% | 98 | A |
| Exemplary Embodiment 1-57 | Wavelength conversion member 28 | Photoresponsive composition 1-28 | 513 | 515 | 25 | 22 | 71% | 76% | 107 | AA |
| Exemplary Embodiment 1-58 | Wavelength conversion member 29 | Photoresponsive composition 1-29 | 514 | 514 | 24 | 23 | 67% | 70% | 104 | AA |
| Comparative Example 1-13 | Wavelength conversion member 30 | Photoresponsive composition 1-30 | 517 | 524 | 23 | 23 | 57% | 17% | 29 | D |
| Comparative Example 1-14 | Wavelength conversion member 31 | Photoresponsive composition 1-31 | 517 | 522 | 24 | 20 | 67% | 37% | 55 | D |
| Comparative Example 1-15 | Wavelength conversion member 32 | Photoresponsive composition 1-32 | 518 | 518 | 22 | 27 | 66% | 14% | 21 | D |
| Comparative Example 1-16 | Wavelength conversion member 33 | Photoresponsive composition 1-33 | 688 | 637 | 43 | 31 | 62% | 1% | 2 | D |
| Comparative Example 1-17 | Wavelength conversion member 34 | Photoresponsive composition 1-34 | 654 | 648 | 44 | 43 | 70% | 3% | 5 | D |
| Comparative Example 1-18 | Wavelength conversion member 35 | Photoresponsive composition 1-35 | 651 | 639 | 50 | 41 | 61% | 3% | 4 | D |
| Comparative Example 1-19 | Wavelength conversion member 36 | Photoresponsive composition 1-36 | 688 | 690 | 43 | 48 | 65% | 4% | 6 | D |
| Comparative Example 1-20 | Wavelength conversion member 37 | Photoresponsive composition 1-37 | 686 | 699 | 45 | 48 | 67% | 9% | 13 | D |
| Comparative Example 1-21 | Wavelength conversion member 38 | Photoresponsive composition 1-38 | 684 | 695 | 45 | 52 | 54% | 5% | 9 | D |
| Comparative Example 1-22 | Wavelength conversion member 39 | Photoresponsive composition 1-39 | 536 | 539 | 21 | 24 | 89% | 38% | 43 | D |
| Comparative Example 1-23 | Wavelength conversion member 40 | Photoresponsive composition 1-40 | 535 | 539 | 22 | 25 | 91% | 52% | 57 | D |
| Comparative Example 1-24 | Wavelength conversion member 41 | Photoresponsive composition 1-41 | 536 | 536 | 21 | 25 | 88% | 48% | 54 | D |

Tables 6 and 7 show that the photoresponsive materials 1-30 to 1-58 according to Exemplary Embodiments 1-30 to 1-58 have a high PLQY and a narrow full width at half maximum immediately after the production and can maintain them even when stimulated for extended periods by very strong blue light or heat. Furthermore, this effect does not depend on the compositions of the A site and the X site in the light-emitting nanocrystal and is effective for light-emitting nanocrystals with a wide range of compositions. It is presumed that these effects are due to the ensured stability of the nanoparticle 10 protected by the specific shell-like ligand 20 in the photoresponsive compositions 1-1 to 1-29 according to Exemplary Embodiments 1-30 to 1-58.

By contrast, the photoresponsive material 1- without the shell-like ligand 20 as in Comparative Examples 1-13, 1-16, 1-19, and 1-22 had a wide full width at half maximum or a low PLQY immediately after the production in some cases and was deactivated by blue light irradiation. Furthermore, as in Comparative Examples 1-14, 1-17, 1-20, and 1-23, the photoresponsive material 1 having the shell-like ligand without the betaine structure had a wide full width at half maximum in some cases and was deactivated by blue light irradiation. When the ligand with the betaine structure was used as in Comparative Examples 1-15, 1-18, 1-21, and 1-24, the full width at half maximum was wide in some cases, and blue light irradiation caused deactivation.

Although the present disclosure is described in more detail below with reference to a second exemplary embodiment group, the present disclosure is not limited thereto.

### [Production of Polymer 2-a]

A reaction vessel equipped with a cooling tube, a stirrer, a thermometer, and a nitrogen inlet tube was charged with 15.8 parts of [2-(methacryloyloxy)ethyl]trimethylammonium chloride (80% aqueous solution), 82.1 parts of octadecyl methacrylate, 4.1 parts of azobisisobutyronitrile, and 900 parts of n-butanol, and nitrogen bubbling was performed for 30 minutes. The resulting reaction mixture was heated at 65°C for 8 hours in a nitrogen atmosphere to complete the polymerization reaction. The reaction liquid was cooled to room temperature, and the solvent was evaporated under reduced pressure. The resulting residue was dissolved in chloroform and was purified by dialysis using a dialysis membrane (Spectra/Por7 MWCO IkDa manufactured by Spectrum Laboratories). The solvent was evaporated under reduced pressure, and a polymer 2-a was produced by drying at 50°C under a reduced pressure of 0.1 kPa or less.

The polymer 2-a was analyzed by the analysis method described above and was found to have a weight-average molecular weight (Mw) of 21,000, and the monomer with the partial structure represented by the formula (1) constituted 21% by mole of the total monomer units.

### [Production of Polymer 2-b]

A solution of 1.3 parts of sodium bromide dissolved in 2.7 parts of water was slowly added to a solution of 5 parts of the polymer 2-a dissolved in 95 parts of tetrahydrofuran, and the mixture was stirred at room temperature for 2 hours. The resulting liquid was subjected to reprecipitation treatment with water, was washed with methanol, and was then dried under vacuum at 50°C for 2 hours to produce a polymer 2-b.

### [Production of Polymer 2-c]

A polymer 2-c was produced in the same manner as the polymer 2-b except that a solution of 1.9 parts of sodium iodide dissolved in 2.0 parts of water was used instead of the solution of 1.3 parts of sodium bromide dissolved in 2.7 parts of water.

### [Production of Polymer 2-d]

A polymer 2-d was produced in the same manner as the polymer 2-b except that a solution of 0.39 parts of sodium bromide and 1.3 parts of sodium iodide dissolved in 2.7 parts of water was used instead of the solution of 1.3 parts of sodium bromide dissolved in 2.7 parts of water.

### [Production of Polymer 2-e]

A solution of 1.9 parts of sodium iodide dissolved in 2.0 parts of water was slowly added to a solution of 5 parts of the polymer 2-, which was produced in the same manner as the polymer 2-a except that 29.3 parts of [2-(methacryloyloxy)ethyl]trimethylammonium chloride (80% aqueous solution) and 63.4 parts of octadecyl methacrylate were used instead of 15.8 parts of [2-(methacryloyloxy)ethyl]trimethylammonium chloride (80% aqueous solution) and 82.1 parts of octadecyl methacrylate, dissolved in 95 parts of tetrahydrofuran, and the mixture was stirred at room temperature for 2 hours. The resulting liquid was subjected to reprecipitation treatment with water, was washed with methanol, and was then dried under vacuum at 50°C for 2 hours to produce a polymer 2-e.

### [Production of Polymer 2-f]

A polymer 2-af was produced in the same manner as the polymer 2-a except that 48.1 parts of octyl methacrylate was used instead of 82.1 parts of octadecyl methacrylate. A solution of 1.9 parts of sodium iodide dissolved in 2.0 parts of water was slowly added to a solution of 5 parts of the polymer 2-af dissolved in 95 parts of tetrahydrofuran, and the mixture was stirred at room temperature for 2 hours. The resulting liquid was subjected to reprecipitation treatment with water, was washed with methanol, and was then dried under vacuum at 50°C for 2 hours to produce a polymer 2-f.

### [Production of Polymer 2-g]

A polymer 2-ag was produced in the same manner as the polymer 2-a except that 41.3 parts of hexyl methacrylate was used instead of 82.1 parts of octadecyl methacrylate. A solution of 1.9 parts of sodium iodide dissolved in 2.0 parts of water was slowly added to a solution of 5 parts of the polymer 2-ag dissolved in 95 parts of tetrahydrofuran, and the mixture was stirred at room temperature for 2 hours. The resulting liquid was subjected to reprecipitation treatment with water, was washed with methanol, and was then dried under vacuum at 50°C for 2 hours to produce a polymer 2-g.

### [Production of Polymer 2-h]

A polymer 2-ah was produced in the same manner as the polymer 2-a except that 34.5 parts of butyl methacrylate was used instead of 82.1 parts of octadecyl methacrylate. A solution of 1.9 parts of sodium iodide dissolved in 2.0 parts of water was slowly added to a solution of 5 parts of the polymer 2-ah dissolved in 95 parts of tetrahydrofuran, and the mixture was stirred at room temperature for 2 hours. The resulting liquid was subjected to reprecipitation treatment with water, was washed with methanol, and was then dried under vacuum at 50°C for 2 hours to produce a polymer 2-h.

### [Production of Comparative Polymer 2-i]

A polymer 2-i for leather was produced in the same manner as the polymer 2-a except that 108 parts of octadecyl methacrylate was used instead of 15.8 parts of [2-(methacryloyloxy)ethyl]trimethylammonium chloride (80% aqueous solution) and 82.1 parts of octadecyl methacrylate.

Table 8 shows the composition ratio and the weight-average molecular weight (Mw) of each of the polymers 2-a to 2-i produced as described above. In Table 8, "a" denotes a binding site for a carbon atom to which R₄ in the formula (2) is bound, "b" denotes a binding site for the quaternary ammonium moiety, and "c" denotes a binding site for a carbon atom to which R₅ in the formula (3) is bound.

### [Table 8]

**Table 8**

| Polymer No. | Structure of polymer | | | | | | | | Composition ratio (mole ratio) [formula (5):formula (6)] | Mw |
|---|---|---|---|---|---|---|---|---|---|---|
| | Formula (5) structure | | | | | | Formula (6) structure | | | |
| | R₉ | R₁₀ | R₁₁ | R₁₂ | A₇ | X | R₁₆ | R₁₇ | | |
| Polymer 2-a | CH₃ | CH₃ | CH₃ | CH₃ | 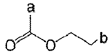 | Cl | CH₃ | 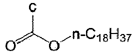 | 21:79 | 21,000 |
| Polymer 2-b | CH₃ | CH₃ | CH₃ | CH₃ | 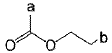 | Br | CH₃ | 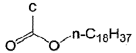 | 21:79 | 21,300 |
| Polymer 2-c | CH₃ | CH₃ | CH₃ | CH₃ | 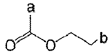 | I | CH₃ | 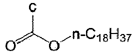 | 21:79 | 21,500 |
| Polymer 2-d | CH₃ | CH₃ | CH₃ | CH₃ | 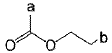 | Br_{0.3}I_{0.7} | CH₃ | 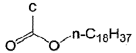 | 21:79 | 21,400 |
| Polymer 2-e | CH₃ | CH₃ | CH₃ | CH₃ | 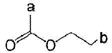 | I | CH₃ | 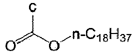 | 39:61 | 18,700 |
| Polymer 2-f | CH₃ | CH₃ | CH₃ | CH₃ | 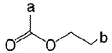 | I | CH₃ | 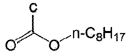 | 20:80 | 20,500 |
| Polymer 2-g | CH₃ | CH₃ | CH₃ | CH₃ | 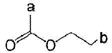 | I | CH₃ | 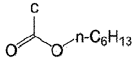 | 22:78 | 19,800 |
| Polymer 2-h | CH₃ | CH₃ | CH₃ | CH₃ | 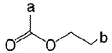 | I | CH₃ | 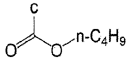 | 20:80 | 19,400 |
| Polymer 2-i | None | | | | | - | CH₃ | 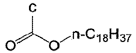 | 0:100 | 11,500 |

### (Exemplary Embodiment 2-1)

### [Preparation of Polymer 2- Solution]

### (Toluene Solution of Polymer 2-a)

A reaction vessel equipped with a stirrer, a thermometer, and a refluxing condenser was charged with 0.5 parts of the polymer 2-a and 99.5 parts of toluene, was heated to 110°C, and was heated at this temperature for 5 minutes. After confirming that the polymer 2-a was completely dissolved, a toluene solution of the polymer 2-a was produced by cooling to room temperature.

### [Production of Nanoparticle Dispersion Liquid 2-a]

10 parts of cesium carbonate, 27 parts of oleic acid, and 385 parts of 1-octadecene were placed in a flask, were heated to 120°C, and were degassed with a vacuum pump for 30 minutes. Furthermore, the liquid was heated to 150°C in a dry nitrogen stream and was held for 30 minutes to produce a cation raw material liquid.

Separately, 10 parts of lead (II) bromide and 494 parts of 1-octadecene were placed in a flask, were heated to 120°C, and were degassed with a vacuum pump for 1 hour. 89 parts of oleic acid and 31 parts of oleylamine were added, and the mixture was degassed with a vacuum pump for 30 minutes. The liquid temperature was then altered to 185°C in a nitrogen flow.

40 parts of the cation raw material liquid was added thereto, and the mixture was cooled with ice after 5 seconds. 2000 parts of ethyl acetate was added thereto, the mixture was centrifuged, and the supernatant was removed. The residue was dispersed in toluene to adjust the solid concentration to 1% by weight. Thus, a nanoparticle dispersion liquid 2-a with a CsPbBr₃ perovskite crystal structure was produced. The peak wavelength was 512 nm.

### [Preparation of Photoresponsive Material 2-1]

A dry nitrogen stream was blown to 10 parts of the nanoparticle dispersion liquid 2-a to remove the solvent. 10 parts of the toluene solution of the polymer 2-a was added thereto, and the mixture was stirred for 3 hours to produce a photoresponsive material 2-1.

### (Exemplary Embodiment 2-2)

A photoresponsive material 2-2 was produced in the same manner as in Exemplary Embodiment 2-1 except that the polymer 2-b was used instead of the polymer 2-a.

### (Exemplary Embodiment 2-3)

A photoresponsive material 2-3 was produced in the same manner as in Exemplary Embodiment 2-1 except that 1 part of the polymer 2-b and 99 parts of toluene were used instead of 0.5 parts of the polymer 2-a and 99.5 parts of toluene.

### (Exemplary Embodiment 2-4)

A photoresponsive material 2-4 was produced in the same manner as in Exemplary Embodiment 2-1 except that 1 part of the polymer 2-c and 99 parts of toluene were used instead of 0.5 parts of the polymer 2-a and 99.5 parts of toluene.

### [Production of Nanoparticle Dispersion Liquid 2-b]

A nanoparticle dispersion liquid 2-b with a CsPb(Br_{0.3}/I_{0.7})₃ perovskite crystal structure was produced in the same manner as the nanoparticle dispersion liquid 2-a except that 3.2 parts of lead (II) bromide and 9.3 parts of lead (II) iodide were used instead of 10 parts of lead (II) bromide. The peak wavelength was 640 nm.

### (Exemplary Embodiment 2-5)

A photoresponsive material 2-5 was produced in the same manner as in Exemplary Embodiment 2-1 except that the nanoparticle 2-b was used instead of the nanoparticle dispersion liquid 2-a.

### (Exemplary Embodiment 2-6)

A photoresponsive material 2-6 was produced in the same manner as in Exemplary Embodiment 2-1 except that the nanoparticle 2-b was used instead of the nanoparticle dispersion liquid 2-a and that the polymer 2-b was used instead of the polymer 2-a.

### (Exemplary Embodiment 2-7)

A photoresponsive material 2-7 was produced in the same manner as in Exemplary Embodiment 2-1 except that the nanoparticle 2-b was used instead of the nanoparticle dispersion liquid 2-a and that the polymer 2-c was used instead of the polymer 2-a.

### (Exemplary Embodiment 2-8)

A photoresponsive material 2-8 was produced in the same manner as in Exemplary Embodiment 2-1 except that the nanoparticle 2-b was used instead of the nanoparticle dispersion liquid 2-a and that 1 part of the polymer 2-c and 99 parts of toluene were used instead of 0.5 parts of the polymer 2-a and 99.5 parts of toluene.

### (Exemplary Embodiment 2-9)

A photoresponsive material 2-9 was produced in the same manner as in Exemplary Embodiment 2-1 except that the nanoparticle 2-b was used instead of the nanoparticle dispersion liquid 2-a and that the polymer 2-d was used instead of the polymer 2-a.

### (Exemplary Embodiment 2-10)

A photoresponsive material 2-10 was produced in the same manner as in Exemplary Embodiment 2-1 except that the nanoparticle 2-b was used instead of the nanoparticle dispersion liquid 2-a and that the polymer 2-e was used instead of the polymer 2-a.

### [Production of Nanoparticle Dispersion Liquid 2-c]

A nanoparticle dispersion liquid 2-c with a CsPbI₃ perovskite crystal structure was produced in the same manner as the nanoparticle dispersion liquid 2-a except that 12.5 parts of lead (II) iodide was used instead of 10 parts of lead (II) bromide. The peak wavelength was 690 nm.

### (Exemplary Embodiment 2-11)

A photoresponsive material 2-11 was produced in the same manner as in Exemplary Embodiment 2-1 except that the nanoparticle 2-c was used instead of the nanoparticle dispersion liquid 2-a.

### (Exemplary Embodiment 2-12)

A photoresponsive material 2-12 was produced in the same manner as in Exemplary Embodiment 2-1 except that the nanoparticle 2-c was used instead of the nanoparticle dispersion liquid 2-a and that the polymer 2-b was used instead of the polymer 2-a.

### (Exemplary Embodiment 2-13)

A photoresponsive material 2-13 was produced in the same manner as in Exemplary Embodiment 2-1 except that the nanoparticle 2-c was used instead of the nanoparticle dispersion liquid 2-a and that the polymer 2-c was used instead of the polymer 2-a.

### (Comparative Example 2-1)

A photoresponsive material 2-14 was produced in the same manner as in Exemplary Embodiment 2-1 except that 100 parts of toluene was used instead of 0.5 parts of the polymer 2-a and 99.5 parts of toluene.

### (Comparative Example 2-2)

A photoresponsive material 2-15 was produced in the same manner as in Exemplary Embodiment 2-1 except that didodecyldimethyl ammonium bromide (manufactured by Tokyo Chemical Industry Co., Ltd.) was used instead of the polymer 2-a.

### (Comparative Example 2-3)

A photoresponsive material 2-16 was produced in the same manner as in Exemplary Embodiment 2-1 except that the nanoparticle 2-c was used instead of the nanoparticle dispersion liquid 2-a and that the polymer 2-i was used instead of the polymer 2-a.

For the photoresponsive materials 2-1 to 2-16, Table 9 shows the type and concentration of the nanoparticle and the type and concentration of the added polymers 2a to 2d and 2-i or ligands.

### [Table 9]

**Table 9**

| Exemplary Embodiment No. | Photoresponsive material | Nanoparticle dispersion liquid | | Added polymer or ligand | |
|---|---|---|---|---|---|
| | | Type | Concentration | Type | Concentration |
| Exemplary Embodiment 2-1 | Photoresponsive material 2-1 | Nanoparticle dispersion liquid 2-a | 1 wt% | Polymer 2-a | 0.5 wt% |
| Exemplary Embodiment 2-2 | Photoresponsive material 2-2 | Nanoparticle dispersion liquid 2-a | 1 wt% | Polymer 2-b | 0.5 wt% |
| Exemplary Embodiment 2-3 | Photoresponsive material 2-3 | Nanoparticle dispersion liquid 2-a | 1 wt% | Polymer 2-b | 1 wt% |
| Exemplary Embodiment 2-4 | Photoresponsive material 2-4 | Nanoparticle dispersion liquid 2-a | 1 wt% | Polymer 2-c | 1 wt% |
| Exemplary Embodiment 2-5 | Photoresponsive material 2-5 | Nanoparticle dispersion liquid 2-b | 1 wt% | Polymer 2-a | 0.5 wt% |
| Exemplary Embodiment 2-6 | Photoresponsive material 2-6 | Nanoparticle dispersion liquid 2-b | 1 wt% | Polymer 2-b | 0.5 wt% |
| Exemplary Embodiment 2-7 | Photoresponsive material 2-7 | Nanoparticle dispersion liquid 2-b | 1 wt% | Polymer 2-c | 0.5 wt% |
| Exemplary Embodiment 2-8 | Photoresponsive material 2-8 | Nanoparticle dispersion liquid 2-b | 1 wt% | Polymer 2-c | 1 wt% |
| Exemplary Embodiment 2-9 | Photoresponsive material 2-9 | Nanoparticle dispersion liquid 2-b | 1 wt% | Polymer 2-d | 0.5 wt% |
| Exemplary Embodiment 2-10 | Photoresponsive material 2-10 | Nanoparticle dispersion liquid 2-b | 1 wt% | Polymer 2-e | 0.5 wt% |
| Exemplary Embodiment 2-11 | Photoresponsive material 2-11 | Nanoparticle dispersion liquid 2-c | 1 wt% | Polymer 2-a | 0.5 wt% |
| Exemplary Embodiment 2-12 | Photoresponsive material 2-12 | Nanoparticle dispersion liquid 2-c | 1 wt% | Polymer 2-b | 0.5 wt% |
| Exemplary Embodiment 2-13 | Photoresponsive material 2-13 | Nanoparticle dispersion liquid 2-c | 1 wt% | Polymer 2-c | 0.5 wt% |
| Comparative Example 2-1 | Photoresponsive material 2-14 | Nanoparticle dispersion liquid 2-b | 1 wt% | - | - |
| Comparative Example 2-2 | Photoresponsive material 2-15 | Nanoparticle dispersion liquid 2-b | 1 wt% | DDAB | 0.5 wt% |
| Comparative Example 2-3 | Photoresponsive material 2-16 | Nanoparticle dispersion liquid 2-b | 1 wt% | Polymer 2-i | 0.5 wt% |

The abbreviation in Table 9 is as follows:
DDAB: didodecyldimethyl ammonium bromide (manufactured by Tokyo Chemical Industry Co., Ltd.)

### <Evaluation of Photoresponsive Materials 2-1 to 2-16>

The photoresponsive materials 2-1 to 2-16 were subjected to the following evaluation. Table 10 shows the results.

### [Evaluation of Emission Properties]

For the photoresponsive materials 2-1 to 2-16, the emission peak wavelength, the half-width, and the absolute photoluminescence quantum yield (hereinafter referred to as PLQY) were measured immediately after the production and 30 minutes after 2-propanol (hereinafter referred to as IPA) was added so as to be 50% by volume. After the addition of IPA, a sample was stored in a darkroom to prevent the promotion of separation of a non-shell-like ligand by light and the inhibition of coordination of a shell-like ligand.

The emission peak wavelength and the half-width are values of an emission spectrum from which PLQY is calculated, and PLQY is the number of photons of fluorescence when the number of excitation photons absorbed by a light-emitting nanocrystal is 1. Each photoresponsive material was diluted with toluene before the measurements so that the optical absorptance at an excitation light wavelength ranged from 0.2 to 0.3. The measurement conditions and evaluation criteria are described below.

### <Measurement Conditions>

Measuring apparatus: absolute PL quantum yield measurement system C9920-03 (manufactured by Hamamatsu Photonics K.K.)
Excitation light wavelength: 460 nm
Excitation light integration range: excitation light wavelength ± 10 nm
Light emission integration range: (excitation light wavelength + 20) nm to 770 nm

### <Evaluation Criteria for PLQY Change>

A: absolute PLQY change rate of less than 20%
B: absolute PLQY change rate of 20% or more and less than 40%
C: absolute PLQY change rate of 40% or more and less than 80%
D: absolute PLQY change rate of 80% or more

### [Table 10]

**Table 10**

| Exemplary Embodiment No.. | Photoresponsive material | Peak wavelength/nm | | | Half-width/nm | | PLQY | | PLQY change rate | Rating | Peak wavelength change/nm | Rating |
|---|---|---|---|---|---|---|---|---|---|---|---|---|
| | | Immediately after synthesis of nanoparticle | Immediately after production | 30 minutes after addition of IPA 50% | Immediately after production | 30 minutes after addition of IPA 50% | Immediately after production | 30 minutes after addition of IPA 50% | | | | |
| Exemplary Embodiment 2-1 | Photoresponsive material 2-1 | 512 | 501 | 501 | 23 | 22 | 68% | 18% | -73% | C | -11 | B |
| Exemplary Embodiment 2-2 | Photoresponsive material 2-2 | 512 | 512 | 512 | 23 | 21 | 73% | 25% | -66% | C | 0 | A |
| Exemplary Embodiment 2-3 | Photoresponsive material 2-3 | 512 | 512 | 511 | 23 | 22 | 74% | 30% | -60% | C | 0 | A |
| Exemplary Embodiment 2-4 | Photoresponsive material 2-4 | 512 | 517 | 517 | 24 | 21 | 63% | 21% | -67% | C | 5 | A |
| Exemplary Embodiment 2-5 | Photoresponsive material 2-5 | 640 | 640 | 640 | 43 | 44 | 66% | 55% | -17% | A | 0 | A |
| Exemplary Embodiment 2-6 | Photoresponsive material 2-6 | 640 | 623 | 617 | 42 | 35 | 75% | 52% | -30% | B | -17 | C |
| Exemplary Embodiment 2-7 | Photoresponsive material 2-7 | 640 | 642 | 633 | 39 | 37 | 84% | 63% | -24% | B | 2 | A |
| Exemplary Embodiment 2-8 | Photoresponsive material 2-8 | 640 | 637 | 626 | 39 | 37 | 82% | 67% | -18% | A | -3 | A |
| Exemplary Embodiment 2-9 | Photoresponsive material 2-9 | 640 | 628 | 620 | 41 | 36 | 74% | 66% | -11% | A | -12 | B |
| Exemplary Embodiment 2-10 | Photoresponsive material 2-10 | 640 | 634 | 628 | 39 | 37 | 85% | 69% | -19% | A | -6 | A |
| Exemplary Embodiment 2-11 | Photoresponsive material 2-11 | 690 | 690 | 690 | 35 | 34 | 91% | 75% | -18% | A | 0 | A |
| Exemplary Embodiment 2-12 | Photoresponsive material 2-12 | 690 | 682 | 669 | 44 | 38 | 83% | 69% | -17% | A | -8 | A |
| Exemplary Embodiment 2-13 | Photoresponsive material 2-13 | 690 | 690 | 688 | 37 | 36 | 86% | 69% | -20% | A | 0 | A |
| Comparative Example 2-1 | Photoresponsive material 2-14 | 640 | 641 | 619 | 38 | 42 | 79% | 9% | -89% | D | 1 | A |
| Comparative Example 2-2 | Photoresponsive material 2-15 | 640 | 535 | 555 | 23 | 25 | 42% | 5% | -87% | D | -105 | D |
| Comparative Example 2-3 | Photoresponsive material 2-16 | 640 | 643 | 619 | 38 | 42 | 83% | 16% | -81% | D | 3 | A |

Table 10 shows that the photoresponsive materials 2-1 to 2-13 according to Exemplary Embodiments 2-1 to 2-13 have a high PLQY of 63% or more immediately after the production and can maintain the high PLQY even after the addition of the polar solvent IPA. This is probably because, in the photoresponsive materials 2-1 to 2-13 according to Exemplary Embodiments 2-1 to 2-13, the shell-like ligand 20 with a specific structure protects the nanoparticle 10 and ensures the stability of the nanoparticle 10.

By contrast, the photoresponsive materials without the shell-like ligand 20 as in Comparative Examples 2-1 to 2-3 had a low PLQY immediately after the production in some cases and were significantly deactivated with time.

### (Exemplary Embodiment 2-14)

### [Preparation of Polymer 2- Solution]

### (Toluene Solution of Polymer 2-b)

A reaction vessel equipped with a stirrer, a thermometer, and a refluxing condenser was charged with 1 part of the polymer 2-b and 99 parts of toluene, was heated to 110°C, and was heated at this temperature for 5 minutes. After confirming that the polymer 2-a was completely dissolved, a toluene solution of the polymer 2-b was produced by cooling to room temperature.

### [Preparation of Ink Composition 2-1]

A dry nitrogen stream was blown to 500 parts of the nanoparticle dispersion liquid 2-a to remove the solvent. 500 parts of the toluene solution of the polymer 2-b was added thereto, and the mixture was stirred for 3 hours. A dry nitrogen stream was again blown to the stirred solution to remove the solvent. After drying, 100 parts of 3,3,5-trimethylcyclohexyl acrylate (TMCHA) and 5 parts of 1-hydroxycyclohexyl phenyl ketone (Omnirad 184) were added as polymerizable compounds to the solid component of the solution, and the mixture was sufficiently stirred to produce an ink composition 2-1.

### (Exemplary Embodiment 2-15)

An ink composition 2-2 was produced in the same manner as in Exemplary Embodiment 2-14 except that tetrahydrofurfuryl acrylate (THFA) was used instead of TMCHA.

### (Exemplary Embodiment 2-16)

An ink composition 2-3 was produced in the same manner as in Exemplary Embodiment 2-14 except that 1,6-hexanediol diacrylate (HDDA) was used instead of TMCHA.

### (Exemplary Embodiment 2-17)

An ink composition 2-4 was produced in the same manner as in Exemplary Embodiment 2-14 except that the nanoparticle dispersion liquid 2-b was used instead of the nanoparticle dispersion liquid 2-a and that the polymer 2-c was used instead of the polymer 2-b.

### (Exemplary Embodiment 2-18)

An ink composition 2-5 was produced in the same manner as in Exemplary Embodiment 2-15 except that tetrahydrofurfuryl acrylate (THFA) was used instead of TMCHA.

### (Exemplary Embodiment 2-19)

An ink composition 2-6 was produced in the same manner as in Exemplary Embodiment 2-16 except that 1,6-hexanediol diacrylate (HDDA) was used instead of TMCHA.

### (Exemplary Embodiment 2-20)

An ink composition 2-7 was produced in the same manner as in Exemplary Embodiment 2-14 except that the nanoparticle dispersion liquid 2-c was used instead of the nanoparticle dispersion liquid 2-a and that the polymer 2-c was used instead of the polymer 2-b.

### (Exemplary Embodiment 2-21)

An ink composition 2-8 was produced in the same manner as in Exemplary Embodiment 2-20 except that tetrahydrofurfuryl acrylate (THFA) was used instead of TMCHA.

### (Exemplary Embodiment 2-22)

An ink composition 2-9 was produced in the same manner as in Exemplary Embodiment 2-20 except that 1,6-hexanediol diacrylate (HDDA) was used instead of TMCHA.

### (Exemplary Embodiment 2-23)

An ink composition 2-10 was produced in the same manner as in Exemplary Embodiment 2-14 except that the nanoparticle dispersion liquid 2-c was used instead of the nanoparticle dispersion liquid 2-a and that the polymer 2-a was used instead of the polymer 2-b.

### (Exemplary Embodiment 2-24)

An ink composition 2-11 was produced in the same manner as in Exemplary Embodiment 2-17 except that cyclohexyl acrylate (CHA) was used instead of TMCHA.

### (Exemplary Embodiment 2-25)

An ink composition 2-12 was produced in the same manner as in Exemplary Embodiment 2-17 except that 80 parts of TMCHA and 20 parts of HDDA were used instead of 100 parts of TMCHA.

### (Exemplary Embodiment 2-26)

An ink composition 2-13 was produced in the same manner as in Exemplary Embodiment 2-17 except that the polymer 2-f was used instead of the polymer 2-c.

### (Exemplary Embodiment 2-27)

An ink composition 2-14 was produced in the same manner as in Exemplary Embodiment 2-17 except that the polymer 2-g was used instead of the polymer 2-c.

### (Exemplary Embodiment 2-28)

An ink composition 2-15 was produced in the same manner as in Exemplary Embodiment 2-17 except that the polymer 2-h was used instead of the polymer 2-c.

### (Comparative Example 2-4)

An ink composition 2-16 was produced in the same manner as in Exemplary Embodiment 2-17 except that toluene was used instead of the polymer 2-c.

### (Comparative Example 2-5)

An ink composition 2-17 was produced in the same manner as in Exemplary Embodiment 2-17 except that didodecyldimethyl ammonium bromide (DDAB) was used instead of the polymer 2-c.

### (Comparative Example 2-6)

An ink composition 2-18 was produced in the same manner as in Exemplary Embodiment 2-17 except that the polymer 2-i was used instead of the polymer 2-c.

### [Table 11]

**Table 11**

| Exemplary Embodiment No. | Ink composition | Photoresponsive nanoparticle | | Polymer | | Polymerizable compound | | Polymerization initiator | |
|---|---|---|---|---|---|---|---|---|---|
| | | Type | Parts | Type | Parts | Type | Parts | Type | Parts |
| Exemplary Embodiment 2-14 | Ink composition2-1 | Photoresponsive nanoparticle dispersion liquid 2-a | 5 | Polymer 2-b | 5 | TMCHA | 100 | Omnirad184 | 5 |
| Exemplary Embodiment 2-15 | Ink composition2-2 | Photoresponsive nanoparticle dispersion liquid 2-a | 5 | Polymer 2-b | 5 | THFA | 100 | Omnirad184 | 5 |
| Exemplary Embodiment 2-16 | Ink composition2-3 | Photoresponsive nanoparticle dispersion liquid 2-a | 5 | Polymer 2-b | 5 | HDDA | 100 | Omnirad184 | 5 |
| Exemplary Embodiment 2-17 | Ink composition2-4 | Photoresponsive nanoparticle dispersion liquid 2-b | 5 | Polymer 2-c | 5 | TMCHA | 100 | Omnirad184 | 5 |
| Exemplary Embodiment 2-18 | Ink composition2-5 | Photoresponsive nanoparticle dispersion liquid 2-b | 5 | Polymer 2-c | 5 | THFA | 100 | Omnirad184 | 5 |
| Exemplary Embodiment 2-19 | Ink composition2-6 | Photoresponsive nanoparticle dispersion liquid 2-b | 5 | Polymer 2-c | 5 | HDDA | 100 | Omnirad184 | 5 |
| Exemplary Embodiment 2-20 | Ink composition2-7 | Photoresponsive nanoparticle dispersion liquid 2-c | 5 | Polymer 2-c | 5 | TMCHA | 100 | Omnirad184 | 5 |
| Exemplary Embodiment 2-21 | Ink composition2-8 | Photoresponsive nanoparticle dispersion liquid 2-c | 5 | Polymer 2-c | 5 | THFA | 100 | Omnirad184 | 5 |
| Exemplary Embodiment 2-22 | Ink composition2-9 | Photoresponsive nanoparticle dispersion liquid 2-c | 5 | Polymer 2-c | 5 | HDDA | 100 | Omnirad184 | 5 |
| Exemplary Embodiment 2-2 3 | Ink composition2-10 | Photoresponsive nanoparticle dispersion liquid 2-c | 5 | Polymer 2-a | 5 | TMCHA | 100 | Omnirad184 | 5 |
| Exemplary Embodiment 2-24 | Ink composition2-11 | Photoresponsive nanoparticle dispersion liquid 2-b | 5 | Polymer 2-c | 5 | CHA | 100 | Omnirad184 | 5 |
| Exemplary Embodiment 2-25 | Ink composition2-12 | Photoresponsive nanoparticle dispersion liquid 2-b | 5 | Polymer 2-c | 5 | TMCHA/HDDA=8/2 | 100 | Omnirad184 | 5 |
| Exemplary Embodiment 2-26 | Ink composition2-13 | Photoresponsive nanoparticle dispersion liquid 2-b | 5 | Polymer 2-f | 5 | TMCHA | 100 | Omnirad184 | 5 |
| Exemplary Embodiment 2-27 | Ink composition2-14 | Photoresponsive nanoparticle dispersion liquid 2-b | 5 | Polymer 2-g | 5 | TMCHA | 100 | Omnirad184 | 5 |
| Exemplary Embodiment 2-28 | Ink composition2-15 | Photoresponsive nanoparticle dispersion liquid 2-b | 5 | Polymer 2-h | 5 | TMCHA | 100 | Omnirad184 | 5 |
| Comparative Example 2-4 | Ink composition2-16 | Photoresponsive nanoparticle dispersion liquid 2-b | 5 | OA/OAm | - | TMCHA | 100 | Omnirad184 | 5 |
| Comparative Example 2-5 | Ink composition2-17 | Photoresponsive nanoparticle dispersion liquid 2-b | 5 | DDAB | 5 | TMCHA | 100 | Omnirad184 | 5 |
| Comparative Example 2-6 | Ink composition2-18 | Photoresponsive nanoparticle dispersion liquid 2-b | 5 | Polymer 2-i | 5 | TMCHA | 100 | Omnirad184 | 5 |

The abbreviations in Table 11 are as follows:
TMCHA: 3,3,5-trimethylcyclohexyl acrylate (manufactured by Osaka Organic Chemical Industry Ltd.)
HDDA: 1,6-hexanediol diacrylate (manufactured by Osaka Organic Chemical Industry Ltd.)
THFA: tetrahydrofurfuryl acrylate (manufactured by Osaka Organic Chemical Industry Ltd.)
CHA: cyclohexyl acrylate (manufactured by Osaka Organic Chemical Industry Ltd.)
DDAB: didodecyldimethyl ammonium bromide (manufactured by Tokyo Chemical Industry Co., Ltd.)

### [Characterization]

The particle size distribution and the absolute photoluminescence quantum yield (hereinafter referred to as PLQY) of the ink compositions 2-1 to 2-18 were measured for initial evaluation. The ink composition 2- composition was then allowed to stand for 14 days at a humidity of 70%RH and at a temperature of 25°C in a constant temperature and humidity chamber, and the particle size distribution and PLQY were then measured for evaluation after the passage of time. The particle size distribution was measured with Zetasizer Nano ZS (manufactured by Malvern), and the arithmetic mean diameter (on a number basis) of the particle size distribution was used as a measured value. The evaluation criteria were as follows:

### <Evaluation Criteria for Initial Particle Size>

A: initial particle size of less than 30 nm
B: initial particle size of 30 nm or more and less than 60 nm
C: initial particle size of 60 nm or more and less than 90 nm
D: initial particle size of 90 nm or more

### <Evaluation Criteria for Particle Size Change>

A: particle size change of less than twice
B: particle size change of twice or more and less than three times
C: particle size change of three times or more and less than four times
D: particle size change of four times or more

The particle size change is defined by the particle size after the passage of time/the initial particle size.

PLQY is the number of photons of fluorescence when the number of excitation photons absorbed by a light-emitting nanocrystal is taken as 1. Each photoresponsive material was diluted with toluene before the measurements so that the optical absorptance at an excitation light wavelength ranged from 0.2 to 0.3. The measurement conditions and evaluation criteria are described below.

### <Measurement Conditions>

Measuring apparatus: absolute PL quantum yield measurement system C9920-03 (manufactured by Hamamatsu Photonics K.K.)
Excitation light wavelength: 460 nm
Excitation light integration range: excitation light wavelength ± 10 nm
Light emission integration range: (excitation light wavelength + 20) nm to 770 nm

### <Evaluation Criteria for PLQY>

A: absolute PLQY change rate of less than 10%
B: absolute PLQY change rate of 10% or more and less than 25%
C: absolute PLQY change rate of 25% or more and less than 40%
D: absolute PLQY change rate of 40% or more

### [Table 12]

**Table 12**

| Exemplary Embodiment No. | Ink composition | Initial particle size | Particle size change | PLQY change |
|---|---|---|---|---|
| Exemplary Embodiment 2-14 | Ink composition 2-1 | A | A | B |
| Exemplary Embodiment 2-15 | Ink composition 2-2 | A | A | C |
| Exemplary Embodiment 2-16 | Ink composition 2-3 | A | A | B |
| Exemplary Embodiment 2-17 | Ink composition 2-4 | A | A | A |
| Exemplary Embodiment 2-18 | Ink composition 2-5 | B | A | B |
| Exemplary Embodiment 2-19 | Ink composition 2-6 | A | A | A |
| Exemplary Embodiment 2-20 | Ink composition 2-7 | A | A | A |
| Exemplary Embodiment 2-21 | Ink composition 2-8 | B | A | B |
| Exemplary Embodiment 2-22 | Ink composition 2-9 | A | A | A |
| Exemplary Embodiment 2-23 | Ink composition 2-10 | A | A | B |
| Exemplary Embodiment 2-24 | Ink composition 2-11 | A | A | A |
| Exemplary Embodiment 2-25 | Ink composition 2-12 | A | A | A |
| Exemplary Embodiment 2-26 | Ink composition 2-13 | A | A | A |
| Exemplary Embodiment 2-27 | Ink composition 2-14 | A | A | A |
| Exemplary Embodiment 2-28 | Ink composition 2-15 | A | A | A |
| Comparative Example 2-4 | Ink composition 2-16 | A | D | B |
| Comparative Example 2-5 | Ink composition 2-17 | A | D | D |
| Comparative Example 2-6 | Ink composition 2-18 | A | D | B |

Table 12 shows that the ink compositions 2-1 to 2-15 according to Exemplary Embodiments 2-14 to 2-28 of the present invention have a small initial particle size for a plurality of media and have a small particle size change and a small PLQY change after the passage of time. This is probably because the shell-like ligand 20 with the quaternary ammonium salt 30b in the binding portions 30 coordinates strongly to the nanoparticle 10, the organic group 30a or 40a is compatibly mixed with the polymerizable compound 50, and the photoresponsive material 330 is therefore stably dispersed.

On the other hand, in the ink compositions 2-16 to 2-18 without the shell-like ligand 20 as in Comparative Examples 2-4 to 2-6, although the change in initial particle size or PLQY is small in some cases, the particle size increases with time in any case, and it is presumed that a coarse secondary particle is formed.

Although the present disclosure is described in more detail below with reference to a third group of Exemplary Embodiments 3-1 to 3-10, the present disclosure is not limited thereto.

### [Production of Sulfobetaine Silane Compound]

5 g of [3-(N,N-dimethylamino)propyl]trimethoxysilane and 3 g of 1,3-propane sultone were dissolved in 25 ml of acetone, and the mixture was stirred in a nitrogen atmosphere for 6 hours. The mixture was washed with acetone and was then filtered to produce 3-(dimethyl(3-(trimethoxysilyl)propyl)ammonia)propane-1-sulfonate as a sulfobetaine silane compound.

### [Production of Carboxybetaine Silane Compound]

5 g of (N,N-dimethylaminopropyl)trimethoxysilane was mixed with 7 g of ethyl-4-bromobutyrate in 20 ml of acetonitrile. After reaction for 72 hours under reflux, 60 ml of ether was added thereto, and the unreacted reactant was removed with a rotary evaporator to produce a carboxybetaine silane compound.

### (Exemplary Embodiment 3-1)

### [Preparation of Sulfobetaine Silane Compound Solution]

### (Toluene Solution of Sulfobetaine Silane Compound)

A reaction vessel equipped with a stirrer, a thermometer, and a refluxing condenser was charged with 2.5 parts of the sulfobetaine silane compound and 97.5 parts of toluene, was heated to 110°C, and was heated at this temperature for 30 minutes. After confirming that the sulfobetaine silane compound was dissolved, a toluene solution of the sulfobetaine silane compound was produced by cooling to room temperature.

### [Production of Light-Emitting Nanocrystal Dispersion Liquid a]

10 parts of cesium carbonate, 27 parts of oleic acid, and 385 parts of 1-octadecene were placed in a flask, were heated to 120°C, and were degassed with a vacuum pump for 30 minutes. Furthermore, the liquid was heated to 150°C in a dry nitrogen stream and was held for 30 minutes to produce a cation raw material liquid.

Separately, 10 parts of lead (II) bromide and 494 parts of 1-octadecene were placed in a flask, were heated to 120°C, and were degassed with a vacuum pump for 1 hour. 89 parts of oleic acid and 31 parts of oleylamine were added, and the mixture was degassed with a vacuum pump for 30 minutes. The liquid temperature was then altered to 185°C in a nitrogen flow.

40 parts of the cation raw material liquid was added thereto, and the mixture was cooled with ice after 5 seconds. 2000 parts of ethyl acetate was added thereto, the mixture was centrifuged, and the supernatant was removed. The residue was dispersed in toluene to adjust the solid concentration to 1% by weight. Thus, a light-emitting nanocrystal dispersion liquid with a CsPbBr₃ perovskite crystal structure was produced.

### [Preparation of Photoresponsive Material 3-1]

A dry nitrogen stream was blown to 10 parts of the light-emitting nanocrystal dispersion liquid a to remove the solvent. 10 parts of the toluene solution of the sulfobetaine silane compound was added thereto, and the reaction vessel was uncovered and was stirred for 1 hour. The alkylsilane main chain of the sulfobetaine silane compound reacted with atmospheric water and underwent hydrolysis, thereby forming an organosilicon polymer portion. Thus, a photoresponsive material 3-1 was produced.

### (Exemplary Embodiment 3-2)

A photoresponsive material 3-2 was produced in the same manner as in Exemplary Embodiment 3-1 except that 0.5 parts of the sulfobetaine silane compound and 99.5 parts of toluene were used instead of 2.5 parts of the sulfobetaine silane compound and 97.5 parts of toluene.

### (Exemplary Embodiment 3-3)

A light-emitting material 3 was produced in the same manner as in Exemplary Embodiment 3-1 except that 1 part of the sulfobetaine silane compound and 99 parts of toluene were used instead of 2.5 parts of the sulfobetaine silane compound and 97.5 parts of toluene.

### (Exemplary Embodiment 3-4)

A photoresponsive material 3-4 was produced in the same manner as in Exemplary Embodiment 3-1 except that 5 parts of the sulfobetaine silane compound and 95 parts of toluene were used instead of 2.5 parts of the sulfobetaine silane compound and 97.5 parts of toluene.

### (Exemplary Embodiment 3-5)

A photoresponsive material 3-5 was produced in the same manner as in Exemplary Embodiment 3-1 except that carboxybetaine was used instead of the sulfobetaine silane compound.

### (Exemplary Embodiment 3-6)

3 parts of tetraethoxysilane (TEOS) was gradually added over 3 hours to 97 parts of the photoresponsive material 3-3 produced in Exemplary Embodiment 3-3. The mixture was stirred for another 2 hours to promote hydrolysis and was centrifuged, and the supernatant was removed. The resulting residue was dispersed in toluene, and the solid concentration was adjusted to 0.5% by weight to produce a photoresponsive material 3-6.

### [Production of Light-Emitting Nanocrystal Dispersion Liquid b]

A light-emitting nanocrystal dispersion liquid b with a CsPb(Br/I)₃ perovskite crystal structure was produced in the same manner as the light-emitting nanocrystal dispersion liquid a except that 3.3 parts of lead (II) bromide and 9.3 parts of lead (II) iodide were used instead of 10 parts of lead (II) bromide.

### (Exemplary Embodiment 3-7)

A photoresponsive material 3-7 was produced in the same manner as in Exemplary Embodiment 3-1 except that the light-emitting nanocrystal dispersion liquid b was used instead of the light-emitting nanocrystal dispersion liquid a, and 0.5 parts of the sulfobetaine silane compound and 99.5 parts of toluene were used instead of 2.5 parts of the sulfobetaine silane compound and 97.5 parts of toluene.

### [Production of Light-Emitting Nanocrystal Dispersion Liquid c]

A light-emitting nanocrystal dispersion liquid c with a CsPbI₃ perovskite crystal structure was produced in the same manner as the light-emitting nanocrystal dispersion liquid a except that 12.5 parts of lead (II) iodide was used instead of 10 parts of lead (II) bromide.

### (Exemplary Embodiment 3-8)

A photoresponsive material 3-8 was produced in the same manner as in Exemplary Embodiment 3-1 except that the light-emitting nanocrystal dispersion liquid c was used instead of the light-emitting nanocrystal dispersion liquid a, and 0.5 parts of the sulfobetaine silane compound and 99.5 parts of toluene were used instead of 2.5 parts of the sulfobetaine silane compound and 97.5 parts of toluene.

### [Production of Light-Emitting Nanocrystal Dispersion Liquid d]

First, an oleate solution of methylamine acetate was synthesized as described below. 40 parts of methylamine acetate and 1290 parts of oleic acid were mixed in a flask and were degassed with a vacuum pump at room temperature for 3 hours. The mixture was heated to 120°C and was degassed for 30 minutes to produce an oleate solution of methylamine acetate.

Next, an oleate solution of formamidine acetate was synthesized as described below. 46 parts of formamidine acetate and 1290 parts of oleic acid were mixed in a flask and were degassed with a vacuum pump at room temperature for 3 hours. The mixture was heated to 120°C and was degassed for 30 minutes to produce an oleate solution of formamidine acetate.

Separately, 10 parts of lead bromide, 129 parts of oleic acid, 59 parts of oleylamine, and 572 parts of octadecene were placed in a flask, were heated to 160°C, and were degassed with a vacuum pump for 100 minutes. 16 parts of the oleate solution of methylamine acetate and 77 parts of the oleate solution of formamidine acetate were mixed and added to the flask all at once. 10 seconds after the addition, the flask was cooled with ice. The ice-cooled solution was centrifuged, and the supernatant was removed. The resulting residue was dispersed in hexane and was further centrifuged to remove a precipitate. The solid concentration was adjusted to 1% by weight to produce a light-emitting nanocrystal dispersion liquid d with a (MA/FA)PbBr₃ perovskite crystal structure.

### (Exemplary Embodiment 3-9)

A photoresponsive material 3-9 was produced in the same manner as in Exemplary Embodiment 3-1 except that the light-emitting nanocrystal dispersion liquid d was used instead of the light-emitting nanocrystal dispersion liquid a, and 0.5 parts of the sulfobetaine silane compound and 99.5 parts of toluene were used instead of 2.5 parts of the sulfobetaine silane compound and 97.5 parts of toluene.

### [Production of Sulfobetaine Silane Compound b]

5 g of (N,N-dimethyl-3-aminopropyl)methyldimethoxysilane and 3 g of 1,3-propane sultone were dissolved in 25 ml of acetone, and the mixture was stirred in a nitrogen atmosphere for 6 hours. The mixture was washed with acetone and was then filtered to produce a sulfobetaine silane compound b. The sulfobetaine silane compound b is a compound represented by the formula (4) in which R₇ denotes a methyl group.

### (Exemplary Embodiment 3-10)

A photoresponsive material 3-10 was produced in the same manner as in Exemplary Embodiment 3-1 except that 1.0 parts of the sulfobetaine silane compound b and 99.0 parts of toluene were used instead of 2.5 parts of the sulfobetaine silane compound and 97.5 parts of toluene.

### (Comparative Example 3-1)

A photoresponsive material 3-11 was produced in the same manner as in Exemplary Embodiment 3-1 except that 100 parts of toluene was used instead of 1 part of the sulfobetaine silane compound and 99 parts of toluene.

### (Comparative Example 3-2)

A photoresponsive material 3-12 was produced in the same manner as in Exemplary Embodiment 3-1 except that 34 parts of an aminoalkyl silane compound 3-aminopropyltriethoxysilane was used instead of 31 parts of oleylamine and that 100 parts of toluene was used instead of 1 part of the sulfobetaine silane compound and 99 parts of toluene.

### (Comparative Example 3-3)

A photoresponsive material 3-13 was produced in the same manner as in Exemplary Embodiment 3-1 except that 1 part of an octadecyl dimethyl(3-sulfopropyl)ammonium hydroxide inner salt as a ligand with a betaine structure (hereinafter referred to as a betaine ligand) and 99.0 parts of toluene were used instead of the sulfobetaine silane compound.

### (Comparative Example 3-4)

A photoresponsive material 3-14 was produced in the same manner as in Comparative Example 3-3 except that the light-emitting nanocrystal dispersion liquid b was used instead of the light-emitting nanocrystal dispersion liquid a.

### (Comparative Example 3-5)

A photoresponsive material 3-15 was produced in the same manner as in Comparative Example 3-3 except that the light-emitting nanocrystal dispersion liquid c was used instead of the light-emitting nanocrystal dispersion liquid a.

### (Comparative Example 3-6)

A photoresponsive material 3-16 was produced in the same manner as in Comparative Example 3-3 except that the light-emitting nanocrystal dispersion liquid d was used instead of the light-emitting nanocrystal dispersion liquid a.

For the photoresponsive materials 3-1 to 3-16, Table 13 shows the type and concentration of the light-emitting nanocrystal and the type and concentration of the added compound.

### [Table 13]

**Table 13**

| Exemplary Embodiment No. | Photoresponsive material | Photoresponsive nanocrystal | | Added polymer or ligand | |
|---|---|---|---|---|---|
| | | Type | Concentration | Type | Concentration |
| Exemplary Embodiment 3-1 | Photoresponsive material 3-1 | CsPbBr₃ | 1 wt% | Sulfobetaine silane compound | 2.5 wt% |
| Exemplary Embodiment 3-2 | Photoresponsive material 3-2 | CsPbBr₃ | 1 wt% | Sulfobetaine silane compound | 0.5 wt% |
| Exemplary Embodiment 3-3 | Photoresponsive material 3-3 | CsPbBr₃ | 1 wt% | Sulfobetaine silane compound | 1.0 wt% |
| Exemplary Embodiment 3-4 | Photoresponsive material 3-4 | CsPbBr₃ | 1 wt% | Sulfobetaine silane compound | 5.0 wt% |
| Exemplary Embodiment 3-5 | Photoresponsive material 3-5 | CsPbBr₃ | 1 wt% | Carboxybetaine compound | 2.5 wt% |
| Exemplary Embodiment 3-6 | Photoresponsive material 3-6 | CsPbBr₃ | 1 wt% | Sulfobetaine silane compound | 1.0 wt% |
| Exemplary Embodiment 3-7 | Photoresponsive material 3-7 | CsPb(Br/I)₃ | 1 wt% | Sulfobetaine silane compound | 0.5 wt% |
| Exemplary Embodiment 3-8 | Photoresponsive material 3-8 | CsPbI₃ | 1 wt% | Sulfobetaine silane compound | 0.5 wt% |
| Exemplary Embodiment 3-9 | Photoresponsive material 3-9 | (MA/FA)PbBr₃ | 1 wt% | Sulfobetaine silane compound | 0.5 wt% |
| Exemplary Embodiment 3-10 | Photoresponsive material 3-10 | CsPbBr₃ | 1 wt% | Sulfobetaine silane compound b | 1.0 wt% |
| Comparative Example 3-1 | Photoresponsive material 3-11 | CsPbBr₃ | 1 wt% | - | - |
| Comparative Example 3-2 | Photoresponsive material 3-12 | CsPbBr₃ | 1 wt% | Aminoalkyl silane compound | 1 wt% |
| Comparative Example 3-3 | Photoresponsive material 3-13 | CsPbBr₃ | 1 wt% | Betaine ligand | 1 wt% |
| Comparative Example 3-4 | Photoresponsive material 3-14 | CsPb(Br/I)₃ | 1 wt% | Betaine ligand | 1 wt% |
| Comparative Example 3-5 | Photoresponsive material 3-15 | CsPbI₃ | 1 wt% | Betaine ligand | 1 wt% |
| Comparative Example 3-6 | Photoresponsive material 3-16 | (MA/FA)PbBr₃ | 1 wt% | Betaine ligand | 1 wt% |

### <Evaluation of Photoresponsive Material Composition>

The photoresponsive materials thus produced were subjected to the following evaluation. Table 14 shows the results.

### [Evaluation of Emission Properties]

For each photoresponsive material, the emission peak wavelength, the full width at half maximum, and the absolute photoluminescence quantum yield (hereinafter referred to as PLQY) were measured immediately after the production and 30 minutes after 2-propanol (hereinafter referred to as IPA) was added so as to be 50% by volume.

The emission peak wavelength and the full width at half maximum are values of an emission spectrum from which PLQY is calculated, and PLQY is the number of photons of fluorescence when the number of excitation photons absorbed by a light-emitting nanocrystal is 1. Each photoresponsive material was diluted with toluene before the measurements so that the optical absorptance at an excitation light wavelength ranged from 0.2 to 0.3. The measurement conditions and evaluation criteria are described below.

### <Measurement Conditions>

Measuring apparatus: absolute PL quantum yield measurement system C9920-03 (manufactured by Hamamatsu Photonics K.K.)
Excitation light wavelength: 460 nm
Excitation light integration range: excitation light wavelength ± 10 nm
Light emission integration range: (excitation light wavelength + 20) nm to 770 nm

### <Evaluation Criteria>

Initial PLQY was defined as 100, and PLQY after the addition of IPA was evaluated based on the following criteria.
A: PLQY change rate of 90 or more and 100 or less
B: PLQY change rate of 80 or more and less than 90
C: PLQY change rate of 60 or more and less than 80
D: PLQY change rate of less than 60

### [Table 14]

**Table 14**

| Exemplary Embodiment No. | Photoresponsive material | | | | | | | PLQY change rate | Rating |
|---|---|---|---|---|---|---|---|---|---|
| | | Immediately after production | 30 minutes after addition of IPA 50% | Immediately after production | 30 minutes after addition of IPA 50% | Immediately after production | 30 minutes after addition of IPA 50% | | |
| Exemplary Embodiment 3-1 | Photoresponsive material 3-1 | 520 | 519 | 21 | 19 | 100% | 97% | -3% | A |
| Exemplary Embodiment 3-2 | Photoresponsive material 3-2 | 519 | 518 | 21 | 21 | 87% | 83% | -5% | A |
| Exemplary Embodiment 3-3 | Photoresponsive material 3-3 | 519 | 518 | 21 | 20 | 93% | 90% | -3% | A |
| Exemplary Embodiment 3-4 | Photoresponsive material 3-4 | 520 | 519 | 21 | 20 | 98% | 92% | -6% | A |
| Exemplary Embodiment 3-5 | Photoresponsive material 3-5 | 519 | 517 | 22 | 22 | 78% | 63% | -19% | B |
| Exemplary Embodiment 3-6 | Photoresponsive material 3-6 | 519 | 518 | 21 | 20 | 96% | 93% | -3% | A |
| Exemplary Embodiment 3-7 | Photoresponsive material 3-7 | 648 | 640 | 38 | 36 | 74% | 60% | -19% | B |
| Exemplary Embodiment 3-8 | Photoresponsive material 3-8 | 688 | 685 | 41 | 41 | 87% | 73% | -16% | B |
| Exemplary Embodiment 3-9 | Photoresponsive material 3-9 | 535 | 533 | 22 | 22 | 80% | 66% | -18% | B |
| Exemplary Embodiment 3-10 | Photoresponsive material 3-10 | 520 | 519 | 22 | 22 | 88% | 80% | -9% | A |
| Comparative Example 3-1 | Photoresponsive material 3-11 | 518 | 517 | 22 | 23 | 55% | 11% | -80% | D |
| Comparative Example 3-2 | Photoresponsive material 3-12 | 517 | 516 | 24 | 23 | 76% | 60% | -21% | C |
| Comparative Example 3-3 | Photoresponsive material 3-13 | 518 | 516 | 23 | 22 | 78% | 36% | -54% | D |
| Comparative Example 3-4 | Photoresponsive material 3-14 | 650 | 640 | 38 | 39 | 80% | 36% | -55% | D |
| Comparative Example 3-5 | Photoresponsive material 3-15 | 688 | 682 | 41 | 42 | 84% | 58% | -31% | C |
| Comparative Example 3-6 | Photoresponsive material 3-16 | 535 | 532 | 22 | 22 | 82% | 62% | -25% | C |

Table 14 shows that the photoresponsive material according to the present embodiment has a high PLQY and a narrow full width at half maximum immediately after the production and can maintain them even after the addition of the polar solvent IPA. This is probably because the photoresponsive materials 3-1 to 3-10 according to the exemplary embodiments are protected by the silica shell of the organosilicon polymer portion with the betaine structure and therefore have high stability.

By contrast, no betaine ligand and no alkylsilane compound as in Comparative Example 3-1 resulted in a low PLQY immediately after the production and large deactivation 30 minutes after the addition of IPA.

Although containing the alkylsilane compound but no betaine structure as in Comparative Example 3-2 resulted in improved PLQY immediately after the production and improved temporal changes 30 minutes after the addition of IPA as compared with Comparative Example 3-1, the absolute PLQY was not sufficient, and the change rate was as high as 20% or more.

Likewise, containing the betaine structure 30b but no alkylsilane compound corresponding to the organosilicon polymer portion as in Comparative Examples 3-3 to 3-6 also resulted in an insufficient absolute PLQY and a change rate as high as 50% or more.

To protect the surface of the perovskite quantum dot and for stabilization against an external atmosphere (oxygen and water) or a solvent, it is considered to be important to strongly coordinate a raw material serving as a protective material at a high density and then react the coordinated protective material to form a strong shell. The betaine ligand used as in Comparative Example 3-3 coordinates strongly but has a weak function as a shell layer and low resistance to an external environment, such as a solvent. It is thought that the use of an aminoalkyl silane, which is a silane coupling agent with a coordinating amino group, as in Comparative Example 3-2 results in a weak bond between the quantum dot surface and the amino group and repeated desorption. It is also thought that oleic acid also coexists as a ligand and coordinates to the quantum dot. Thus, it is thought that there is a portion where the alkylsilane raw material has a low density near the quantum dot surface, and the silica shell formed by hydrolysis also partially has a low density.

When a betaine silane compound with a relatively low molecular weight and low steric hindrance is used as in the present embodiment, first, the betaine structure acts on the quantum dot surface and can coordinate firmly at a high density. Subsequently, the alkylsilane compound linked to the betaine structure can be hydrolyzed into an organosilicon polymer portion and form a silica shell, thus forming a shell layer at a high density on the quantum dot surface. Consequently, it is thought that the betaine structure and the silica shell reduce a non-light-emitting portion caused by a defect present on the quantum dot surface and thereby improve PLQY and resistance to an external environment, such as a solvent.

### <Production of Wavelength Conversion Member>

### (Exemplary Embodiment 3-11)

A photoresponsive composition was produced by blending 20 parts of the photoresponsive material 3-1, 76 parts of 3,3,5-trimethylcyclohexyl acrylate (manufactured by Osaka Organic Chemical Industry Ltd., trade name: Viscoat #196) as a polymerizable compound, 4 parts of (1-hydroxycyclohexyl phenyl ketone (manufactured by IGM Resins, trade name: Omnirad 184) as a polymerization initiator, and 4 parts of JR-603 (manufactured by Tayca Corporation) as a scattering agent.

The photoresponsive composition was spin-coated on a glass substrate (10 cm x 10 cm). The photoresponsive composition was then irradiated with ultraviolet light using a belt conveyor type ultraviolet irradiator (a high-pressure mercury lamp 120 W/cm2 lamp) at an integrated light quantity of 400 mJ/cm², thereby forming a cured film with a thickness of 10 um on the glass substrate. A barrier film was then stacked on the surface to produce a wavelength conversion member 3-1.

### (Exemplary Embodiments 3-12 to 3-20)

Wavelength conversion members 3-2 to 3-10 were produced in the same manner as in Exemplary Embodiment 3-11 except that the photoresponsive materials 3-2 to 3-10 were used instead of the photoresponsive material 3-1.

### (Comparative Example 3-7 to 12)

Wavelength conversion members 3-10 to 3-16 were produced in the same manner as in Exemplary Embodiment 3-11 except that the photoresponsive materials 3-11 to 3-16 were used instead of the photoresponsive material 3-1.

### [Table 15]

**Table 15**

| Exemplary Embodiment No. | Photoresponsive material | Peak wavelength | | Full width at half maximum | | PLQY | | PLQY change rate | Rating |
|---|---|---|---|---|---|---|---|---|---|
| | | Immediately after production | 16 hours after B light irradiation | Immediately after production | 100 hours after B light irradiation | Immediately after production | 100 hours after B light irradiation | | |
| Exemplary Embodiment 3-11 | Wavelength conversion member 3-1 | 522 | 519 | 21 | 19 | 89% | 87% | -2% | A |
| Exemplary Embodiment 3-12 | Wavelength conversion member 3-2 | 520 | 518 | 21 | 21 | 85% | 82% | -4% | A |
| Exemplary Embodiment 3-13 | Wavelength conversion member 3-3 | 520 | 518 | 21 | 20 | 86% | 82% | -5% | A |
| Exemplary Embodiment 3-14 | Wavelength conversion member 3-4 | 521 | 519 | 21 | 20 | 88% | 86% | -2% | A |
| Exemplary Embodiment 3-15 | Wavelength conversion member 3-5 | 520 | 517 | 22 | 22 | 74% | 60% | -19% | B |
| Exemplary Embodiment 3-16 | Wavelength conversion member 3-6 | 520 | 518 | 21 | 20 | 88% | 86% | -2% | A |
| Exemplary Embodiment 3-17 | Wavelength conversion member 3-7 | 645 | 640 | 38 | 36 | 78% | 60% | -23% | B |
| Exemplary Embodiment 3-18 | Wavelength conversion member 3-8 | 688 | 685 | 41 | 41 | 76% | 62% | -18% | B |
| Exemplary Embodiment 3-19 | Wavelength conversion member 3-9 | 535 | 533 | 22 | 22 | 72% | 58% | -19% | B |
| Exemplary Embodiment 3-20 | Wavelength conversion member 3-10 | 520 | 519 | 22 | 22 | 85% | 83% | -2% | A |
| Comparative Example 3-7 | Wavelength conversion member 3-11 | 518 | 510 | 22 | 24 | 57% | 10% | -82% | D |
| Comparative Example 3-8 | Wavelength conversion member 3-12 | 517 | 516 | 24 | 23 | 65% | 20% | -69% | D |
| Comparative Example 3-9 | Wavelength conversion member 3-13 | 518 | 516 | 23 | 22 | 66% | 18% | -73% | D |
| Comparative Example 3-10 | Wavelength conversion member 3-14 | 651 | 638 | 50 | 46 | 58% | 20% | -66% | D |
| Comparative Example 3-11 | Wavelength conversion member 3-15 | 684 | 694 | 45 | 53 | 60% | 30% | -50% | D |
| Comparative Example 3-12 | Wavelength conversion member 3-16 | 536 | 533 | 21 | 23 | 86% | 45% | -48% | D |

Table 15 shows that the light-emitting conversion members 1 to 10 according to Exemplary Embodiments 3-11 to 3-20 have a high PLQY and a narrow full width at half maximum immediately after the production and can maintain them even when stimulated for extended periods by very strong blue light. Furthermore, this effect does not depend on the compositions of the A site and the X site in the light-emitting nanocrystal and is effective for light-emitting nanocrystals with a wide range of compositions. It is presumed that these effects are due to the ensured stability of the nanoparticle 10 protected by the specific shell-like ligand 20.

### (Exemplary Embodiment 3-21)

10 parts of the photoresponsive material 3-1, 100 parts of 3,3,5-trimethylcyclohexyl acrylate (manufactured by Osaka Organic Chemical Industry Ltd., trade name: Viscoat #196) as a polymerizable compound, 5 parts of (1-hydroxycyclohexyl phenyl ketone (manufactured by IGM Resins, trade name: Omnirad 184) as a polymerization initiator, and 50 parts of toluene as a solvent were mixed to produce a photoresponsive material 3- composition 17. The particle size distribution and PLQY of the photoresponsive material 3- composition 17 were measured for initial evaluation. The photoresponsive material 3- composition was then allowed to stand for 14 days at a humidity of 70%RH and at a temperature of 25°C in a constant temperature and humidity chamber, and the particle size distribution and PLQY were then measured for evaluation after the passage of time. PLQY was measured under the same conditions as described above. The particle size distribution was measured with Zetasizer Nano ZS (manufactured by Malvern), and the arithmetic mean diameter (on a number basis) of the particle size distribution was used as a measured value. The particle size was 18 nm as an initial value and 20 nm after the passage of time. PLQY was initially 95% and 92% after the passage of time.

The evaluation results showed that the photoresponsive material 3-7 according to Exemplary Embodiment 3-7 was protected by the shell-like ligand with the organosilicon polymer portion and therefore had high stability.

The invention according to each embodiment described in the present description includes the following first to fourteenth constitutions.
- The first constitution includes a photoresponsive material, which includes a nanoparticle with a perovskite crystal structure and a shell-like ligand that has a plurality of binding portions with an ionic structural unit and that has a polymer portion bound to the nanoparticle at a plurality of positions via the plurality of binding portions.
- The second constitution includes the photoresponsive material according to the first constitution, wherein the ionic structural unit includes a zwitterionic structure.
- The third constitution includes the photoresponsive material according to the second constitution, wherein zwitterionic structure includes a betaine structure.
- The fourth constitution includes the photoresponsive material according to any one of the first to third constitutions, wherein the plurality of binding portions include a structural unit represented by at least one of the formulae (1) to (5): 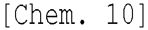 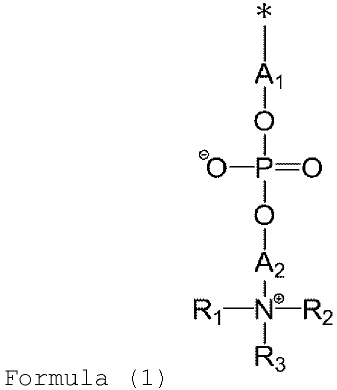 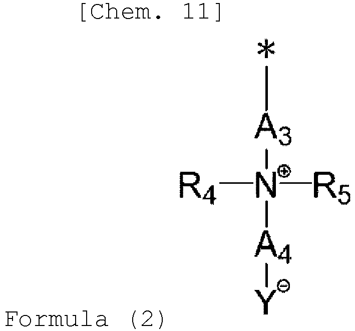 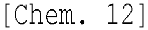 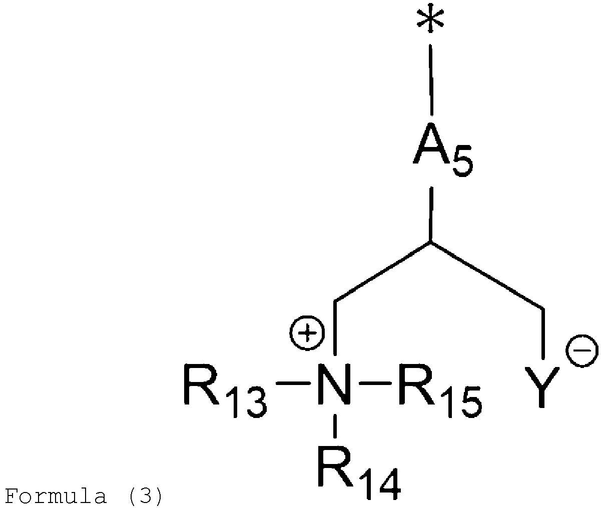
   in the formulae (1) to (3), R₁ to R₅ and R₁₃ to R₁₅ each independently denote any one of a hydrogen atom and an alkyl group, N denotes a nitrogen atom, A₁ to A₅ denote a linking group, Y⁻ denotes a COO⁻ group or a SO₃⁻ group, and "*" denotes a bonding arm to an organic polymer portion, 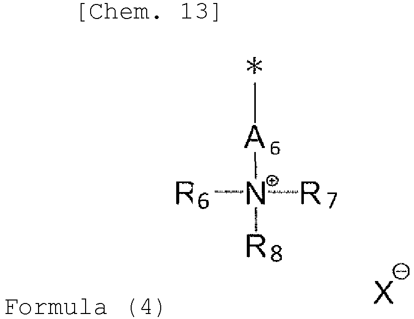
   in the formula (4), R₆ to R₈ each independently denote any one of an alkyl group and an aryl group, N denotes a nitrogen atom, N denotes a nitrogen atom, A₆ denotes a linking group, X⁻ denotes an anion, and "*" denotes a bonding arm to the polymer portion, and 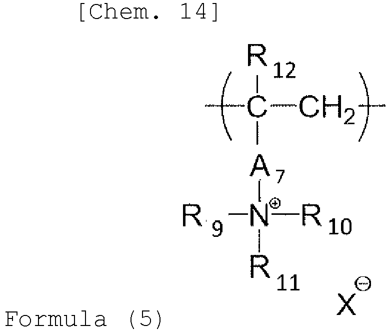
   in the formula (5), R₉ to R₁₁ each independently denote any one of an alkyl group and an aryl group, R₁₂ denotes any one of a hydrogen atom and an alkyl group, N denotes a nitrogen atom, A₇ denotes a linking group, and X⁻ denotes an anion.
- The fifth constitution includes the photoresponsive material according to the fourth constitution, wherein the plurality of binding portions include a structural unit represented by at least one of the formulae (1) to (3) as a betaine portion.
- The sixth constitution includes the photoresponsive material according to the fourth constitution, wherein the plurality of binding portions include a structural unit represented by at least one of the formulae (4) and (5) as a quaternary ammonium salt.
- The seventh constitution includes the photoresponsive material according to any one of the first to sixth constitutions, wherein the shell-like ligand has at least a portion coordinated to the nanoparticle.
- The eighth constitution includes the photoresponsive material according to any one of the first to seventh constitutions, wherein the polymer portion has a structural unit represented by any one of the formulae (6) to (8): 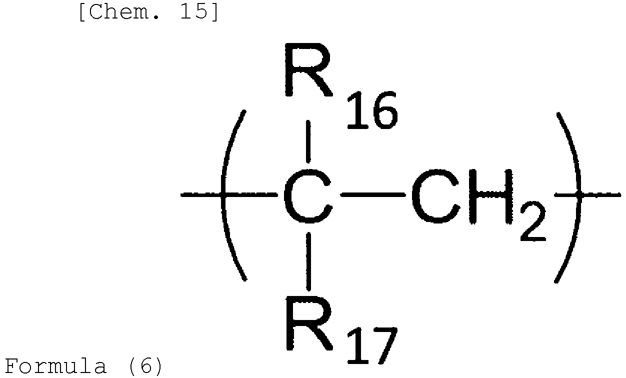
   in the formula (6), R16 denotes any one of a hydrogen atom and an alkyl group, and R₁₇ denotes any one of an alkyl group, a carboxylate group, a carboxamide group, an alkoxy group, and an aryl group, 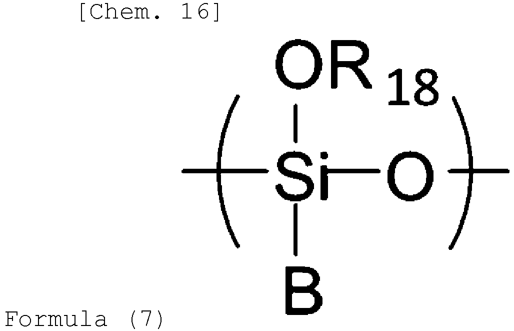
   in the formula (7), R₁₈ denotes any one of a hydrogen atom and an alkyl group, and B denotes a bonding arm to one of the binding portions, and 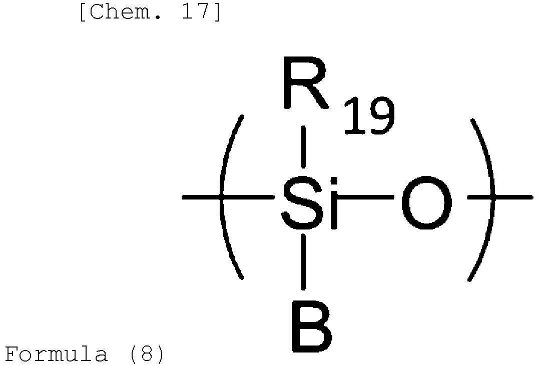
   in the formula (8), R₁₉ denotes an alkyl group, and B denotes a bonding arm to one of the binding portions.
- The ninth constitution includes the photoresponsive material according to any one of the first to eighth constitutions, wherein the shell-like ligand coordinates so as to cover an outer periphery of the nanoparticle.
- The tenth constitution includes the photoresponsive material according to any one of the first to ninth constitutions, wherein the shell-like ligand has a number-average molecular weight of 1,000 or more and 50,000 or less.
- The eleventh constitution includes a photoresponsive composition containing the photoresponsive material according to any one of the first to tenth constitutions and a polymerizable compound.
- The twelfth constitution includes a wavelength conversion member containing the photoresponsive composition according to the eleventh constitution cured with the polymerizable compound.
- The thirteenth constitution includes a wavelength conversion layer, in which the wavelength conversion member according to the twelfth constitution has an optical coupling surface that is optically coupled to a light source for emitting light with a first wavelength.
- The fourteenth constitution includes the wavelength conversion layer according to the thirteenth constitution, wherein the photoresponsive material emits light with a second wavelength longer than the light with the first wavelength received through the optical coupling surface.

The present invention is not limited to these embodiments, and various changes and modifications may be made therein without departing from the spirit and scope of the present invention. Accordingly, the following claims are attached to make the scope of the present invention public.

This application claims the benefit of Japanese Patent Application No. 2021-194474 filed November 30, 2021, Japanese Patent Application No. 2021-194476 filed November 30, 2021, Japanese Patent Application No. 2022-041491 filed March 16, 2022, Japanese Patent Application No. 2022-051869 filed March 28, 2022, Japanese Patent Application No. 2022-182323 filed November 15, 2022, Japanese Patent Application No. 2022-182325 filed November 15, 2022, and Japanese Patent Application No. 2022-189339 filed November 28, 2022, which are hereby incorporated by reference herein in their entirety.

## Claims

1. A photoresponsive material comprising:
a nanoparticle with a perovskite crystal structure; and
a shell-like ligand that has a plurality of binding portions with an ionic structural unit and that has a polymer portion bound to the nanoparticle at a plurality of positions via the plurality of binding portions.

2. The photoresponsive material according to Claim 1, wherein the ionic structural unit includes a zwitterionic structure.

3. The photoresponsive material according to Claim 2, wherein the zwitterionic structure includes a betaine structure.

4. The photoresponsive material according to Claim 1 or 2, wherein the plurality of binding portions include a structural unit represented by at least one of formulae (1) to (5): 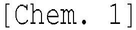 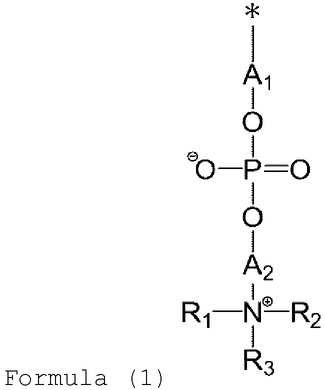 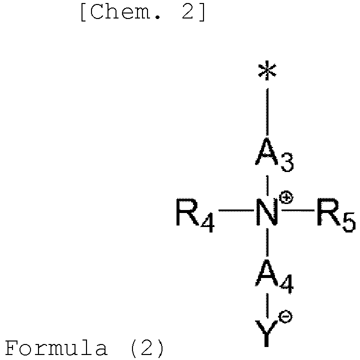 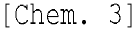 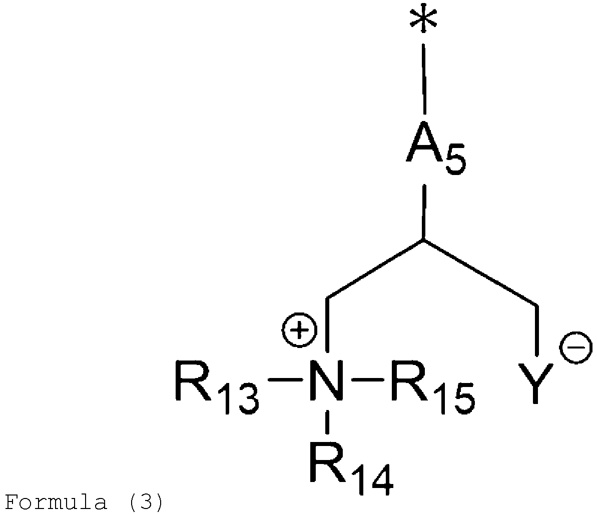
in the formulae (1) to (3), R₁ to R₅ and R₁₃ to R₁₅ each independently denote any one of a hydrogen atom and an alkyl group, N denotes a nitrogen atom, A₁ to A₅ denote a linking group, Y⁻ denotes a COO⁻ group or a SO₃⁻ group, and "*" denotes a bonding arm to the polymer portion, 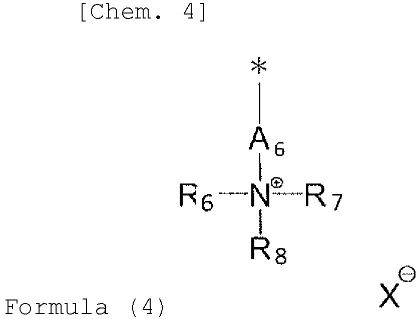
in the formula (4), R₆ to R₈ each independently denote any one of an alkyl group and an aryl group, N denotes a nitrogen atom, A₆ denotes a linking group, X- denotes an anion, and "*" denotes a bonding arm to the polymer portion, and 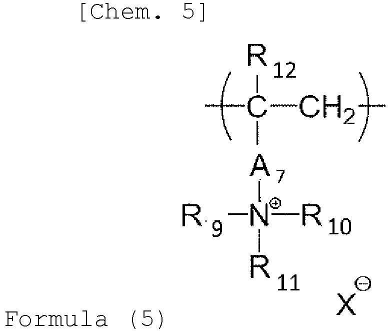
in the formula (5), R₉ to R₁₁ each independently denote any one of an alkyl group and an aryl group, R₁₂ denotes any one of a hydrogen atom and an alkyl group, N denotes a nitrogen atom, A₇ denotes a linking group, and X- denotes an anion.

5. The photoresponsive material according to Claim 4, wherein the plurality of binding portions include a structural unit represented by at least one of the formulae (1) to (3) as a betaine portion.

6. The photoresponsive material according to Claim 4, wherein the plurality of binding portions include a structural unit represented by at least one of the formulae (4) and (5) as a quaternary ammonium salt.

7. The photoresponsive material according to Claim 1 or 2, wherein the shell-like ligand has at least a portion coordinated to the nanoparticle.

8. The photoresponsive material according to Claim 1 or 2, wherein the polymer portion has a structural unit represented by any one of formulae (5) to (7): 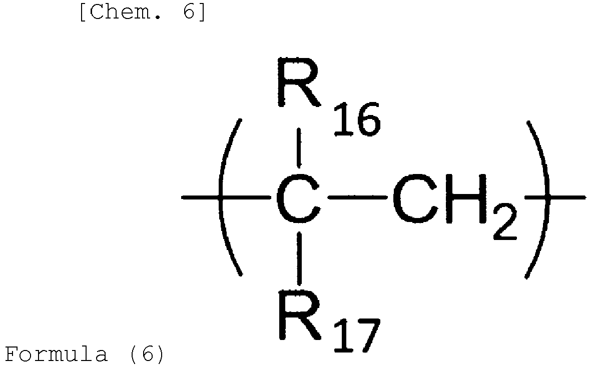
in the formula (6), R₁₆ denotes any one of a hydrogen atom and an alkyl group, and R₁₇ denotes any one of an alkyl group, a carboxylate group, a carboxamide group, an alkoxy group, and an aryl group, 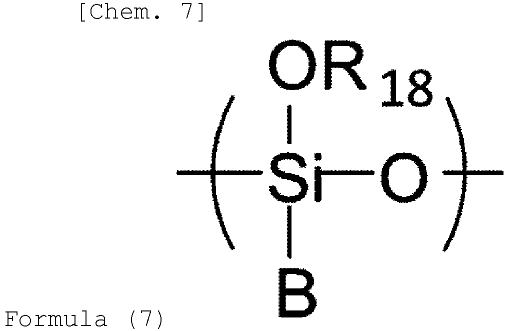
in the formula (7), R₁₈ denotes any one of a hydrogen atom and an alkyl group, and B denotes a bonding arm to one of the binding portions, and 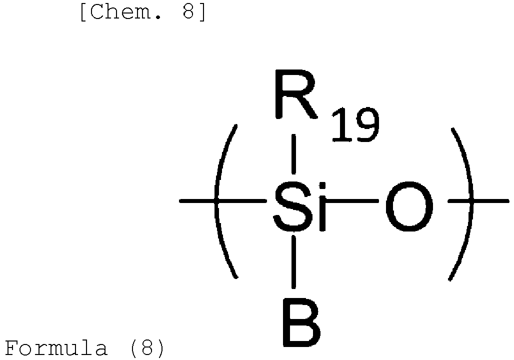
in the formula (8), R₁₉ denotes an alkyl group, and B denotes a bonding arm to one of the binding portions.

9. The photoresponsive material according to Claim 1 or 2, wherein the shell-like ligand coordinates so as to cover an outer periphery of the nanoparticle.

10. The photoresponsive material according to Claim 1 or 2, wherein the shell-like ligand has a number-average molecular weight of 1,000 or more and 50,000 or less.

11. A photoresponsive composition comprising: the photoresponsive material according to Claim 1 or 2; and a polymerizable compound.

12. A wavelength conversion member comprising: the photoresponsive composition according to Claim 11 cured with the polymerizable compound.

13. A wavelength conversion layer, in which the wavelength conversion member 3- according to Claim 12 has an optical coupling surface that is optically coupled to a light source for emitting light with a first wavelength.

14. The wavelength conversion layer according to Claim 13, wherein the photoresponsive material emits light with a second wavelength longer than the light with the first wavelength received through the optical coupling surface.
